# EUROPEAN PATENT APPLICATION

(11) **EP 4 270 932 A1**
(43) Date of publication of application: **01.11.2023**
(21) Application number: 21911051.7
(22) Date of filing: 24.12.2021
(51) Int. Cl.: H04N 5/369, H01L 21/336, H01L 21/8234, H01L 27/088, H01L 27/146, H01L 29/78, H04N 5/374

(54) **IMAGE CAPTURE ELEMENT AND IMAGE CAPTURE DEVICE**

(30) Priority: 25.12.2020 JP 2020217525
(71) Applicant: Sony Semiconductor Solutions Corporation, Atsugi-shi, Kanagawa 243-0014 (JP)
(72) Inventor: OKAWA, Tatsuya, Atsugi-shi, Kanagawa 243-0014 (JP); SUGIMOTO, Masataka, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/048194
(87) International publication number: WO 2022/138914

(57) **Abstract**

To downsize an imaging element formed by stacking a plurality of semiconductor substrates. The imaging element includes pixels, a pixel circuit, an isolating section, a buried electrode, and a connecting location. Each of the pixels includes: the photoelectric conversion section that is disposed on the first semiconductor substrate and performs photoelectric conversion of incident light; the charge holding section that holds a charge generated by the photoelectric conversion; and the charge transfer section that transfers the charge from the photoelectric conversion section to the charge holding section. The pixel circuit generates an image signal on the basis of charges disposed and held on a second semiconductor substrate stacked on the front surface side of the first semiconductor substrate. The isolating section is disposed at a boundary of the pixels. The buried electrode is disposed by being buried the front surface side of the first semiconductor substrate at the boundary of the pixel overlapping the isolating section, so as to be connected to the first semiconductor substrate. The connecting location is connected to the buried electrode.

## Description

### Field

The present disclosure relates to an imaging element and an imaging device.

### Background

An imaging element that images a subject is implemented by using an imaging element having a configuration in which a plurality of substrates is stacked. The plurality of substrates corresponds to, for example, a substrate on which a pixel that converts incident light from the subject into an image signal using photoelectric conversion is formed and a substrate on which a circuit that generates a control signal of the pixel or a circuit that processes image signals is formed. A circuit that handles an analog image signal is disposed on the pixel. On the other hand, the circuit that processes image signals mainly uses a digital circuit that operates at a high speed. In this manner, with a configuration in which circuits having different characteristics are disposed on different substrates, it is possible to manufacture a substrate by applying an optimum process to these circuits. Further, the configuration of stacking these substrates making it also possible to reduce the area of the imaging element.

For example, there is proposed an imaging element in which a first substrate on which a photoelectric conversion element that performs photoelectric conversion of incident light is mainly disposed and a second substrate on which a readout circuit that outputs an image signal on the basis of a charge generated by the photoelectric conversion element is disposed are stacked (refer to Patent Literature 1, for example). In this imaging element, a third substrate on which a logic circuit that processes the image signal is disposed is further stacked to form an imaging element.

### Citation List

### Patent Literature

Patent Literature 1: WO 2019/131965 A

### Summary

### Technical Problem

The above-described conventional technique, however, has a problem of difficulty in downsizing the pixel. Since the circuit constituting the pixel is divided into two substrates and stacked, a connecting location (contact) for using the reference potential of these substrates in common is disposed between the substrates. Here, the reference potential is a potential serving as a reference of a signal of a circuit of a pixel or a power supply voltage, and corresponds to a ground potential, for example. The first substrate needs to have a region for connecting this contact, and this increases the pixel area.

In view of this, regarding an imaging element and an imaging device having a configuration in which a plurality of semiconductor substrates is stacked, the present disclosure proposes an imaging element and an imaging device that can be downsized.

### Solution to Problem

The present disclosure has been conceived to solve the problem described above, and the aspect thereof is an imaging element includes: pixels each disposed on a first semiconductor substrate and including a photoelectric conversion section that performs photoelectric conversion of incident light, a charge holding section that holds a charge generated by the photoelectric conversion, and a charge transfer section that transfers the charge from the photoelectric conversion section to the charge holding section; a pixel circuit that is disposed on a second semiconductor substrate stacked on a front surface side of the first semiconductor substrate and generates an image signal on a basis of the held charge; an isolating section disposed at a boundary of the pixels; a buried electrode that is disposed by being buried in the front surface side of the first semiconductor substrate at a boundary of the pixel overlapping with the isolating section and is connected to the first semiconductor substrate; and a connecting location connected to the buried electrode.

### Brief Description of Drawings

FIG. 1 is a block diagram depicting an example of a functional configuration of an imaging device according to an embodiment of the present disclosure.
FIG. 2 is a schematic plan view depicting a schematic configuration of the imaging device depicted in FIG. 1.
FIG. 3 is a schematic view depicting a cross-sectional configuration taken along line III-III' depicted in FIG. 2.
FIG. 4 is an equivalent circuit diagram depicting an example of a configuration of a pixel sharing unit according to an embodiment of the present disclosure.
FIG. 5 is a cross-sectional view depicting a configuration example of the imaging device according to the embodiment of the present disclosure.
FIG. 6 is a cross-sectional view depicting another configuration example of the imaging device according to the embodiment of the present disclosure.
FIG. 7 is a cross-sectional view depicting another configuration example of the imaging device according to the embodiment of the present disclosure.
FIG. 8 is a diagram depicting a configuration example of a pixel sharing unit according to a first embodiment of the present disclosure.
FIG. 9 is a diagram depicting a configuration example of a pixel according to the first embodiment of the present disclosure.
FIG. 10A is a diagram depicting an example of a method of manufacturing the imaging element according to the first embodiment of the present disclosure.
FIG. 10B is a diagram depicting an example of the method of manufacturing the imaging element according to the first embodiment of the present disclosure.
FIG. 10C is a diagram depicting an example of a method of manufacturing the imaging element according to the first embodiment of the present disclosure.
FIG. 10D is a diagram depicting an example of the method of manufacturing the imaging element according to the first embodiment of the present disclosure.
FIG. 10E is a diagram depicting an example of the method of manufacturing the imaging element according to the first embodiment of the present disclosure.
FIG. 10F is a diagram depicting an example of the method of manufacturing the imaging element according to the first embodiment of the present disclosure.
FIG. 10G is a diagram depicting an example of the method of manufacturing the imaging element according to the first embodiment of the present disclosure.
FIG. 10H is a diagram depicting an example of the method of manufacturing the imaging element according to the first embodiment of the present disclosure.
FIG. 10I is a diagram depicting an example of the method of manufacturing the imaging element according to the first embodiment of the present disclosure.
FIG. 11 is a diagram depicting another configuration example of the pixel sharing unit according to the first embodiment of the present disclosure.
FIG. 12A is a diagram depicting another configuration example of a buried electrode according to the first embodiment of the present disclosure.
FIG. 12B is a diagram depicting another configuration example of the buried electrode according to the first embodiment of the present disclosure.
FIG. 13 is a diagram depicting another configuration example of the pixel sharing unit according to the first embodiment of the present disclosure.
FIG. 14 is a diagram depicting a configuration example of a pixel sharing unit according to a second embodiment of the present disclosure.
FIG. 15A is a view depicting a configuration example of a boundary wiring line according to the second embodiment of the present disclosure.
FIG. 15B is a view depicting a configuration example of the boundary wiring line according to the second embodiment of the present disclosure.
FIG. 16A is a diagram depicting an example of the method of manufacturing the boundary wiring line according to the second embodiment of the present disclosure.
FIG. 16B is a diagram depicting an example of the method of manufacturing the boundary wiring line according to the second embodiment of the present disclosure.
FIG. 16C is a diagram depicting an example of the method of manufacturing the boundary wiring line according to the second embodiment of the present disclosure.
FIG. 16D is a diagram depicting an example of the method of manufacturing the boundary wiring line according to the second embodiment of the present disclosure.
FIG. 16E is a diagram depicting an example of the method of manufacturing the boundary wiring line according to the second embodiment of the present disclosure.
FIG. 17A is a diagram depicting another configuration example of the boundary wiring line according to the second embodiment of the present disclosure.
FIG. 17B is a diagram depicting another configuration example of the boundary wiring line according to the second embodiment of the present disclosure.
FIG. 18A is a diagram depicting an example of another method of manufacturing the boundary wiring line according to the second embodiment of the present disclosure.
FIG. 18B is a diagram depicting an example of another method of manufacturing the boundary wiring line according to the second embodiment of the present disclosure.
FIG. 18C is a diagram depicting an example of another method of manufacturing the boundary wiring line according to the second embodiment of the present disclosure.
FIG. 18D is a diagram depicting an example of another method of manufacturing the boundary wiring line according to the second embodiment of the present disclosure.
FIG. 18E is a diagram depicting an example of another method of manufacturing the boundary wiring line according to the second embodiment of the present disclosure.
FIG. 18F is a diagram depicting an example of another method of manufacturing the boundary wiring line according to the second embodiment of the present disclosure.
FIG. 18G is a diagram depicting an example of another method of manufacturing the boundary wiring line according to the second embodiment of the present disclosure.
FIG. 19 is a diagram depicting another configuration example of the pixel sharing unit according to the second embodiment of the present disclosure.
FIG. 20A is a diagram depicting a configuration example of a pixel array section according to a third embodiment of the present disclosure.
FIG. 20B is a diagram depicting a configuration example of the pixel array section according to the third embodiment of the present disclosure.
FIG. 20C is a diagram depicting a configuration example of the pixel array section according to the third embodiment of the present disclosure.
FIG. 21 is a diagram depicting a configuration example of the pixel array section according to the third embodiment of the present disclosure.
FIG. 22 is a diagram depicting a comparison result of the pixel array section according to the third embodiment of the present disclosure.
FIG. 23A is a diagram depicting a configuration example of a pixel array section according to a fourth embodiment of the present disclosure.
FIG. 23B is a diagram depicting a configuration example of the pixel array section according to the fourth embodiment of the present disclosure.
FIG. 23C is a diagram depicting a configuration example of the pixel array section according to the fourth embodiment of the present disclosure.
FIG. 24 is a diagram depicting a comparison result of the pixel array section according to the fourth embodiment of the present disclosure.
FIG. 25A is a diagram depicting a configuration example of a pixel array section according to a fifth embodiment of the present disclosure.
FIG. 25B is a diagram depicting a configuration example of the pixel array section according to the fifth embodiment of the present disclosure.
FIG. 25C is a diagram depicting a configuration example of the pixel array section according to the fifth embodiment of the present disclosure.
FIG. 25D is a diagram depicting a configuration example of the pixel array section according to the fifth embodiment of the present disclosure.
FIG. 25E is a diagram depicting a configuration example of the pixel array section according to the fifth embodiment of the present disclosure.
FIG. 26 is a diagram depicting a comparison result of the pixel array section according to the fifth embodiment of the present disclosure.
FIG. 27A is a diagram depicting a configuration example of a pixel array section according to a sixth embodiment of the present disclosure.
FIG. 27B is a diagram depicting a configuration example of the pixel array section according to the sixth embodiment of the present disclosure.
FIG. 27C is a diagram depicting a configuration example of the pixel array section according to the sixth embodiment of the present disclosure.
FIG. 27D is a diagram depicting a configuration example of the pixel array section according to the sixth embodiment of the present disclosure.
FIG. 27E is a diagram depicting a configuration example of the pixel array section according to the sixth embodiment of the present disclosure.
FIG. 27F is a diagram depicting a configuration example of the pixel array section according to the sixth embodiment of the present disclosure.
FIG. 28 is a diagram depicting a comparison result of the pixel array section according to the sixth embodiment of the present disclosure.
FIG. 29A is a diagram depicting a configuration example of an isolating section according to a seventh embodiment of the present disclosure.
FIG. 29B is a diagram depicting a configuration example of the isolating section according to the seventh embodiment of the present disclosure.
FIG. 30 is a diagram depicting a configuration example of a pixel sharing unit according to an eighth embodiment of the present disclosure.
FIG. 31 is a diagram depicting a configuration example of a pixel according to the eighth embodiment of the present disclosure.
FIG. 32 is a diagram depicting a configuration example of a pixel sharing unit according to a ninth embodiment of the present disclosure.
FIG. 33 is a diagram depicting a configuration example of a pixel according to the ninth embodiment of the present disclosure.
FIG. 34A is a diagram depicting an example of a method of manufacturing an imaging element according to the ninth embodiment of the present disclosure.
FIG. 34B is a diagram depicting an example of the method of manufacturing the imaging element according to the ninth embodiment of the present disclosure.
FIG. 34C is a diagram depicting an example of the method of manufacturing the imaging element according to the ninth embodiment of the present disclosure.
FIG. 34D is a diagram depicting an example of the method of manufacturing the imaging element according to the ninth embodiment of the present disclosure.
FIG. 34E is a diagram depicting an example of the method of manufacturing the imaging element according to the ninth embodiment of the present disclosure.
FIG. 34F is a diagram depicting an example of the method of manufacturing the imaging element according to the ninth embodiment of the present disclosure.
FIG. 34G is a diagram depicting an example of the method of manufacturing the imaging element according to the ninth embodiment of the present disclosure.
FIG. 34H is a diagram depicting an example of the method of manufacturing the imaging element according to the ninth embodiment of the present disclosure.
FIG. 34I is a diagram depicting an example of the method of manufacturing the imaging element according to the ninth embodiment of the present disclosure.
FIG. 34J is a diagram depicting an example of the method of manufacturing the imaging element according to the ninth embodiment of the present disclosure.
FIG. 34K is a diagram depicting an example of the method of manufacturing the imaging element according to the ninth embodiment of the present disclosure.
FIG. 34L is a diagram depicting an example of the method of manufacturing the imaging element according to the ninth embodiment of the present disclosure.
FIG. 34M is a diagram depicting an example of the method of manufacturing the imaging element according to the ninth embodiment of the present disclosure.
FIG. 35 is a diagram depicting a first modification of a configuration of a charge transfer section according to the ninth embodiment of the present disclosure.
FIG. 36A is a diagram depicting a second modification of the configuration of the charge transfer section according to the ninth embodiment of the present disclosure.
FIG. 36B is a diagram depicting the second modification of the configuration of the charge transfer section according to the ninth embodiment of the present disclosure.
FIG. 36C is a diagram depicting the second modification of the configuration of the charge transfer section according to the ninth embodiment of the present disclosure.
FIG. 36D is a diagram depicting the second modification of the configuration of the charge transfer section according to the ninth embodiment of the present disclosure.
FIG. 36E is a diagram depicting the second modification of the configuration of the charge transfer section according to the ninth embodiment of the present disclosure.
FIG. 37 is a diagram depicting a configuration example of a pixel sharing unit according to a tenth embodiment of the present disclosure.
FIG. 38 is a diagram depicting an example of a schematic configuration of an imaging system including the imaging device according to the embodiments and their modifications.
FIG. 39 is a diagram depicting an example of a flowchart of an imaging operation in the imaging system.
FIG. 40 is a block diagram depicting a schematic configuration example of a vehicle control system, which is an example of a mobile body control system to which the technology according to the present disclosure is applicable.
FIG. 41 is a diagram depicting an example of an installation position of an imaging section 12031.
FIG. 42 is a view depicting an example of a schematic configuration of an endoscopic surgery system to which the technology according to the present disclosure (present technology) can be applied.
FIG. 43 is a block diagram depicting an example of a functional configuration of a camera head 11102 and a CCU 11201 depicted in FIG. 42.

### Description of Embodiments

Embodiments of the present disclosure will be described below in detail with reference to the drawings. The description will be given in the following order. Note that, in each of the following embodiments, the same parts are denoted by the same reference symbols, and a repetitive description thereof will be omitted.
1. First embodiment
2. Second embodiment
3. Third embodiment
4. Fourth embodiment
5. Fifth embodiment
6. Sixth embodiment
7. Seventh embodiment
8. Eighth embodiment
9. Ninth embodiment
10. Tenth embodiment
11. Application Example
12. Example of application to mobile body
13. Example of application to endoscopic surgery system

### (1. First embodiment)

### [Functional configuration of imaging device 1]

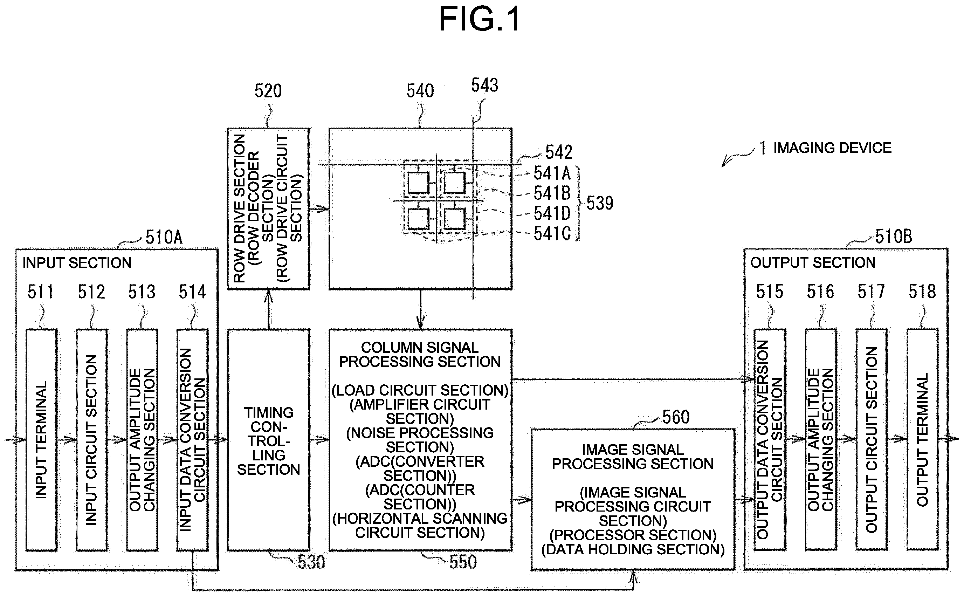

FIG. 1 is a block diagram depicting an example of a functional configuration of an imaging device (imaging device 1) according to an embodiment of the present disclosure.

The imaging device 1 of FIG. 1 includes, for example, an input section 510A, a row drive section 520, a timing controlling section 530, a pixel array section 540, a column signal processing section 550, an image signal processing section 560, and an output section 510B.

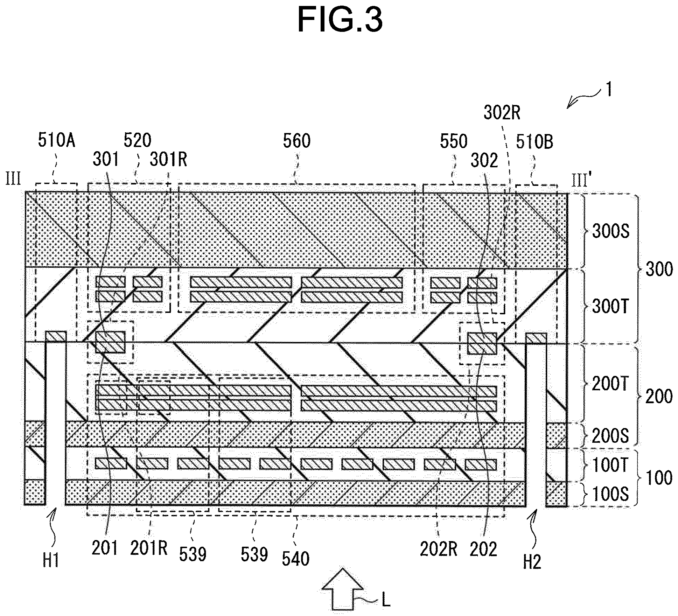

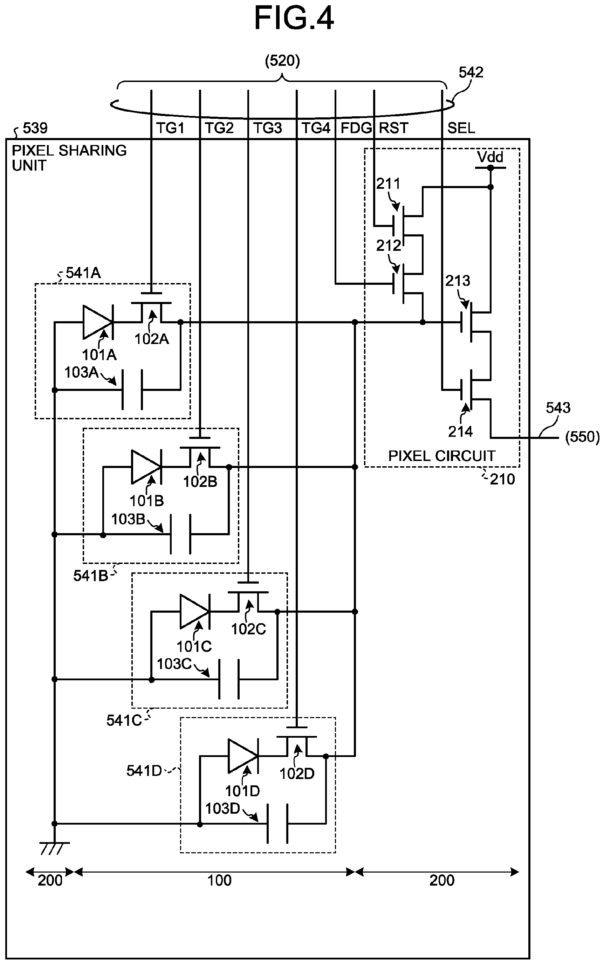

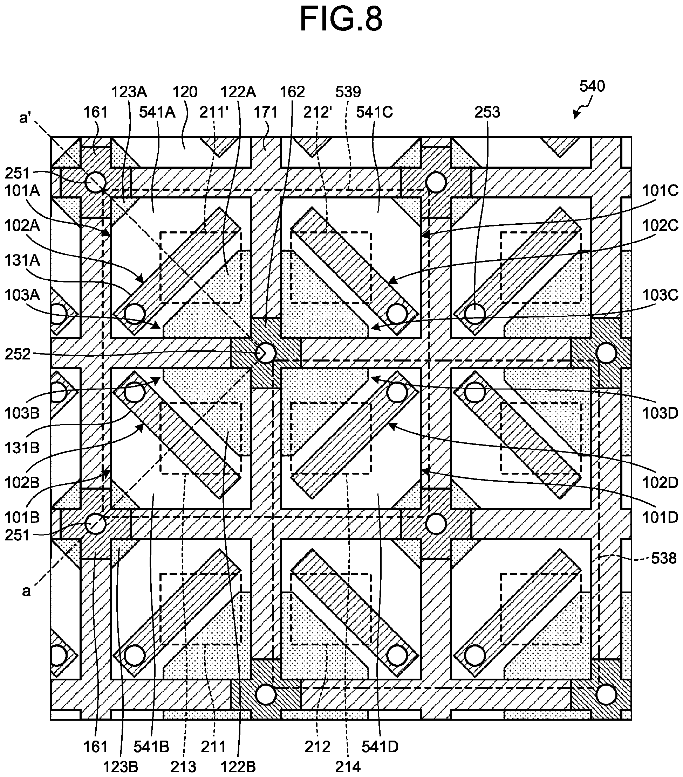

In the pixel array section 540, pixels 541 are repeatedly disposed in an array. More specifically, a pixel sharing unit 539 including a plurality of pixels is a repeating unit, and is repeatedly disposed in an array including a row direction and a column direction. In the present specification, for convenience, the row direction may be referred to as an H direction, and the column direction orthogonal to the row direction may be referred to as a V direction. In the example of FIG. 1, one pixel sharing unit 539 includes four pixels (pixels 541A, 541B, 541C, and 541D). Each of the pixels 541A, 541B, 541C, and 541D includes a photoelectric conversion section 101 (depicted in FIG. 8 and the like described below). The pixel sharing unit 539 is a unit of sharing one pixel circuit (a pixel circuit 210 in FIG. 3 described below). In other words, one pixel circuit (the pixel circuit 210 to be described below) is provided for every four pixels (pixels 541A, 541B, 541C, and 541D). By allowing the pixel circuit to operate in time division, a pixel signal of each of the pixels 541A, 541B, 541C, and 541D is sequentially read out. The pixels 541A, 541B, 541C, and 541D are each disposed in 2 rows × 2 columns, for example. The pixel array section 540 includes a plurality of row drive signal lines 542 and a plurality of vertical signal lines (column readout lines) 543 together with the pixels 541A, 541B, 541C, and 541D. The row drive signal line 542 drives the pixels 541 included in each of the plurality of pixel sharing units 539 disposed side by side in the row direction in the pixel array section 540. In the pixel sharing unit 539, individual pixels disposed side by side in the row direction are driven. As will be described in detail below with reference to FIG. 4, the pixel sharing unit 539 is provided with a plurality of transistors. In order to drive each of the plurality of transistors, the plurality of row drive signal lines 542 is connected to one pixel sharing unit 539. The pixel sharing unit 539 is connected to the vertical signal line (column readout line) 543. A pixel signal is read out from each of the pixels 541A, 541B, 541C, and 541D included in the pixel sharing unit 539 via the vertical signal line (column readout line) 543.

The row drive section 520 includes, for example, a row address controlling section that determines a position of a row for pixel drive, in other words, a row decoder section, and a row drive circuit section that generates a signal for driving the pixels 541A, 541B, 541C, and 541D.

The column signal processing section 550 includes, for example, a load circuit section connected to the vertical signal line 543 and configured to form a source follower circuit with the pixels 541A, 541B, 541C, and 541D (pixel sharing unit 539). The column signal processing section 550 may include an amplifier circuit section that amplifies a signal read out from the pixel sharing unit 539 via the vertical signal line 543. The column signal processing section 550 may include a noise processing section. The noise processing section removes system noise levels from the signal read out from the pixel sharing unit 539 as a result of photoelectric conversion, for example.

The column signal processing section 550 includes an analog-to-digital converter (ADC), for example. The analog-to-digital converter converts the signal read out from the pixel sharing unit 539 or the noise-processed analog signal into a digital signal. The ADC includes, for example, a comparator section and a counter section. The comparator section compares an analog signal to be converted with a reference signal for comparison. The counter section is supposed to count the time until the comparison result in the comparator section is inverted. The column signal processing section 550 may include a horizontal scanning circuit section that performs control to scan the readout column.

The timing controlling section 530 supplies a signal controlling timing to the row drive section 520 and the column signal processing section 550 on the basis of the reference clock signal and the timing control signal input to the device.

The image signal processing section 560 is a circuit that applies various types of signal processing on data obtained as a result of photoelectric conversion, in other words, data obtained as a result of an imaging operation in the imaging device 1. The image signal processing section 560 includes, for example, an image signal processing circuit section and a data holding section. The image signal processing section 560 may include a processor section.

An example of signal processing executed in the image signal processing section 560 is a tone curve correction process of increasing levels of gradations in a case where the AD converted imaging data is data obtained by imaging a dark subject and reducing the levels of gradations in a case where the AD converted imaging data is data obtained by imaging a bright subject. In this case, it is desirable to preliminarily store, in the data holding section of the image signal processing section 560, the characteristic data of the tone curve, that is, which tone curve is to be used as a bases of the correction of gradation of the imaging data.

The input section 510A is, for example, a section provided for inputting the above-described reference clock signal, the timing control signal, the characteristic data, and the like from the outside of the device to the imaging device 1. The timing control signal is, for example, a vertical synchronization signal, a horizontal synchronization signal, or the like. The characteristic data is data to be stored in the data holding section of the image signal processing section 560, for example. The input section 510A includes an input terminal 511, an input circuit section 512, an input amplitude changing section 513, an input data conversion circuit section 514, and a power supply section (not depicted), for example.

The input terminal 511 is an external terminal for inputting data. The input circuit section 512 is a unit provided for capturing a signal input to the input terminal 511 into the imaging device 1. The input amplitude changing section 513 changes the amplitude of the signal captured by the input circuit section 512 to an amplitude highly usable inside the imaging device 1. The input data conversion circuit section 514 changes the arrangement of data strings of the input data. The input data conversion circuit section 514 is constituted with a serial-to-parallel conversion circuit, for example. The serial-to-parallel conversion circuit converts a serial signal received as input data into a parallel signal. The input section 510A can omit the input amplitude changing section 513 and the input data conversion circuit section 514. The power supply section supplies power set to various voltages required inside the imaging device 1 on the basis of power supplied from the outside to the imaging device 1.

When the imaging device 1 is connected to an external memory device, the input section 510A may be provided with a memory interface circuit that receives data from the external memory device. Examples of the external memory device include a flash drive, SRAM, and DRAM.

The output section 510B outputs image data to the outside of the device. Examples of the image data include image data captured by the imaging device 1, image data that has undergone signal processing performed by the image signal processing section 560, and the like. The output section 510B includes, for example, an output data conversion circuit section 515, an output amplitude changing section 516, an output circuit section 517, and an output terminal 518.

The output data conversion circuit section 515 is, for example, constituted with a parallel-to-serial conversion circuit, and thus, the output data conversion circuit section 515 converts a parallel signal used inside the imaging device 1 into a serial signal. The output amplitude changing section 516 changes the amplitude of a signal used inside the imaging device 1. The signal having amplitude changed will have high usability in an external device connected to the outside of the imaging device 1. The output circuit section 517 is a circuit that outputs data from the inside of the imaging device 1 to the outside of the device. The output circuit section 517 also drives wiring outside the imaging device 1 connected to the output terminal 518. Data is output from the imaging device 1 to the outside of the device via the output terminal 518. The output section 510B can omit the output data conversion circuit section 515 and the output amplitude changing section 516.

When the imaging device 1 is connected to an external memory device, the output section 510B may be provided with a memory interface circuit that outputs data to the external memory device. Examples of the external memory device include a flash drive, SRAM, and DRAM.

### [Schematic configuration of imaging device 1]

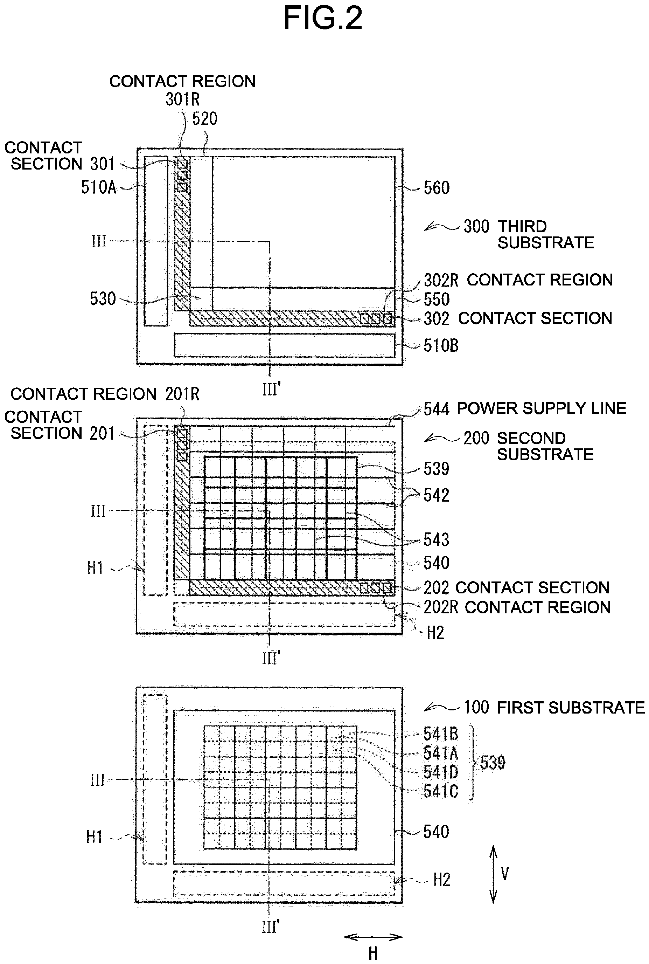

FIGS. 2 and 3 depict an example of a schematic configuration of the imaging device 1. The imaging device 1 includes three substrates (a first substrate 100, a second substrate 200, and a third substrate 300). FIG. 2 schematically depicts a planar configuration of each of the first substrate 100, the second substrate 200, and the third substrate 300. FIG. 3 schematically depicts a cross-sectional configuration of the first substrate 100, the second substrate 200, and the third substrate 300 stacked on each other. FIG. 3 corresponds to the cross-sectional configuration taken along line III-III' depicted in FIG. 2. The imaging device 1 is an imaging device having a three-dimensional structure formed by bonding three substrates (the first substrate 100, the second substrate 200, and the third substrate 300). The first substrate 100 includes a semiconductor layer 100S and a wiring layer 100T. The second substrate 200 includes a semiconductor layer 200S and a wiring layer 200T. The third substrate 300 includes a semiconductor layer 300S and a wiring layer 300T. Here, a combination of the wiring included in each substrate of the first substrate 100, the second substrate 200, and the third substrate 300 together with an interlayer insulating film around the wiring is referred to as wiring layers (100T, 200T, and 300T) provided on each of the substrates (the first substrate 100, the second substrate 200, and the third substrate 300) for convenience. The first substrate 100, the second substrate 200, and the third substrate 300 are stacked in this order, and specifically, the layers are stacked in order of the semiconductor layer 100S, the wiring layer 100T, the semiconductor layer 200S, the wiring layer 200T, the wiring layer 300T, and the semiconductor layer 300S in a stacking direction. Specific configurations of the first substrate 100, the second substrate 200, and the third substrate 300 will be described below. The arrow depicted in FIG. 3 indicates the incident direction of light L on the imaging device 1. In the following cross-sectional views in the present specification, the light incident side in the imaging device 1 may be referred to as "lower", "lower side", or "below", and the side opposite to the light incident side may be referred to as "upper", "upper side", or "above" for convenience. In addition, in the present specification, for convenience, in a substrate including a semiconductor layer and a wiring layer, a side of the wiring layer may be referred to as a front surface, and a side of the semiconductor layer may be referred to as a back surface. The description of the specification is not limited to the above terms. The imaging device 1 is, for example, a back-illuminated imaging device in which light enters from the back surface side of the first substrate 100 having a photodiode.

Both the pixel array section 540 and the pixel sharing unit 539 included in the pixel array section 540 are constituted by using both the first substrate 100 and the second substrate 200. The first substrate 100 is provided with the plurality of pixels 541A, 541B, 541C, and 541D included in the pixel sharing unit 539. Each of these pixels 541 includes a photodiode (photoelectric conversion section 101 described below) and a transfer transistor (charge transfer section 102 described below). The second substrate 200 is provided with a pixel circuit (the pixel circuit 210 to be described below) included in the pixel sharing unit 539. The pixel circuit reads out the pixel signal transferred from the photodiode of each of the pixels 541A, 541B, 541C, and 541D via the transfer transistor, or resets the photodiode. In addition to such a pixel circuit, the second substrate 200 includes a plurality of row drive signal lines 542 extending in the row direction and a plurality of vertical signal lines 543 extending in the column direction. The second substrate 200 further includes a power supply line 544 extending in the row direction. The third substrate 300 includes, for example, an input section 510A, a row drive section 520, a timing controlling section 530, a column signal processing section 550, an image signal processing section 560, and an output section 510B. The region in which the row drive section 520 is located partially overlaps the pixel array section 540 in the stacking direction of the first substrate 100, the second substrate 200, and the third substrate 300 (hereinafter, simply referred to as the stacking direction), for example. More specifically, the row drive section 520 is provided in a region overlapping the vicinity of an end of the pixel array section 540 in the H direction in the stacking direction (FIG. 2). The column signal processing section 550 is provided, for example, in a region partially overlapping the pixel array section 540 in the stacking direction. More specifically, the column signal processing section 550 is provided in a region overlapping the vicinity of the end of the pixel array section 540 in the V direction, in the stacking direction (FIG. 2). Although not depicted, the input section 510A and the output section 510B may be disposed in a portion other than the third substrate 300, and may be disposed on the second substrate 200, for example. Alternatively, the input section 510A and the output section 510B may be provided on the back surface (light incident surface) side of the first substrate 100. The pixel circuit provided on the second substrate 200 may also be referred to as a pixel transistor circuit, a pixel transistor group, a pixel transistor, a pixel readout circuit, or a readout circuit as an alternative term. In the present specification, the term "pixel circuit" is used.

The first substrate 100 and the second substrate 200 are electrically connected by through-substrate electrodes (through-substrate electrodes 252, 253A and 253B of FIG. 8 to be described below), for example. The second substrate 200 and the third substrate 300 are electrically connected via contact sections 201, 202, 301, and 302, for example. The contact sections 201 and 202 are provided on the second substrate 200, while the contact sections 301 and 302 are provided on the third substrate 300. The contact section 201 of the second substrate 200 is in contact with the contact section 301 of the third substrate 300, while the contact section 202 of the second substrate 200 is in contact with the contact section 302 of the third substrate 300. The second substrate 200 has a contact region 201R including a plurality of the contact sections 201 and a contact region 202R including a plurality of the contact sections 202. The third substrate 300 has a contact region 301R including a plurality of the contact sections 301 and a contact region 302R including a plurality of the contact sections 302. The contact regions 201R and 301R are provided between the pixel array section 540 and the row drive section 520 in the stacking direction (FIG. 3). In other words, the contact regions 201R and 301R are provided, for example, in a region where the row drive section 520 (on the third substrate 300) and the pixel array section 540 (on the second substrate 200) overlap each other in the stacking direction or in a region in their vicinity. The contact regions 201R and 301R are disposed at ends in the H direction in such regions, for example (FIG. 2). In the third substrate 300, for example, the contact region 301R is provided at a position overlapping a part of the row drive section 520, specifically the end of the row drive section 520 in the H direction (FIGS. 2 and 3). The contact sections 201 and 301 connect, for example, the row drive section 520 provided on the third substrate 300 and the row drive signal line 542 provided on the second substrate 200 to each other. For example, the contact sections 201 and 301 may connect the input section 510A provided on the third substrate 300, the power supply line 544, and a reference potential line (a ground line described below) to each other. The contact regions 202R and 302R are provided between the pixel array section 540 and the column signal processing section 550 in the stacking direction (FIG. 3). In other words, the contact regions 202R and 302R are provided, for example, in a region where the column signal processing section 550 (on the third substrate 300) and the pixel array section 540 (on the second substrate 200) overlap each other in the stacking direction or in a region in their vicinity. The contact regions 202R and 302R are disposed at ends in the V direction in such regions, for example (FIG. 2). In the third substrate 300, for example, the contact region 301R is provided at a position overlapping a part of the column signal processing section 550, specifically, the end of the column signal processing section 550 in the V direction (FIGS. 2 and 3). The contact sections 202 and 302 are provided for connecting a pixel signal (a signal corresponding to the amount of charge generated as a result of photoelectric conversion in a photodiode) output from each of the plurality of pixel sharing units 539 included in the pixel array section 540 to the column signal processing section 550 provided on the third substrate 300. The pixel signal is to be transmitted from the second substrate 200 to the third substrate 300.

FIG. 3 is an example of a cross-sectional view of the imaging device 1 as described above. The first substrate 100, the second substrate 200, and the third substrate 300 are electrically connected to each other via the wiring layers 100T, 200T, and 300T. For example, the imaging device 1 includes an electrical connecting location that electrically connects the second substrate 200 and the third substrate 300 to each other. Specifically, the contact sections 201, 202, 301, and 302 are formed with electrodes formed of a conductive material. The conductive material is formed of, for example, a metal material such as copper (Cu), aluminum (Al), or gold (Au). By directly bonding wiring lines formed as electrodes, for example, the contact regions 201R, 202R, 301R, and 302R electrically connect the second substrate and the third substrate to each other, enabling signal input and/or output between the second substrate 200 and the third substrate 300.

An electrical connecting location that electrically connects the second substrate 200 and the third substrate 300 can be provided at a desired location. For example, as described as the contact regions 201R, 202R, 301R, and 302R in FIG. 3, the contact regions may be provided in a region overlapping the pixel array section 540 in the stacking direction. The electrical connecting location may be provided in a region not overlapping the pixel array section 540 in the stacking direction. Specifically, it may be provided in a region overlapping a peripheral portion disposed outside the pixel array section 540 in the stacking direction.

The first substrate 100 and the second substrate 200 are provided with connection holes H1 and H2, for example. The connection holes H1 and H2 penetrate the first substrate 100 and the second substrate 200 (FIG. 3). The connection holes H1 and H2 are provided outside the pixel array section 540 (or a portion overlapping the pixel array section 540) (FIG. 2). For example, the connection hole H1 is disposed outside the pixel array section 540 in the H direction, while the connection hole H2 is disposed outside the pixel array section 540 in the V direction. For example, the connection hole H1 reaches the input section 510A provided in the third substrate 300, while the connection hole H2 reaches the output section 510B provided in the third substrate 300. The connection holes H1 and H2 may be hollow, and may at least a partially contain a conductive material. For example, there is a configuration in which a bonding wire is connected to an electrode formed as the input section 510A and/or the output section 510B. Alternatively, there is a configuration in which the electrode formed as the input section 510A and/or the output section 510B is connected to the conductive material provided in the connection holes H1 and H2. The conductive material provided in the connection holes H1 and H2 may be embedded in a part or all of the connection holes H1 and H2, and the conductive material may be formed on side walls of the connection holes H1 and H2.

FIG. 3 is a case of a structure in which the input section 510A and the output section 510B are provided on the third substrate 300, but the present disclosure is not limited thereto. For example, by sending a signal of the third substrate 300 to the second substrate 200 via the wiring layers 200T and 300T, the input section 510A and/or the output section 510B can be provided on the second substrate 200. Similarly, by sending a signal of the second substrate 200 to the first substrate 1000 via the wiring layers 100T and 200T, the input section 510A and/or the output section 510B can be provided on the first substrate 100.

Note that the imaging device 1 and the pixel array section 540 are examples of an imaging element described in the claims.

FIG. 4 is an equivalent circuit diagram depicting an example of a configuration of the pixel sharing unit. The pixel sharing unit 539 includes the plurality of pixels 541 (FIG. 4 depicts four pixels 541, namely, the pixels 541A, 541B, 541C, and 541D), one pixel circuit 210 connected to the plurality of pixels 541, and a vertical signal line 543 connected to the pixel circuit 210. The pixel circuit 210 includes, for example, four transistors, specifically, an amplification transistor 213, a selection transistor 214, a reset transistor 211, and a capacitance switching transistor 212. As described above, by operating one pixel circuit 210 in time division, the pixel sharing unit 539 is configured to sequentially output the pixel signals of the four pixels 541 (pixels 541A, 541B, 541C, and 541D) included in the pixel sharing unit 539 to the vertical signal line 543. The mode in which one pixel circuit 210 is connected to the plurality of pixels 541 and pixel signals of the plurality of pixels 541 are output by the one pixel circuit 210 in time division is referred to as a mode in which "the plurality of pixels 541 shares one pixel circuit 210".

The pixels 541A, 541B, 541C, and 541D have components common to each other.

The pixels 541A, 541B, 541C, and 541D include, for example, a photoelectric conversion section 101, a charge transfer section 102 electrically connected to the photoelectric conversion section 101, and a charge holding section 103 electrically connected to the charge transfer section 102. The photoelectric conversion section 101 (photoelectric conversion sections 101A, 101B, 101C, and 101D) has a cathode electrically connected to a source of the charge transfer section 102 and has an anode electrically connected to a reference potential line (for example, a ground line). The photoelectric conversion section 101 performs photoelectric conversion of incident light and generates a charge corresponding to the amount of received light. The charge transfer section 102 (charge transfer sections 102A, 102B, 102C, and 102D) is an n-channel MOS transistor, for example. The charge transfer section 102 has a drain electrically connected to the charge holding section 103 and has a gate electrically connected to a drive signal line (signal lines TG1, TG2, TG3, and TG4). This drive signal line is a part of the plurality of row drive signal lines 542 (refer to FIG. 1) connected to one pixel sharing unit 539. The charge transfer section 102 transfers the charge generated in the photoelectric conversion section 101 to the charge holding section 103. The charge holding section 103 (charge holding sections 103A, 103B, 103C, and 103D) is an n-type diffusion layer region formed in the p-type semiconductor layer. Such charge holding section 103 is referred to as floating diffusion (FD). The charge holding section 103 is a charge holding means that temporarily holds the charge transferred from the photoelectric conversion section 101, and is a charge-voltage conversion means that generates a voltage corresponding to the charge amount.

The four charge holding sections 103 (charge holding sections 103A, 103B, 103C, and 103D) included in one pixel sharing unit 539 are electrically connected to each other and electrically connected to the gate of the amplification transistor 213 and the source of the capacitance switching transistor 212. The drain of the capacitance switching transistor 212 is connected to the source of the reset transistor 211, while the gate of the capacitance switching transistor 212 is connected to a drive signal line FDG. This drive signal line FDG is a part of the plurality of row drive signal lines 542 connected to one pixel sharing unit 539. The drain of the reset transistor 211 is connected to a power supply line Vdd, while the gate of the reset transistor 211 is connected to the drive signal line RST. This drive signal line RST is a part of the plurality of row drive signal lines 542 connected to one pixel sharing unit 539. The gate of the amplification transistor 213 is connected to the charge holding section 103, the drain of the amplification transistor 213 is connected to the power supply line Vdd, and the source of the amplification transistor 213 is connected to the drain of the selection transistor 214. The source of the selection transistor 214 is connected to the vertical signal line 543, while the gate of the selection transistor 214 is connected to the drive signal line SEL. This drive signal line SEL is a part of the plurality of row drive signal lines 542 connected to one pixel sharing unit 539.

When the charge transfer section 102 is turned on, the charge transfer section 102 transfers the charge of the photoelectric conversion section 101 to the charge holding section 103. A gate (transfer gate) of the charge transfer section 102 includes, for example, an electrode referred to as a vertical electrode, and is provided to extend from a front surface of a semiconductor layer (a semiconductor layer 100S in FIG. 8 to be described below) to a depth reaching the photoelectric conversion section 101 as depicted in FIG. 8 to be described below. The reset transistor 211 resets the potential of the charge holding section 103 to a predetermined potential. When the reset transistor 211 is turned on, the potential of the charge holding section 103 is reset to the potential of the power supply line Vdd. The selection transistor 214 controls an output timing of the pixel signal from the pixel circuit 210. The amplification transistor 213 generates a signal of a voltage corresponding to the level of the charge held in the charge holding section 103 as a pixel signal. The amplification transistor 213 is connected to the vertical signal line 543 via the selection transistor 214. The amplification transistor 213 constitutes a source follower together with a load circuit section (refer to FIG. 1) connected to the vertical signal line 543 in the column signal processing section 550. When the selection transistor 214 is turned on, the amplification transistor 213 outputs the voltage of the charge holding section 103 to the column signal processing section 550 via the vertical signal line 543. The reset transistor 211, the amplification transistor 213, and the selection transistor 214 are n-channel MOS transistors, for example.

The capacitance switching transistor 212 is used to change a gain of charge-voltage conversion in the charge holding section 103. In general, a pixel signal is weak at the time of photographing in a dark place. Based on Q = CV, when the capacitance (FD capacitance C) of the charge holding section 103 is large at the time of performing charge-voltage conversion, this results in a small V at the time of conversion into a voltage by the amplification transistor 213. On the other hand, in a bright place, the pixel signal becomes large, and thus, the charge holding section 103 cannot receive the charge of the photoelectric conversion section 101 unless the FD capacitance C is large. Further, the FD capacitance C needs to be large so that V when converted into a voltage by the amplification transistor 213 does not become too high (in other words, so as to be low). In view of these, when the capacitance switching transistor 212 is turned on, the gate capacitance for the capacitance switching transistor 212 increases, leading to a large entire FD capacitance C. In contrast, turning off the capacitance switching transistor 212 decreases the entire FD capacitance C. In this manner, switching on/off of the capacitance switching transistor 212 can achieve variable FD capacitance C, making it possible to switch the conversion efficiency. The capacitance switching transistor 212 is an n-channel MOS transistor, for example.

Incidentally, it is also possible to have a configuration not including the capacitance switching transistor 212. At this time, for example, the pixel circuit 210 includes three transistors, for example, an amplification transistor 213, a selection transistor 214, and a reset transistor 211. The pixel circuit 210 includes, for example, at least one of pixel transistors such as an amplification transistor 213, a selection transistor 214, a reset transistor 211, and a capacitance switching transistor 212.

The selection transistor 214 may be provided between the power supply line Vdd and the amplification transistor 213. In this case, the drain of the reset transistor 211 is electrically connected to the power supply line Vdd and the drain of the selection transistor 214. The source of the selection transistor 214 is electrically connected to the drain of the amplification transistor 213, while the gate of the selection transistor 214 is electrically connected to the row drive signal line 542 (refer to FIG. 1). The source of the amplification transistor 213 (an output end of the pixel circuit 210) is electrically connected to the vertical signal line 543, while the gate of the amplification transistor 213 is electrically connected to the source of the reset transistor 211. Note that, although not depicted, the number of pixels 541 sharing one pixel circuit 210 may be other than four. For example, two or eight pixels 541 may share one pixel circuit 210.

### [Configuration of cross-section of imaging device]

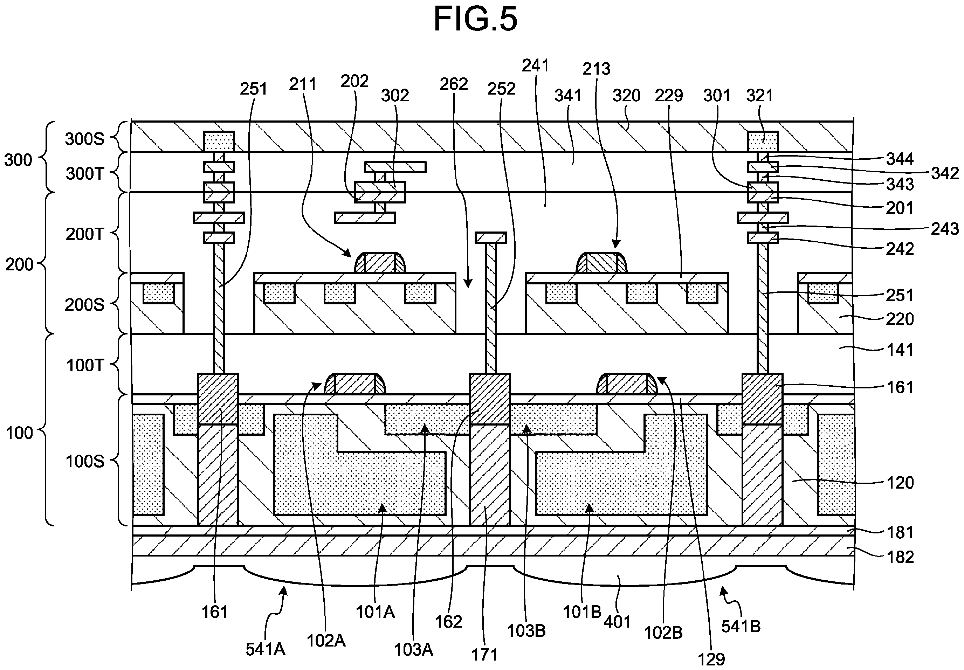

FIG. 5 is a cross-sectional view depicting a configuration example of the imaging device according to the embodiment of the present disclosure. The drawing is a cross-sectional view schematically depicting the imaging device 1. The imaging device 1 in the drawing includes a first substrate 100, a second substrate 200, and a third substrate 300. As described above, the first substrate 100 includes the semiconductor layer 100S and the wiring layer 100T, the second substrate 200 includes the semiconductor layer 200S and the wiring layer 200T, and the third substrate 300 includes the semiconductor layer 300S and the wiring layer 300T. Further, the imaging device 1 further includes a protective film 181, a color filter 182, and an on-chip lens 401. Note that the drawing depicts the pixels 541A and 541B.

The semiconductor layer 100S includes a first semiconductor substrate 120, an insulating film 129, and an isolating section 171.

The first semiconductor substrate 120 is a semiconductor substrate on which the photoelectric conversion section 101 is disposed. The charge transfer section 102 and the charge holding section 103 are further disposed on the first semiconductor substrate 120 in the drawing. The drawing depicts the photoelectric conversion sections 101A and 101B, the charge transfer sections 102A and 102B, and the charge holding sections 103A and 103B. The first semiconductor substrate 120 can be formed of silicon (Si), for example. Note that the wiring layer 100T is disposed on the front surface side of the first semiconductor substrate 120.

The insulating film 129 is a film that insulates the front surface side of the first semiconductor substrate 120. The insulating film 129 can be formed of silicon oxide (SiO₂) or silicon nitride (SiN) .

The isolating section 171 is disposed at a boundary of the pixels 541 to isolate the pixels 541 from each other. The drawing depicted an example in which the pixels 541A and 541B are isolated from each other by the isolating section 171. Note that buried electrodes 161 and 162 are further disposed at the boundary of the pixel 541 in the drawing.

The wiring layer 100T includes an insulating layer 141. The insulating layer 141 insulates the gate electrode, a through-substrate electrode 251, and the like disposed on the front surface side of the first semiconductor substrate 120. The insulating layer 141 can be formed of SiO₂, for example. Note that through-substrate electrodes 251 and 252 described below are disposed in the wiring layer 100T.

The semiconductor layer 200S includes a second semiconductor substrate 220 and an insulating film 229. In addition, the semiconductor layer 200S has a through hole 262.

The second semiconductor substrate 220 is a semiconductor substrate on which the pixel circuit 210 is disposed. Among the pixel circuit 210, a reset transistor 211 and an amplification transistor 213 are depicted on the second semiconductor substrate 220 in the drawing. Similarly to the first semiconductor substrate 120, the second semiconductor substrate 220 can be formed of Si. The through hole 262 is a through hole formed in the second semiconductor substrate 220 to allow passage of the through-substrate electrode 251 and the like described below. An insulating layer 241 is disposed in the through hole 262.

The wiring layer 200T includes an insulating layer 241, a wiring line 242, a via plug 243, through-substrate electrodes 251 to 253, and contact sections 201 and 202. The wiring line 242 is a conductor that transmits an electric signal or the like to an element or the like disposed on the second semiconductor substrate 220. The wiring line 242 can be formed of metal such as copper (Cu). The insulating layer 241 insulates the wiring line 242 and the like. Similarly to the insulating layer 141, the insulating layer 241 can be formed of SiO₂ or the like. The wiring line 242 and the insulating layer 241 can be configured in multiple layers. The drawing depicts the wiring line 242 and the insulating layer 241 formed in two layers as an example. The wiring lines 242 disposed in different layers can be connected to each other by the via plug 243. The via plug 243 can be formed of columnar metal such as columnar Cu, for example.

The through-substrate electrodes 251 and 252 are columnar electrodes connecting the wiring line 242 and a member disposed on the front surface side of the first semiconductor substrate 120. The through-substrate electrodes 251 and 252 are connected to the buried electrodes 161 and 162, respectively. These through-substrate electrodes 252 and the like can be formed of metal such as tungsten, and can be disposed in the through holes 262.

The through-substrate electrode 251 connects the first semiconductor substrate 120 and another semiconductor substrate to each other in order to allow the reference potential to be used in common. The through-substrate electrode 252 transmits the charge of the charge holding section 103 of the first semiconductor substrate 120 to the second semiconductor substrate 220. These through-substrate electrodes 251 and 252 can be formed of columnar tungsten, for example. Note that the through-substrate electrode 251 in the drawing is connected to the third substrate 300 via the wiring line 242, the via plug 243, and the contact section 201.

As described above, the contact sections 201 and 202 are connected to the contact sections 301 and 303 of the third substrate 300, respectively. The contact section 201 is connected to the through-substrate electrode 251 and transmits the reference potential. The contact section 202 is used to transmit signals and the like.

The semiconductor layer 300S includes a third semiconductor substrate 320. The above-described image signal processing section 560 (not depicted) and the like are disposed on the third semiconductor substrate 320. In addition, a well region is formed in the third semiconductor substrate 320. A semiconductor region 321 is disposed in this well region. The semiconductor region 321 is formed to have a relatively high impurity concentration, and is connected to a contact plug 344.

The wiring layer 300T includes an insulating layer 341, a wiring 342, a via plug 343, a contact plug 344, and contact sections 301 and 302. Since these configurations are similar to the insulating layer 241, the wiring line 242, the via plug 243, a contact plug 244, and the contact sections 301 and 302, the description thereof will be omitted.

The protective film 181 protects the back surface side of the first semiconductor substrate 120. The protective film 181 can be formed of SiO₂, for example. The color filter 182 is an optical filter that is disposed for each pixel 541 and transmits light having a predetermined wavelength among the incident light. The on-chip lens 401 is a lens that is disposed for each pixel 541 and condenses incident light onto the photoelectric conversion section 101.

In the present exemplary embodiment, the first substrate 100 and the second substrate 200 are connected via the through-substrate electrode, and the second substrate 200 and the third substrate 300 are connected via the contact section, but the configuration is not limited to this example. For example, the first substrate 100 and the second substrate 200 may also be connected via a contact section.

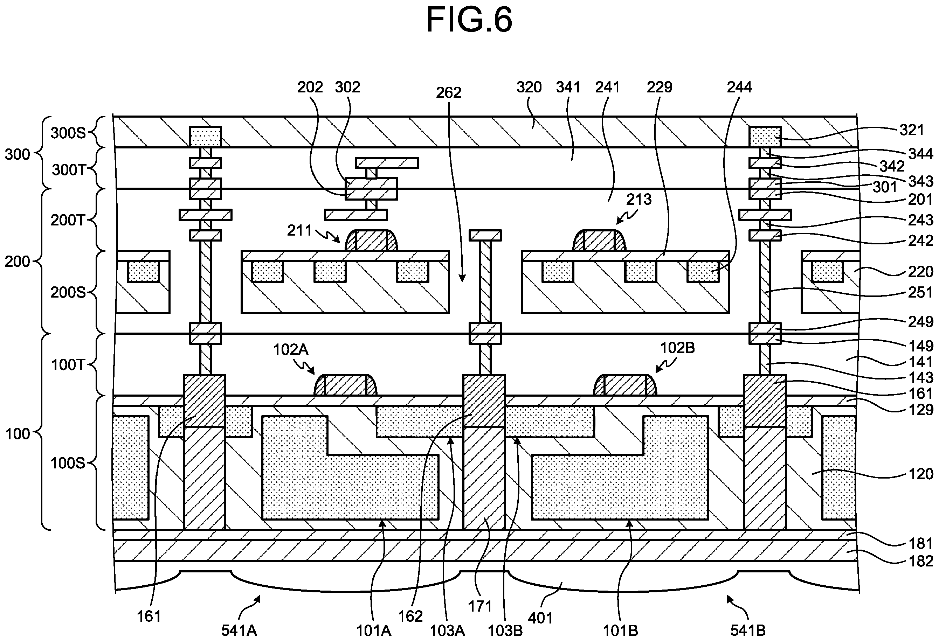

FIG. 6 is a cross-sectional view depicting another configuration example of the imaging device according to the embodiment of the present disclosure. In the second substrate 200 in the drawing, the insulating layer 241 is formed and a contact section 249 is disposed also on the back surface of the semiconductor layer 200S. The contact section 249 is connected to a contact section 149 disposed on the first substrate 100 in the drawing.

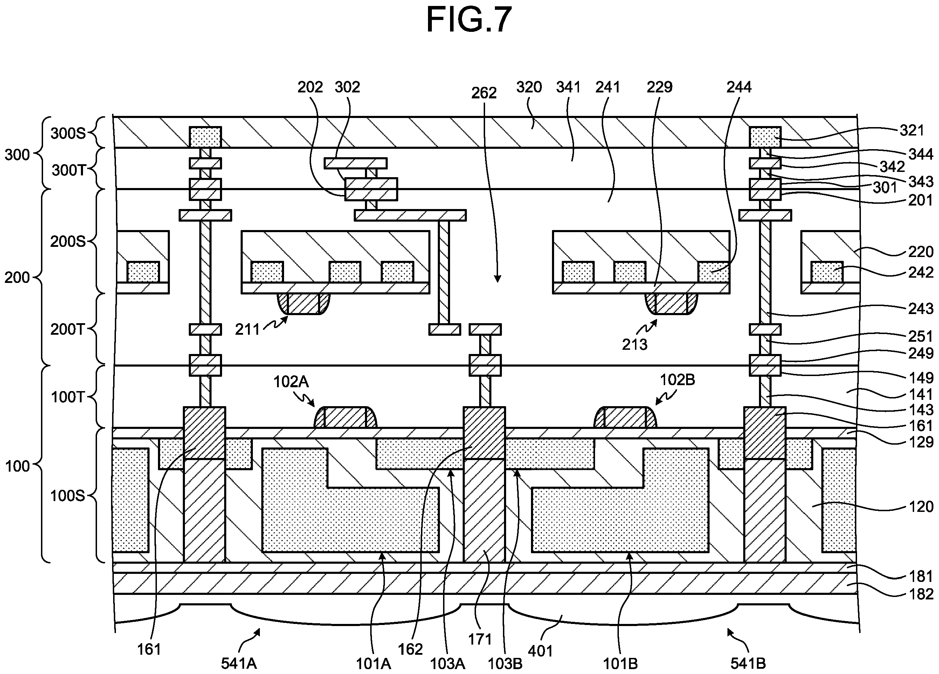

FIG. 7 is a cross-sectional view depicting another configuration example of the imaging device according to the embodiment of the present disclosure. The second substrate 200 in the drawing corresponds to a vertically flipped configuration of the second substrate 200 in FIG. 6.

Note that FIGS. 3 and 5 to 7 depict examples in which the electrical connecting location between the first substrate 100 and the second substrate 200 and the electrical connecting location between the second substrate 200 and the third substrate 300 are disposed at positions overlapping the pixel array section 540. It is also possible to adopt a configuration in which the electrical connecting location between the first substrate 100 and the second substrate 200 and the electrical connecting location between the second substrate 200 and the third substrate 300 are disposed in a region outside the pixel array section 540. Specifically, in FIGS. 3 and 5 to 7, the contact sections 201, 202, 301, and 302, which are electrical connecting locations between the second substrate 200 and the third substrate 300, can also be disposed in a region outside the pixel array section 540. Similarly, in FIGS. 6 and 7, the contact sections 149 and 249, which are electrical connecting locations between the first substrate 100 and the second substrate 200, can also be disposed in a region outside the pixel array section 540.

### [Configuration of pixel sharing unit]

FIG. 8 is a diagram depicting a configuration example of a pixel sharing unit according to the first embodiment of the present disclosure. The drawing is a plan view depicting a configuration example of the pixel sharing unit 539 in the pixel array section 540. In addition, FIG. 8 is a diagram depicting configurations of the first substrate 100 and the second substrate 200 viewed from the side of the second substrate 200.

In the drawing, an outlined rectangular region represents a region of the first semiconductor substrate 120 corresponding to a region of the pixel 541. Further, the region with dot hatching represents a semiconductor region formed on the first semiconductor substrate 120. Further, an oblique rectangular region represents a gate electrode of the charge transfer section 102. Outlined circles represent the through-substrate electrodes 251 to 253. A dotted rectangle represents an element (reset transistor 211, capacitance switching transistor 212, amplification transistor 213, and selection transistor 214) of the pixel circuit 210. Further, a dotted rectangle depicted at the boundary of the pixel 541 represents the range of the pixel sharing unit 539. A two-dot chain line rectangle represents a range of a pixel group 538 described below.

The isolating section 171 is disposed at the boundary of the pixel 541. The isolating section 171 is formed in a shape surrounding the pixel 541. Further, the buried electrodes 161 and 162 are further disposed on the first semiconductor substrate 120 at the boundary of the pixels 541. The buried electrode 161 is connected to the well region of the first semiconductor substrate 120. Note that a semiconductor region 123 is disposed on the first semiconductor substrate 120 of the pixel 541 adjacent to the buried electrode 161 in the drawing. The buried electrode 161 is connected to the well region via the semiconductor region 123. The buried electrode 162 is connected to a semiconductor region 122 constituting the charge holding section 103. The buried electrodes 161 and 162 in the drawing are disposed by being buried in the first semiconductor substrate 120 adjacent to the corners of the four pixels 541.

As described above, the pixels 541A, 541B, 541C, and 541D are disposed on the first substrate 100. As depicted in the figure, the pixels 541A, 541B, 541C, and 541D are disposed in a 2 row × 2 column pattern, and the charge holding sections 103A, 103B, 103C, and 103D are disposed in the vicinity of the central portions thereof. The charge transfer sections 102A, 102B, 102C, and 102D and the photoelectric conversion sections 101A, 101B, 101C, and 101D are disposed adjacent to the charge holding sections 103A, 103B, 103C, and 103D, respectively. Note that the configuration of the pixel sharing unit 539 is not limited to this example. For example, the pixel sharing unit 539 may include a number of pixels 541 other than 4.

The buried electrode 162 is disposed at the central portion of the pixels 541A, 541B, 541C, and 541D in 2 rows and 2 columns. The pixels 541A, 541B, 541C, and 541D, together with the pixel circuit 210 of the second semiconductor substrate 220, constitute the pixel sharing unit 539. In other words, in the pixel sharing unit 539 of the drawing, the pixels 541A, 541B, 541C, and 541D are commonly connected to the buried electrode 162 and the pixel circuit 210. Such pixel sharing units 539 are disposed in a two-dimensional matrix.

On the other hand, the pixel group 538 also has four pixels 541 formed by 2 rows and 2 columns. The pixel 541 constituting the pixel group 538 corresponds to a pixel at a position shifted by one pixel in the vertical and horizontal directions of the drawing with respect to the pixel sharing unit 539. The buried electrode 161 is disposed at the central portion of the four pixels 541 formed by 2 rows and 2 columns constituting the pixel group 538. These four pixels 541 are commonly connected to the buried electrode 161. Note that the configuration of the pixel group 538 is not limited to this example. For example, the pixel group 538 may include a number of pixels 541 other than 4.

### [Configuration of pixel]

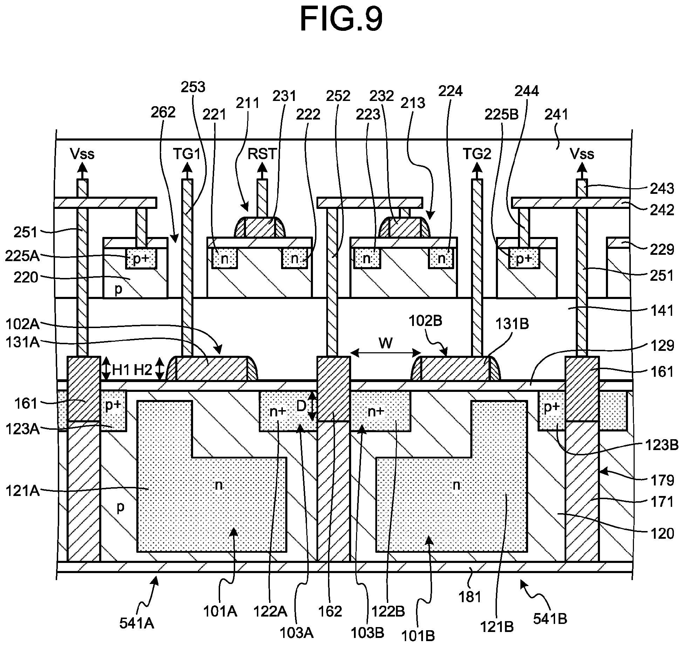

FIG. 9 is a diagram depicting a configuration example of a pixel according to the first embodiment of the present disclosure. The drawing is a schematic cross-sectional view depicting a configuration example of the pixel 541. The drawing corresponds to a cross-sectional view taken along line a-a' in FIG. 8. The drawing depicts the pixels 541A and 541B. In addition, the drawing omits illustration of the third semiconductor substrate 320.

As described above, the photoelectric conversion section 101, the charge transfer section 102, and the charge holding section 103 are disposed on the first semiconductor substrate 120. The drawing depicts the photoelectric conversion sections 101A and 101B, the charge transfer sections 102A and 102B, and the charge holding sections 103A and 103B. These elements are disposed in a well region formed in the first semiconductor substrate 120. For convenience, it is assumed that the first semiconductor substrate 120 in the drawing constitutes a p-type well region. By disposing an n-type semiconductor region in the p-type well region, an element (a diffusion layer of element) can be formed.

A dot-hatched region depicted in the first semiconductor substrate 120 in the drawing represents an n-type semiconductor region. The photoelectric conversion section 101A is constituted with an n-type semiconductor region 121A. Specifically, a photodiode, constituted by a p-n junction formed at an interface between the n-type semiconductor region 121A and the surrounding p-type well region, corresponds to the photoelectric conversion section 101A. As depicted in the drawing, the photoelectric conversion section 101A is formed closer to the back surface side of the first semiconductor substrate 120. Further, a part of the photoelectric conversion section 101A is extended to the vicinity of the front surface side of the first semiconductor substrate 120. The photoelectric conversion section 101B is also configured similarly to the photoelectric conversion section 101A.

The charge holding sections 103A and 103B are constituted with n-type semiconductor regions 122A and 122B, respectively. These n-type semiconductor regions 122A and 122B constitute the above-described FD. In addition, the semiconductor regions 122A and 122B are disposed adjacent to the buried electrode 162.

The charge transfer section 102A is constituted with the semiconductor regions 121A and 122A and a gate electrode 131A. The n-type semiconductor regions 121A and 122A correspond to the source region and the drain region of the charge transfer section 102A. The charge transfer section 102A in the drawing is constituted with a planar type or horizontal MOS transistor in which a channel is formed along a surface of the semiconductor substrate. The gate electrode 131A is disposed on the front surface side of the first semiconductor substrate 120. The gate electrode 131A in the drawing includes a sidewall. When a drive voltage is applied to the gate electrode 131A, a channel is formed in a well region adjacent to the gate electrode 131A, allowing the n-type semiconductor regions 121A and 122A to be conductive. That is, conduction is established between the photoelectric conversion section 101A and the charge holding section 103A, allowing the charge of the photoelectric conversion section 101A to be transferred to the charge holding section 103A.

Similarly to the charge transfer section 102A, the charge transfer section 102B includes semiconductor regions 121B and 122B and a gate electrode 131B. The gate electrodes 131A and 131B can be formed with polycrystalline silicon implanted with impurities. The insulating film 129 between the gate electrodes 131A and 131B and the first semiconductor substrate 120 constitutes a gate insulating film.

The gate electrode 131A of the charge transfer section 102A is connected to the through-substrate electrode 253. The gate electrode 131A of the charge transfer section 102A is connected to the signal line TG1 via the through-substrate electrode 253. Similarly, the gate electrode 131B of the charge transfer section 102B is also connected to the signal line TG2 via the through-substrate electrode 253.

In addition, semiconductor regions 123A and 123B are disposed on the first semiconductor substrate 120. The semiconductor regions 123A and 123B, being semiconductor regions disposed in the well region of the first semiconductor substrate 120, are semiconductor regions having the same conductivity type as the well region and formed to have a relatively high impurity concentration. In addition, the semiconductor regions 123A and 123B are disposed adjacent to the buried electrode 161. Note that the semiconductor region 123 is an example of a high-concentration impurity region described in the claims.

The isolating section 171 is disposed at a boundary of the pixels 541 to isolate the pixels 541 from each other. The isolating section 171 isolates adjacent pixels 541 from each other in the first semiconductor substrate 120. The isolating section 171 can be constituted by burying an insulator such as SiO₂ in a groove 179 penetrating from the front surface side to the back surface side of the first semiconductor substrate 120, for example. Further, a light shielding member that shields incident light may be disposed in the isolating section 171.

The buried electrodes 161 and 162 are electrodes disposed at the boundaries of the pixels 541. In addition, the buried electrodes 161 and 162 are disposed on the front surface side of the first semiconductor substrate 120 at a position overlapping the isolating section 171. The buried electrodes 161 and 162 can be formed of polycrystalline silicon implanted with impurities, for example.

As described above, the buried electrode 161 is disposed adjacent to the semiconductor region 123 (semiconductor regions 123A and 123B) and connected to the well region of the first semiconductor substrate 120. The buried electrode 161 is connected to the through-substrate electrode 251 and is supplied with a reference potential (well potential). Incidentally, the semiconductor region 123 is a semiconductor region disposed to establish an ohmic connection between the buried electrode 161 and the first semiconductor substrate 120 or the like, being a semiconductor region having the same conductivity type as the well region and having a relatively high impurity concentration.

The buried electrode 162 is disposed adjacent to the semiconductor region 122 (semiconductor regions 122A and 122B) and connected to the charge holding sections 103 (charge holding sections 103A and 103B). The buried electrode 162 is connected to the through-substrate electrode 252. The through-substrate electrode 252 makes a connection between the charge holding section 103 and the pixel circuit 210. The through-substrate electrodes 251 and 252 are examples of a connecting location described in the claims.

The pixel circuit 210 is disposed on the second semiconductor substrate 220. The drawing depicts the reset transistor 211 and the amplification transistor 213. The reset transistor 211 and the amplification transistor 213 are disposed in a well region of the second semiconductor substrate 220. Similarly to the first semiconductor substrate 120, a p-type well region is formed in the second semiconductor substrate 220. For convenience, it is assumed that the second semiconductor substrate 220 in the drawing constitutes a p-type well region. The reset transistor 211 includes n-type semiconductor regions 221 and 222 and a gate electrode 231. The gate electrode 231 of the reset transistor 211 is connected to the signal line RST via the contact plug 244. The amplification transistor 213 includes n-type semiconductor regions 223 and 224 and a gate electrode 232. The gate electrode 232 of the amplification transistor 213 is connected to the through-substrate electrode 252 via the contact plug 244 and the wiring line 242. That is, the gate electrode 232 of the amplification transistor 213 is connected to the charge holding sections 103A and 103B via the contact plug 244, the wiring line 242, the through-substrate electrode 252, and the buried electrode 162.

The second semiconductor substrate 220 includes semiconductor regions 225A and 225B having a relatively high p-type impurity concentration. These p-type semiconductor regions 225A and 225B are connected to the through-substrate electrode 251 via the contact plug 244 and the wiring line 242. With this configuration, the well region of the second semiconductor substrate 220 is connected to the well region of the first semiconductor substrate 120. A common well potential is supplied to the first semiconductor substrate 120 and the second semiconductor substrate 220. Note that the through-substrate electrode 251 is further connected to a ground line Vss of the third semiconductor substrate 320 (not depicted) via the wiring line 242 and the contact plug 244. The ground potential of the third semiconductor substrate 320 is supplied to the through-substrate electrode 251 as a reference potential (well potential). Note that a fixed potential other than the ground potential can also be applied as the reference potential.

The buried electrode 161 is disposed at the boundary of the pixel 541 so as to be connected to the well region of the first semiconductor substrate 120 of the pixel 541. By supplying the reference potential (well potential) to the buried electrode 161, the well potential can be supplied to the first semiconductor substrate 120 of the pixel 541. The semiconductor region 123 for obtaining an ohmic connection can be formed with a small occupancy area adjacent to the buried electrode 161. In addition, by commonly connecting the buried electrode 161 to the plurality of pixels 541, the through-substrate electrode 251 can be shared by the plurality of pixels 541. This configuration makes it possible to reduce the number of through-substrate electrodes 251. This also makes it possible to reduce the opening area of the through hole 262 of the second semiconductor substrate 220 in which the through-substrate electrode 251 is disposed, facilitating the arrangement of the elements of the pixel circuit 210 in the second semiconductor substrate 220.

On the other hand, when the buried electrode 161 is not used, the through-substrate electrode 251 needs to be connected to the first semiconductor substrate 120 of the pixel 541 to supply the well potential. Specifically, the through-substrate electrode 251 is connected to the semiconductor region 123. In this case, there would be a need to dispose the semiconductor region 123 having a relatively large area. This is to reduce the occurrence of a failure due to positional deviation of the through-substrate electrode 251 in the manufacturing step. This would reduce the region assigned to the photoelectric conversion section 101 and the like in the pixel 541.

In addition, by disposing the buried electrode 162 at the boundary of the pixel 541 for connecting the buried electrode 162 to the charge holding section 103 of the first semiconductor substrate 120 of the pixel 541, it is possible, similarly to the semiconductor region 123 described above, to reduce the area of the semiconductor region 122 constituting the charge holding section 103. In addition, by commonly connecting the buried electrode 162 to the plurality of pixels 541, the through-substrate electrode 252 can be shared by the plurality of pixels 541. This makes it possible to reduce the number of through-substrate electrodes 252, with the reduction of the opening area of the through hole 262.

In this manner, the buried electrode 162 is disposed at a position overlapping the isolating section 171 at the boundary of the pixel 541 and connected to the first semiconductor substrate 120 of the pixel 541. The through-substrate electrode 251 and the like connected to the first semiconductor substrate 120 inside the pixel 541 can be moved to the outside of the pixel 541, enabling reduction of the occupancy area of the pixel 541.

In addition, the buried electrodes 161 and 162 are formed to be buried in the groove 179 formed in the first semiconductor substrate 120 at the boundary of the pixel 541. With this configuration, the buried electrodes 161 and 162 are formed to be connected to the side surface of the first semiconductor substrate 120 adjacent to the groove 179. With a configuration in which the connection surfaces between the buried electrodes 161 and 162 and the first semiconductor substrate 120 are disposed in a direction perpendicular to the surface of the first semiconductor substrate 120, it is possible to reduce the occupancy areas of the buried electrodes 161 and 162. This configuration makes it possible to reduce the occupancy area of the pixel 541. A burying depth ("D" in the drawing) of the buried electrode 161 and the like in the first semiconductor substrate 120 is preferably 50 nm or more. This is because this setting can increase the connection surface between the buried electrodes 161 and 162 and the first semiconductor substrate 120 and reduce the connection resistance.

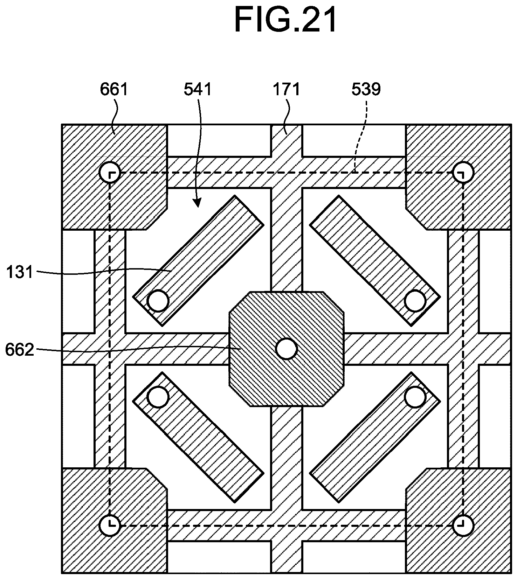

In contrast, when electrically connecting to the first semiconductor substrate 120 via an electrode disposed on the surface of the first semiconductor substrate 120, it would be necessary to dispose an electrode having a relatively large area as depicted in FIG. 21 to be described below. This is to reduce the connection resistance between the electrode and the semiconductor region. This would increase the area of the pixel 541.

In addition, downsizing and arranging the buried electrode 162 at the boundary of the pixel 541 makes it possible to increase a distance ("W" in the drawing) from a gate electrode 131. This configuration enables reduction of the parasitic capacitance between the gate electrode 131 of the charge transfer section 102 and the charge holding section 103. This makes it possible to improve the charge transfer efficiency of the charge transfer section 102. The height of the gate electrode 131 ("H2" in the drawing) is preferably equal to or less than the heights of the buried electrodes 161 and 162 ("H1" in the drawing). By doing this, it is possible to decrease the parasitic capacitance between the gate electrode 131 and the buried electrodes 161 and 162.

### [Method of manufacturing imaging element]

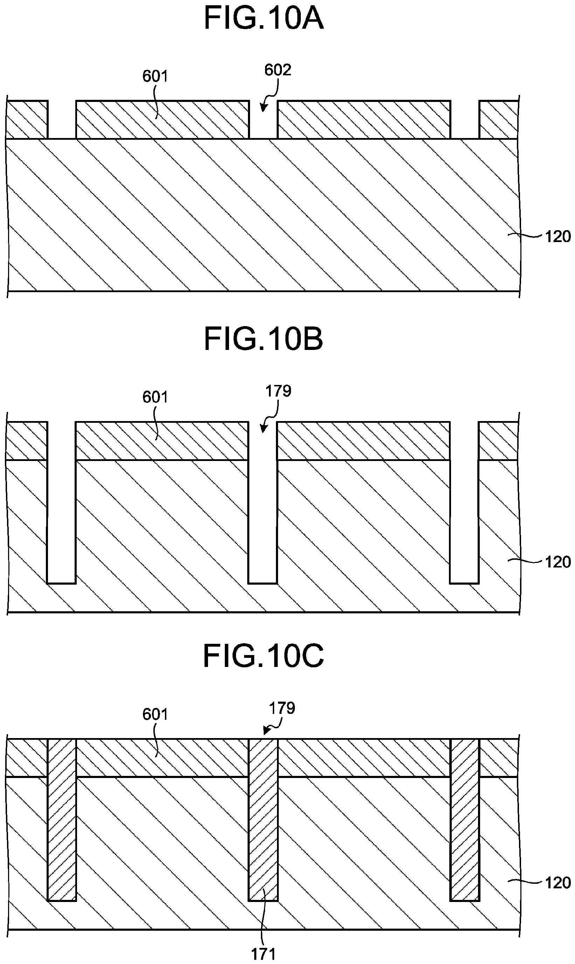

FIGS. 10A to 10I are diagrams depicting an example of a method of manufacturing the imaging element according to the first embodiment of the present disclosure. FIGS. 10A to 10I are diagrams depicting an example of a manufacturing step of the imaging device 1, being diagrams depicting an example of a manufacturing step related to a region of the first semiconductor substrate 120.

First, a well region and a semiconductor region 121 (not depicted) are formed in the first semiconductor substrate 120. Next, a resist 601 is disposed on the front surface side of the first semiconductor substrate 120. The resist 601 includes an opening 602 located at a boundary portion of the pixel 541 (FIG. 10A).

Next, the front surface side of the first semiconductor substrate 120 is etched using the resist 601 as a mask to form the groove 179 (FIG. 10B). This process can be performed by dry etching, for example.

Next, the isolating section 171 is disposed in the groove 179 (FIG. 10C). This process can be performed, for example, by forming a film of SiO₂ as a material of the isolating section 171 on the front surface side of the first semiconductor substrate 120 including the groove 179 using chemical vapor deposition (CVD) and grinding the film to a desired thickness. The grinding of the SiO₂ film can be performed by using Chemical mechanical polishing (CMP).

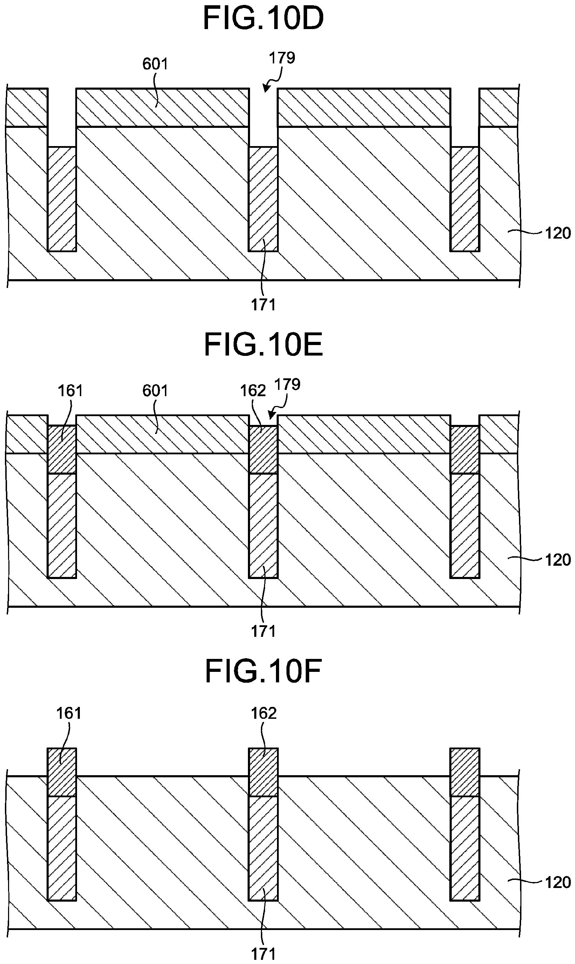

Next, the isolating section 171 is ground to expose, to the groove 179, the side surface in the vicinity of the front surface side of the first semiconductor substrate 120 (FIG. 10D). This process can be performed by etching the isolating section 171 using the resist 601 as a mask. The etching can be performed by applying anisotropic dry etching.

Next, the buried electrodes 161 and 162 are disposed in the groove 179 (FIG. 10E). This process can be performed, for example, by disposing polycrystalline silicon, which is a material of the buried electrodes 161 and 162, in the groove 179 by a method such as CVD. Next, the resist 601 is removed (FIG. 10F).

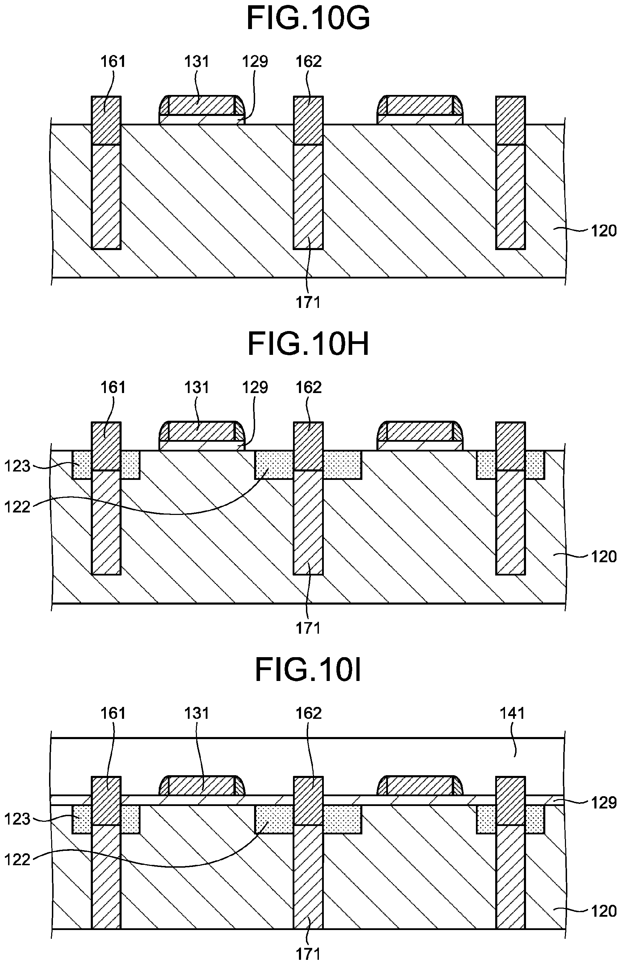

Next, a gate insulating film, a gate electrode 131, and a sidewall are formed (FIG. 10G). Next, the semiconductor region 123 and the like are formed (FIG. 10H). This process can be performed by ion implantation. Next, the insulating film 129 is formed on the front surface side of the first semiconductor substrate 120. Next, the insulating layer 141 is disposed (FIG. 10I). This process can be performed by forming a film of SiO₂ which is a material of the insulating layer 141 by CVD, for example. Through the above steps, the first semiconductor substrate 120 portion of the imaging device 1 can be manufactured.

Note that the configuration of the isolating section 171 is not limited to this example. For example, the isolating section 171 may be disposed in the groove 179 formed from the back surface side of the first semiconductor substrate 120. In addition, the isolating section 171 may be formed to have a depth that does not penetrate the first semiconductor substrate 120 and reaches the vicinity of the back surface side from the front surface side of the first semiconductor substrate 120.

### [Anther configuration of pixel sharing unit]

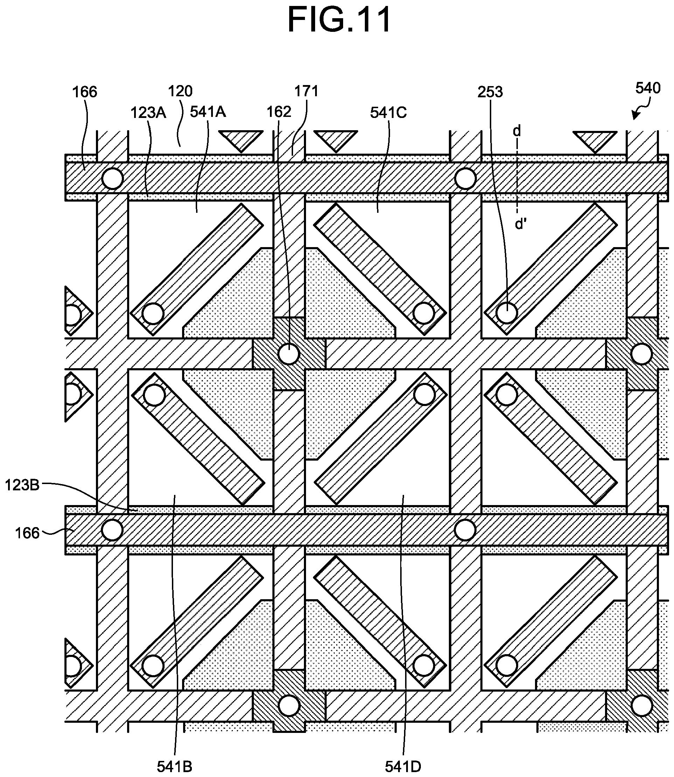

FIG. 11 is a diagram depicting another configuration example of the pixel sharing unit according to the first embodiment of the present disclosure. The drawing is a plan view depicting a configuration example of the pixel sharing unit 539, similarly to FIG. 8. The pixel sharing unit 539 in the drawing is different from the pixel sharing unit 539 in FIG. 8 in that a band-shaped buried electrode is disposed instead of the buried electrode 161.

A buried electrode 166 in the drawing is a buried electrode connected to the well region of the first semiconductor substrate 120. The buried electrode 166 is a buried electrode formed in a band shape and disposed along a side of the rectangular pixel 541 or the like in plan view. In addition, the drawing depicts an example in which the buried electrode 166 has a shape expanded in the lateral direction of the drawing. Note that the buried electrode 166 is connected to the well region via the semiconductor region 123. The semiconductor region 123 in the drawing is formed in a band shape along the buried electrode 166. By disposing such a band-shaped buried electrode 166, it is possible to increase the contact area between the buried electrode 166 and the well region of a semiconductor substrate 110, leading to reduction of the connection resistance.

### [Another configuration of buried electrode]

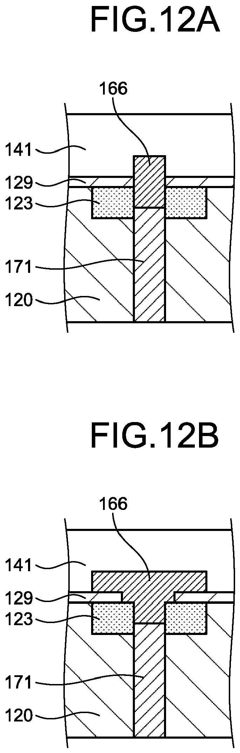

FIGS. 12A and 12B are diagrams depicting another configuration example of a buried electrode according to the first embodiment of the present disclosure. FIG. 12A is a cross-sectional view depicting a configuration example of the buried electrode 166, being a cross-sectional view taken along line d-d' in FIG. 11. The drawing is an example in which the buried electrode 166 is formed to have substantially the same width as the isolating section 171.

FIG. 12B is a diagram depicting an example of the buried electrode 166 formed to have a width greater than the width of the isolating section 171. The buried electrode 166 in the drawing is formed in a cross section having a width greater than the width of the isolating section 171 on the surface of the semiconductor substrate 110. In addition, the drawing depicts an example in which the buried electrode 166 is formed to have a width greater than the opening width of the insulating film 129.

Note that the method of manufacturing the imaging element is not limited to the method depicted in FIGS. 10A to 10I. For example, after the formation of the insulating film 129 in FIG. 10I, a groove-shaped opening may be formed in the insulating film 129 adjacent to the isolating section 171, and a polycrystalline silicon film may be further disposed adjacent to the buried electrode 161 in FIG. 10I. In addition, it is also possible to form the buried electrode 166 by a process in which, after FIG. 10D, the resist 601 is removed to form the insulating film 129, the insulating film 129 inside of the groove 179 and on the upper surface of the shoulder is removed by pattern etching, a polycrystalline silicon film is then formed, and pattern etching is performed. By applying these manufacturing methods, it is possible to form a buried electrode whose upper width is greater than the width of the isolating section 171, such as the buried electrode 166 described in FIG. 12B.

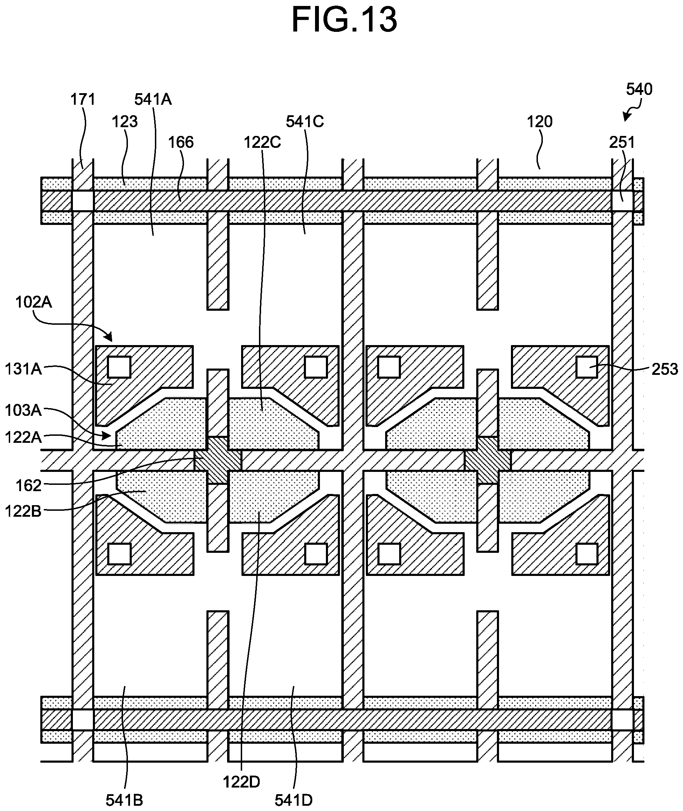

FIG. 13 is a diagram depicting another configuration example of the pixel sharing unit according to the first embodiment of the present disclosure. The drawing is a plan view depicting a configuration example of the pixel sharing unit 539 in which the band-shaped buried electrodes 166 are disposed, similarly to FIG. 11. The pixel sharing unit 539 in the drawing is different from the pixel sharing unit 539 in FIG. 11 in that pixels 541 having a rectangular shape, and the like, are disposed.

Note that, in the pixel array section 540 in the drawing, the pixels 541A and 541C constitute phase difference pixels. The phase difference pixel can generate a phase difference signal for detecting an image plane phase difference by applying pupil-division on incident light from a subject and an image signal based on the incident light from the subject. When the phase difference signal is generated, two image signals based on charges generated by photoelectric conversion of the photoelectric conversion sections of the pixels 541A and 541C are output as the phase difference signals. On the other hand, when the image signal is generated, the charges generated by the photoelectric conversion of the two photoelectric conversion sections are added up in the pixel, and the image signal generated based on the added charges is output. In the pixels 541B and 541D, phase difference pixels are constituted similarly to the pixels 541A and 541C.

Note that a gap is formed in the isolating section 171 between the pixels 541A and 541C and the pixels 541B and 541D. An overflow path is formed in a portion of the gap.

Note that a common on-chip lens 401 for pupil division is disposed in the pixels 541A and 541C constituting the phase difference pixels. Similarly, the common on-chip lens 401 is also disposed in the pixels 541B and 541D.

Note that the pixels 541A and 541C and the pixels 541B and 541D described above can also be used as normal pixels that do not generate phase difference signals. Further, the functions of the phase difference pixel and the normal pixel can also be provided for each region of the pixel array section 540. Specifically, a part of the pixel 541A and the like in the pixel array section 540 can be caused to function as a phase difference pixel, and the other pixels 541A and the like can be caused to function as normal pixels. Further, in the imaging device 1, a part or all of the pixel 541A and the like can be caused to function as a phase difference pixel in a case of detecting an image plane phase difference, and the pixel 541A and the like can be caused to function as a normal pixel in other cases.

The drawing depicts an example in which the regions of the semiconductor regions 122A to 122D constituting the FD of the pixel 541A -541D are formed to have a shape longer in the lateral direction of the drawing compared with the semiconductor regions 122A to 122D of FIG. 8. Note that the shapes of the semiconductor regions 122A to 122D are not limited to this example. For example, it is also possible to form a shape elongated in the vertical direction in the drawing or a symmetrical shape similar to that in FIG. 8.

In this manner, in the imaging device 1 according to the first embodiment of the present disclosure, the buried electrode 161 is disposed at the boundary of the pixel 541. The reference potential is supplied to the first semiconductor substrate 120 via the buried electrode 161. With this configuration, the region related to the supply of the reference potential can be disposed outside the pixel 541, making it possible to downsize the pixel 541.

### (2. Second embodiment)

In the imaging device 1 of the first embodiment described above, the buried electrode 161 is disposed in the isolating section 171 of the first semiconductor substrate 120. In contrast, an imaging device 1 according to a second embodiment of the present disclosure is different from the above-described first embodiment in that the buried electrodes 161 are connected to each other.

### [Configuration of pixel sharing unit]

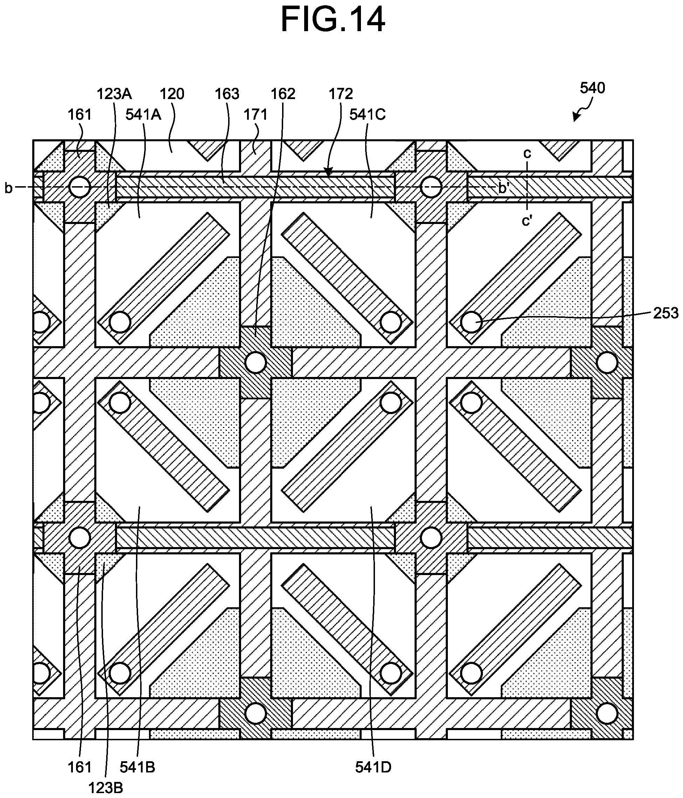

FIG. 14 is a diagram depicting a configuration example of a pixel sharing unit according to the second embodiment of the present disclosure. The drawing is a plan view depicting a configuration example of the pixel sharing unit 539, similarly to FIG. 8. The pixel sharing unit 539 in the drawing is different from the pixel sharing unit 539 in FIG. 8 in including a boundary wiring line 163 that connects the buried electrodes 161 to each other.

The boundary wiring line 163 is a wiring line connected to the buried electrode 161 disposed at the boundary of the pixel 541. The boundary wiring line 163 in the drawing is an exemplary configuration having a shape buried in the first semiconductor substrate 120. Specifically, the boundary wiring line 163 in the drawing is formed to be buried in the isolating section 171. The boundary wiring line 163 can be formed of polycrystalline silicon implanted with impurities, for example. The reference potential (well potential) can be made common in the adjacent buried electrodes 161 by disposing the boundary wiring line 163 and connecting the buried electrodes 161. This makes it possible to reduce the potential difference of the well potential between the different pixels 541. In addition, by disposing the boundary wiring line 163 and making the well potential of the pixels 541 common, it is possible to reduce the through-substrate electrodes 251. Note that the drawing depicts an example in which the boundary wiring line 163 is disposed between the buried electrodes 161 adjacent to each other in one direction (the lateral direction in the drawing).

Note that the boundary wiring line 163 may be disposed between the buried electrodes 162 to connect the buried electrodes 161 to each other. In this case, the adjacent charge holding sections 103 are connected to each other by the boundary wiring line 163.

### [Configuration of boundary wiring line]

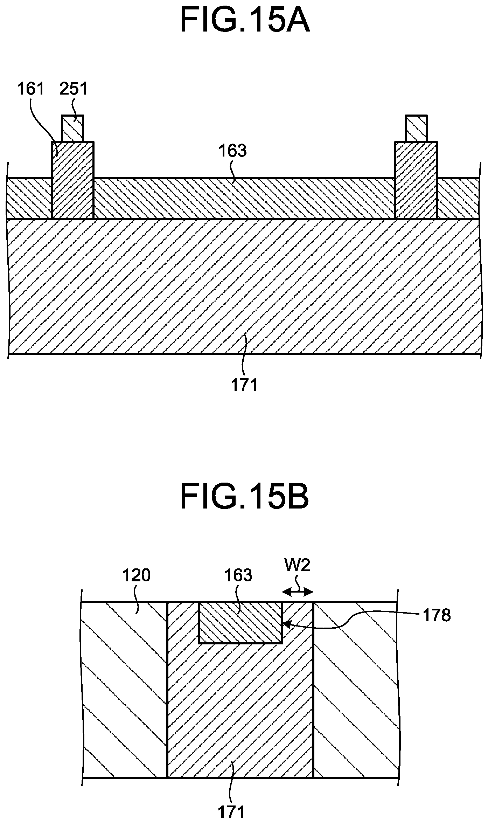

FIGS. 15A and 15B are diagrams depicting another configuration example of the boundary wiring line according to the second embodiment of the present disclosure. FIGS. 15A and 15B depict configuration examples of a cross section of the boundary wiring line 163 along line b-b' and line c-c' in FIG. 14, respectively. The boundary wiring line 163 in the drawing is connected to the side surface of the buried electrode 161 (FIG. 15A). In addition, the boundary wiring line 163 in the drawing has a shape in which the upper surface thereof is exposed to the front surface side of the first semiconductor substrate 120 (FIG. 15B). As depicted in FIG. 15B, the boundary wiring line 163 in the drawing can be formed to have a shape separated from the region of the first semiconductor substrate 120. The width ("W2" in the drawing) of the isolating section 171 between the boundary wiring line 163 and the first semiconductor substrate 120 can be 20 nm or more. The through-substrate electrode 251 can also be disposed above the boundary wiring line 163. This is because the boundary wiring line 163 is electrically connected to the buried electrode 161.

### [Method of manufacturing boundary wiring line]

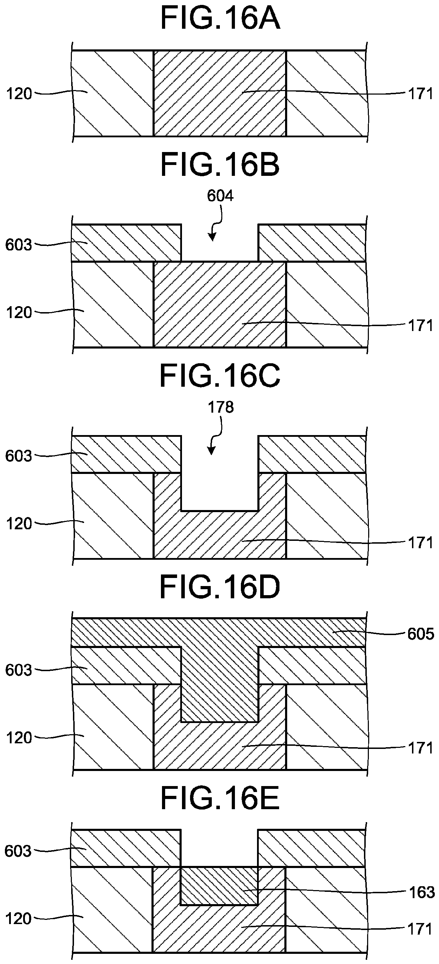

FIGS. 16A to 16E are diagrams depicting an example of a method of manufacturing the boundary wiring line according to the second embodiment of the present disclosure. FIGS. 16A to 16E are diagrams depicting an example of a manufacturing step of the boundary wiring line 163.

First, the isolating section 171 is formed in the first semiconductor substrate 120 (FIG. 16A). Next, a resist 603 is disposed on the front surface side of the first semiconductor substrate 120. In the resist 603, an opening 604 is located in a portion where the boundary wiring line 163 is disposed (FIG. 16B). Next, the isolating section 171 is etched using the resist 603 as a mask to form an opening 178 (FIG. 16C). This process can be performed by anisotropic dry etching, for example. Next, a material film 605 of the boundary wiring line 163 is disposed on the front surface side of the first semiconductor substrate 120 including the opening 178 (FIG. 16D). This process can be performed by forming a polycrystalline silicon film by CVD, for example. Next, the material film 605 is etched to remove the material film 605 in a portion other than the opening 178 (FIG. 16E). With this configuration, the boundary wiring line 163 can be formed. Thereafter, the resist 603 is removed.

### [Another configuration of boundary wiring line]

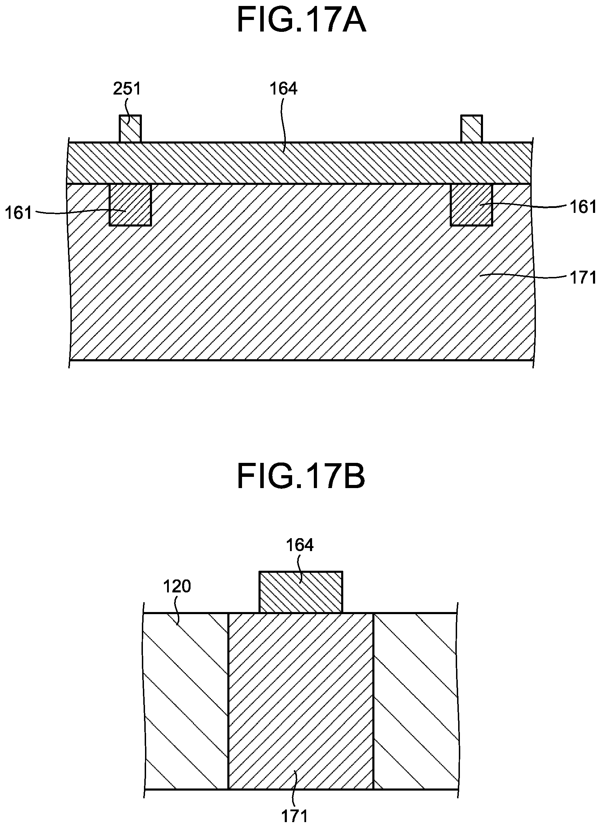

FIGS. 17A and 17B are diagrams depicting another configuration example of the boundary wiring line according to the second embodiment of the present disclosure. FIGS. 17A and 17B are diagrams depicting a configuration example of a boundary wiring line 164. The boundary wiring line 164 is a wiring line disposed adjacent to the front surface of the first semiconductor substrate 120. FIG. 17A depicts a configuration example of a cross section of the boundary wiring line 164 in a direction along the boundary of the pixel 541. FIG. 17B depicts a configuration example of a cross section of the boundary wiring line 164 in a direction perpendicular to the boundary of the pixel 541. The boundary wiring line 164 in the drawing is connected to the upper surface of the buried electrode 161 (FIG. 17A). In addition, the boundary wiring line 163 in the drawing has a shape in which the upper and side surfaces thereof are exposed to the front surface side of the first semiconductor substrate 120 (FIG. 17B). Similarly to the boundary wiring line 163, the boundary wiring line 164 in FIG. 17B can also be formed to have a shape separated from the region of the first semiconductor substrate 120. The distance between the boundary wiring line 164 and the first semiconductor substrate 120 can be 20 nm or more. Note that the through-substrate electrode 251 can be disposed on the boundary wiring line 163 instead of the buried electrode 161.

### [Another method of manufacturing boundary wiring line]

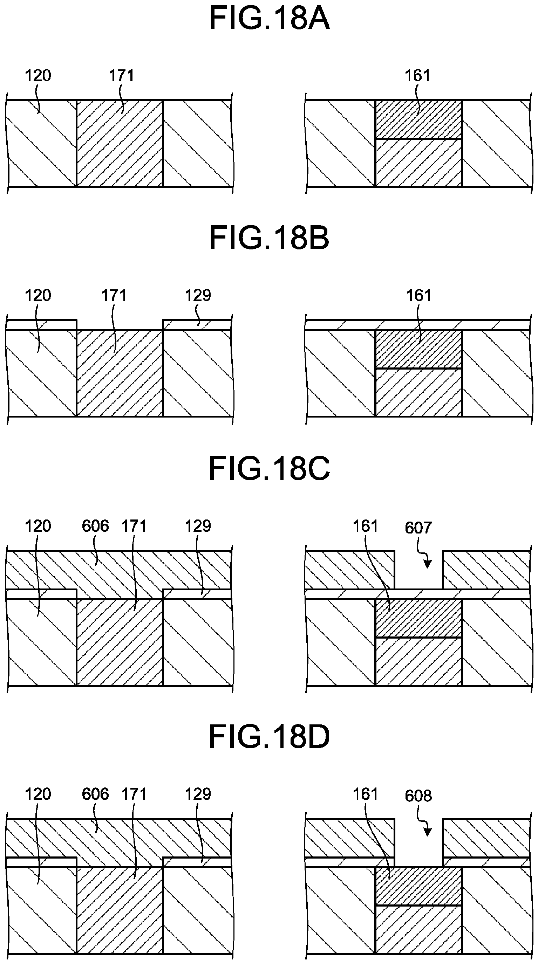

FIGS. 18A to 18G are diagrams depicting an example of another method of manufacturing the boundary wiring line according to the second embodiment of the present disclosure. FIGS. 18A to 18G are diagrams depicting an example of a manufacturing step of the boundary wiring line 164. In each of FIGS. 18A to 18G, the left diagram depicts a portion where the buried electrode 161 is not disposed, while the right diagram depicts a portion where the buried electrode 161 is disposed.

First, the isolating section 171 is formed in the first semiconductor substrate 120, and the buried electrode 161 is disposed here (FIG. 18A). Next, the insulating film 129 is disposed on the front surface side of the first semiconductor substrate 120 (FIG. 18B). This process can be performed by thermal oxidation, for example. Next, a resist 606 is disposed on the front surface side of the first semiconductor substrate 120. In the resist 606, an opening 607 is located in a portion where the boundary wiring line 164 is disposed (FIG. 18C). Next, the insulating film 129 is etched using the resist 606 as a mask to form an opening 608 in a region adjacent to the buried electrode 161 (FIG. 18D). This process can be performed by dry etching, for example.

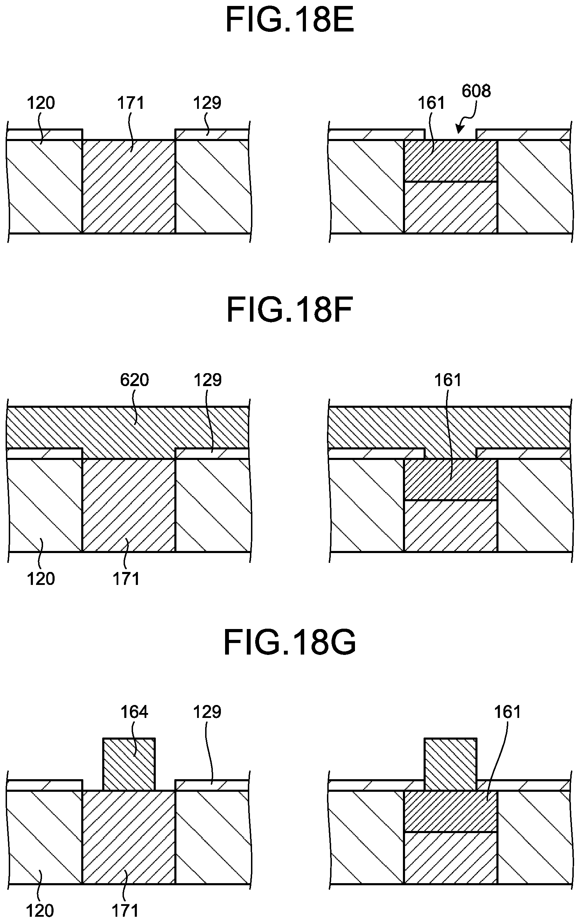

Next, the resist 606 is removed (FIG. 18E). Next, a material film 620 to be the boundary wiring line 164 is disposed on the front surface side of the first semiconductor substrate 120 including the opening 608 (FIG. 18F). This process can be performed by forming a polycrystalline silicon film by CVD, for example. Next, the material film 620 is etched to remove the material film 620 other than the boundary of the pixel 541 (FIG. 18G). With this configuration, the boundary wiring line 164 can be formed.

### [Anther configuration of pixel sharing unit]

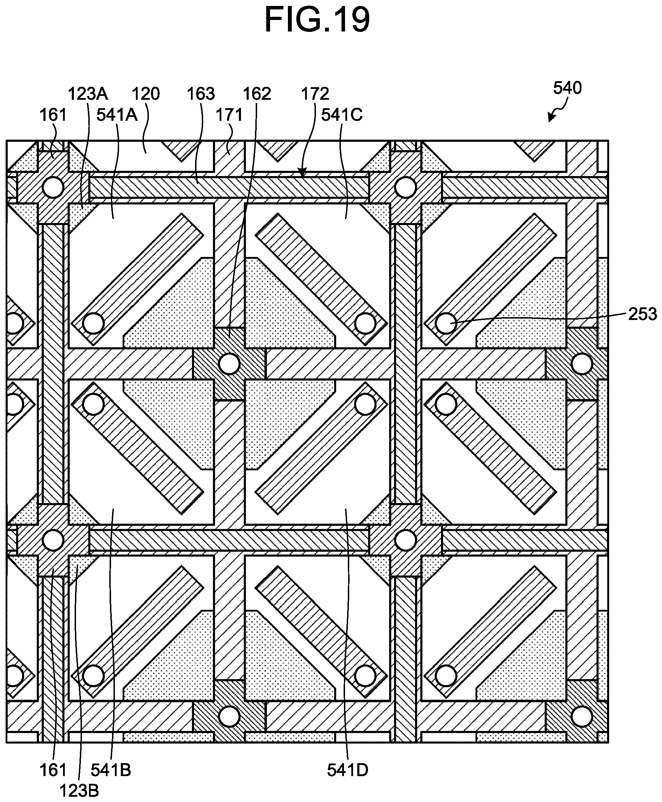

FIG. 19 is a diagram depicting another configuration example of the pixel sharing unit according to the second embodiment of the present disclosure. The drawing is a plan view depicting a configuration example of the pixel sharing unit 539, similarly to FIG. 14. The pixel sharing unit 539 in the drawing is different from the pixel sharing unit 539 in FIG. 14 in that the boundary wiring lines 163 are disposed in a mesh shape.

The boundary wiring line 163 in the drawing connects the buried electrodes 161 in the vertical direction and the lateral direction in the drawing. This configuration makes it possible to further reduce the resistance of the wiring line for supplying the well potential in the first semiconductor substrate 120, leading to reduction of the potential difference of the well potential between the different pixels 541.

The configuration of the imaging device 1 other than this is similar to the configuration of the imaging device 1 in the first embodiment of the present disclosure, and thus the description thereof will be omitted.

In this manner, the imaging device 1 according to the second embodiment of the present disclosure connects the adjacent buried electrodes 161 to each other by the boundary wiring line 163 or the like. This makes it possible to reduce the potential difference of the well potential between the different pixels 541.

### (3. Third embodiment)

In the imaging device 1 of the first embodiment described above, the through-substrate electrode 251 is disposed for each pixel group 538. In contrast, a third embodiment of the present disclosure will give an example in which the boundary wiring line 163 and the like are disposed to reduce the through-substrate electrodes 251.

### [Configuration of pixel array section]

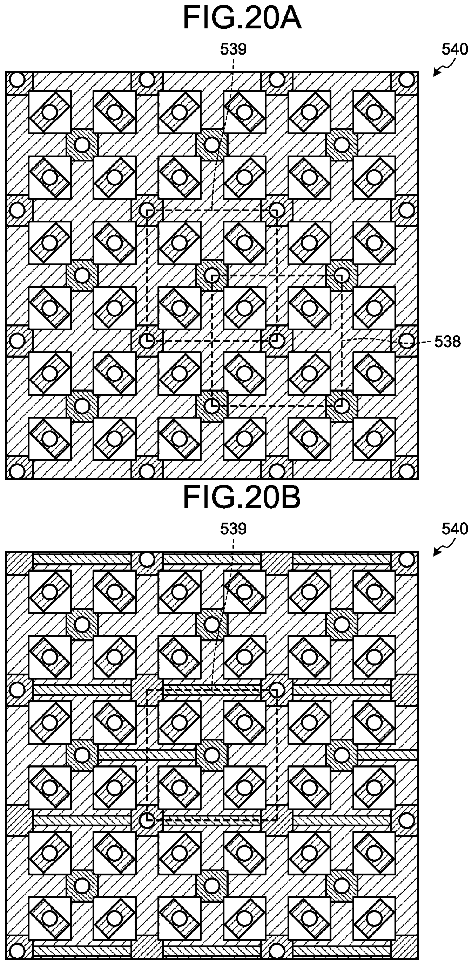

FIGS. 20A to 20C are diagrams depicting a configuration example of a pixel array section according to the third embodiment of the present disclosure. FIGS. 20A to 20C are diagrams depicting a configuration example of the pixel array section 540. Note that FIGS. 20A to 20C omit description of reference numerals.

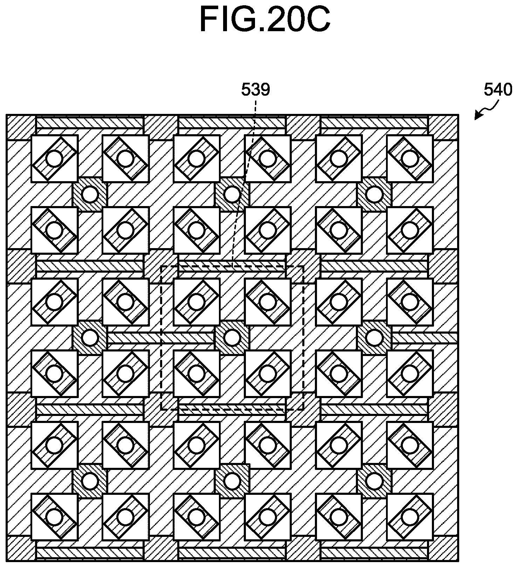

FIG. 20A is a diagram depicting an example in which the through-substrate electrodes 251 and 252 are disposed on all the buried electrodes 161 and 162, similarly to FIG. 8. FIG. 20B is a diagram depicting an example of a case where the boundary wiring line 163 is disposed between the buried electrodes 161 adjacent to each other in the lateral direction in the drawing and the through-substrate electrodes 251 are alternately disposed with respect to the adjacent buried electrodes 161. FIG. 20C is a diagram depicting an example of a case where the boundary wiring line 163 is disposed and the through-substrate electrode 251 is omitted.

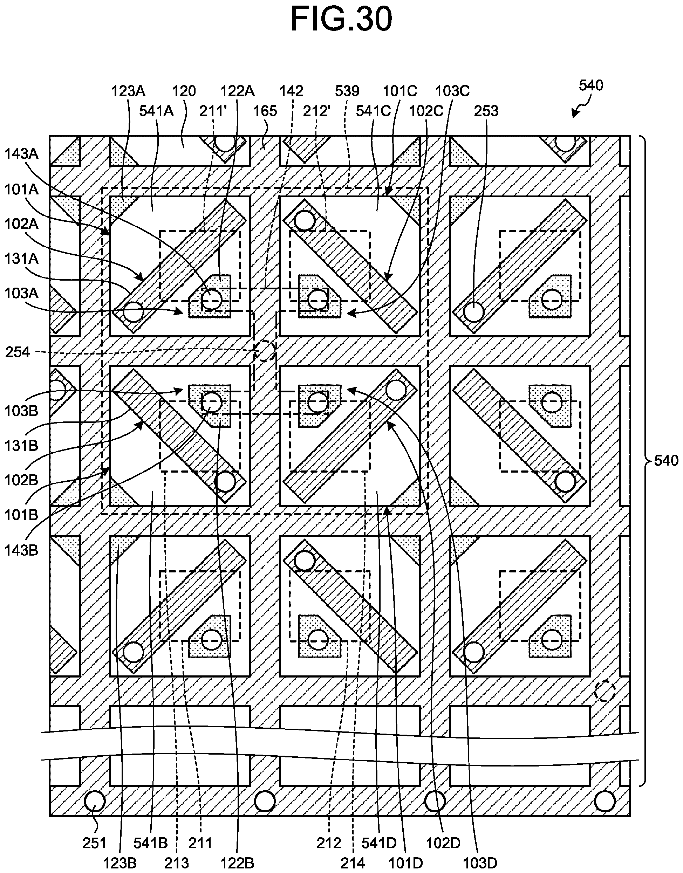

In the pixel array section 540 of FIG. 20C, as will be described below with reference to FIG. 30, the through-substrate electrode 251 that supplies the reference potential is disposed outside the pixel array section 540. The through-substrate electrode 251 disposed outside the pixel array section 540 can be connected to a well region extended to a region outside the pixel array section 540, for example. In addition, the through-substrate electrode 251 can be connected to the buried electrode 161 of the pixel array section 540 and can also be connected to the boundary wiring line 163 extending to a region outside the pixel array section 540. In this manner, in a case where the through-substrate electrode 251 is not disposed in the pixel array section 540, the reference potential (well potential) can be supplied to the pixel 541.

FIG. 21 is a diagram depicting a configuration example of the pixel array section according to the third embodiment of the present disclosure. The drawing is a diagram depicting an example of a case where electrodes 661 and 662 adjacent to the front-side surface of the first semiconductor substrate 120 are used instead of the buried electrodes 161 and 162. The drawing depicts a Comparative Example of the embodiment of the present disclosure. The electrodes 661 and 662 are formed in a shape not buried in the first semiconductor substrate 120, and are bonded to a semiconductor region on the front surface of the first semiconductor substrate 120. In order to reduce the connection resistance with the semiconductor region, the electrodes 661 and 662 need to be formed to have a larger area than the buried electrodes 161 and 162.

In each of the cases of FIGS. 20A to 20C and 21, the number of connecting locations such as the through-substrate electrodes 251 and the like are compared.

### [Comparison result]

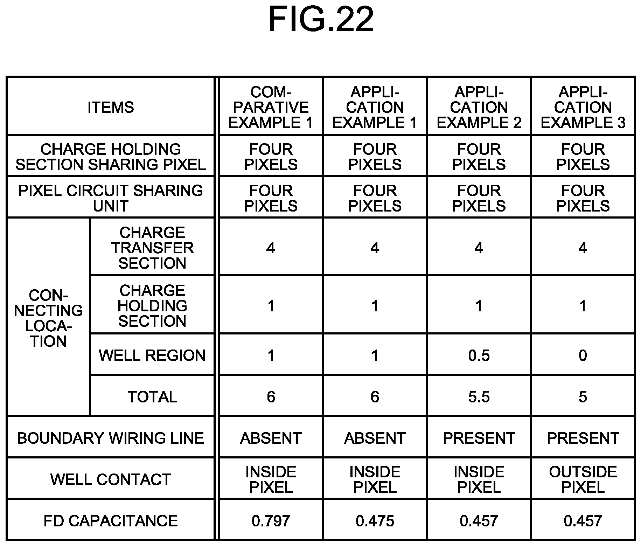

FIG. 22 is a diagram depicting a comparison result of the pixel array section according to the third embodiment of the present disclosure. In the drawing, Comparative Example 1, Application Example 1, Application Example 2, and Application Example 3 represent examples in the case of the pixel array section 540 of FIGS. 21, 20A, 20B, and 20C, respectively. In addition, the "charge holding section sharing pixel" in the drawing represents the number of pixels of the charge holding section 103 commonly connected by the buried electrode 162. The "pixel circuit sharing unit" represents the number of pixels per pixel circuit 210. The "connecting locations" in the drawing indicates the number of connecting locations connecting the first semiconductor substrate 120 and the second semiconductor substrate 220 to each other in the pixel array section 540. Specifically, it represents the number of through-substrate electrodes 251 to 253. In the drawing, "charge transfer section", "charge holding section", and "well region" indicate the number of connecting locations of the charge transfer section 102 (specifically, the gate electrode 131), the charge holding section 103, and the well region (the semiconductor region 123), respectively. "Total" in the drawing represents the total number of the charge transfer section 102, the charge holding section 103, and the connecting location of the well region.

The "boundary wiring line" in the drawing indicates the presence or absence of the boundary wiring line 163 and the like. "Well contact" in the drawing represents a position where the well contact is disposed. The FD capacitance in the drawing represents capacitance (parasitic capacitance) between the gate electrode 131 and the charge holding section 103.

In the four examples in the drawing, the number of pixels in "charge holding section sharing pixel" and "pixel circuit sharing unit" is four pixels for each, and the number of "connecting locations" in "charge transfer section" and "charge holding section" is four and one, respectively. This is because the pixel sharing unit 539 includes four pixels 541 and one pixel circuit 210 in each example.

In Comparative Example 1 and Application Example 1, the number of "connecting locations" in "well region" is 1. This is because the through-substrate electrode 251 is disposed for each buried electrode 161. In contrast, in Application Example 2, the number of "connecting locations" in "well region" is 0.5. This is because the through-substrate electrode 251 is shared by the two pixel groups 538. In addition, in Application Example 3, the number of "connecting locations" in "well region" is 0. The "Total" of "connecting locations" in Comparative Example 1, Application Example 1, Application Example 2, and Application Example 3 are 6, 6, 5.5, and 5, respectively. In "well contact", Application Example 3 is outside the pixel, and the rest is inside the pixel. As described above, in Application Example 3 in which the well contact (through-substrate electrode 251) is omitted, the well contact is disposed outside the pixel array section 540. Regarding the item of "FD capacity", Comparative Example 1 has a higher value than Application Examples 1 to 3. This is because of the short distance between the gate electrode 131 and the electrodes 661 and 662.

In this manner, the number of connecting locations can be reduced in the application example in which the boundary wiring lines 163 and 164 are disposed.

### (4. Fourth embodiment)

The above-described third embodiment has performed a comparison on an example of providing the pixel sharing unit 539 including four pixels 541. In contrast, a fourth embodiment of the present disclosure will describe an example of providing a pixel sharing unit 539 including eight pixels 541.

The pixel sharing unit 539 in the drawing includes two sets of four pixels 541 sharing the buried electrode 162. The pixel sharing unit 539 includes a total of 8 pixels 541.

### [Configuration of pixel array section]

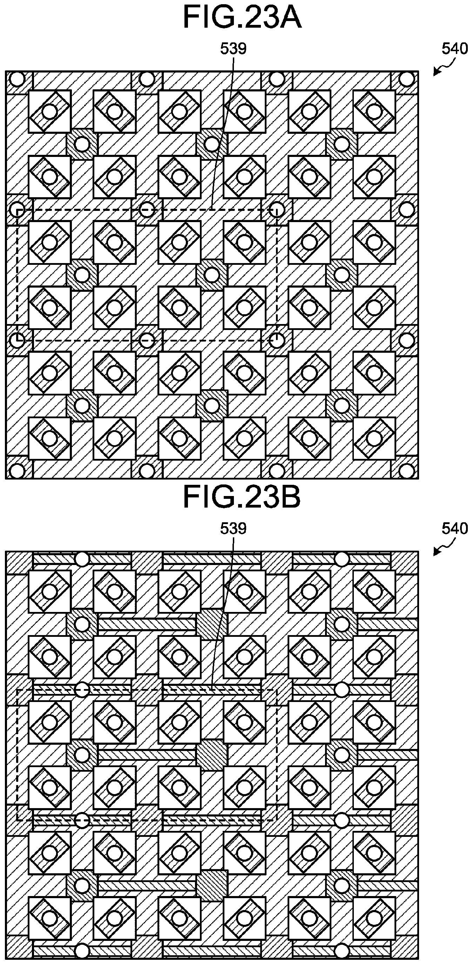

FIGS. 23A to 23C are diagrams depicting a configuration example of a pixel array section according to the fourth embodiment of the present disclosure. FIGS. 23A to 23C are diagrams depicting a configuration example of the pixel array section 540, similarly to FIGS. 20A to 20C. The pixel sharing unit 539 in FIGS. 23A to 23C is different from the pixel sharing unit 539 in FIGS. 20A to 20C in including eight pixels 541.

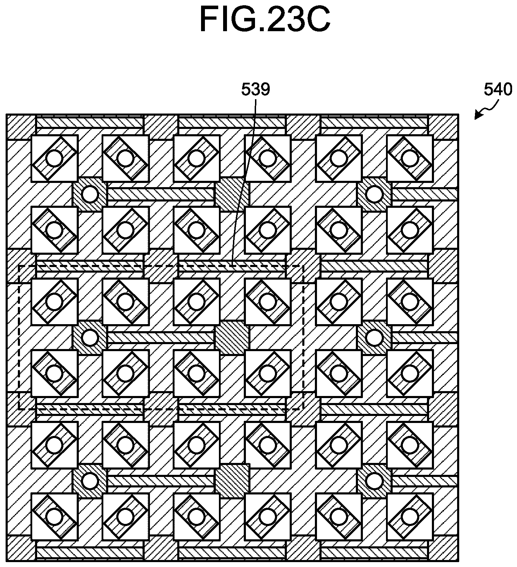

FIG. 23A is a diagram depicting an example in which the through-substrate electrodes 251 and the like are disposed on all the buried electrodes 161 and 162, similarly to FIG. 20A. A through-substrate electrode 252 is disposed on each of the two buried electrodes 162 of the pixel sharing unit 539. These through-substrate electrodes 252, commonly connected to the wiring line 242 of the second semiconductor substrate 220, are connected to the pixel circuit 210. FIG. 23B is a diagram depicting an example of a case where the boundary wiring line 163 is disposed between the buried electrodes 161 adjacent in the lateral direction in the drawing and the two buried electrodes 162 of the pixel sharing unit 539 are connected to each other by the boundary wiring line 163 and the like. FIG. 23B also depicts an example in which the through-substrate electrode 251 is connected to the boundary wiring line 163 and the like. FIG. 23C is a diagram depicting an example of a case where the through-substrate electrode 251 is further omitted from the example of FIG. 23B.

### [Comparison result]

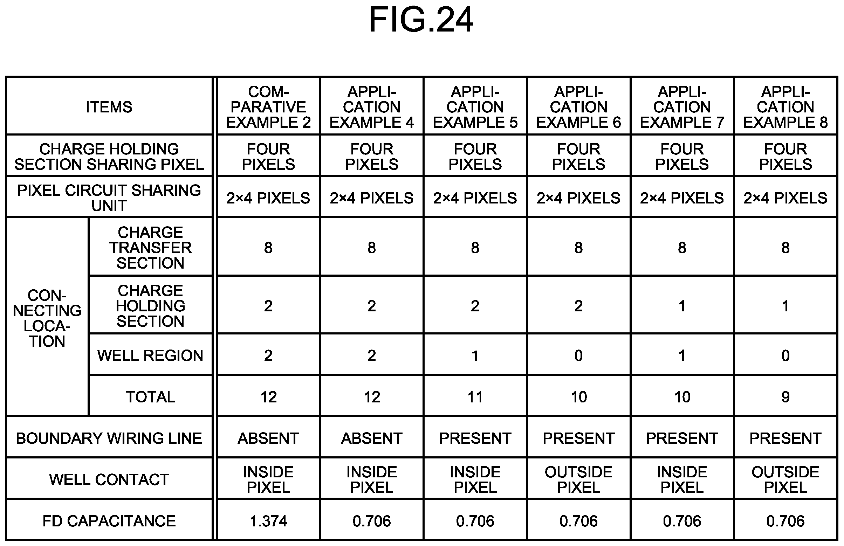

FIG. 24 is a diagram depicting a comparison result of the pixel array section according to the fourth embodiment of the present disclosure. In the drawing, Comparative Example 2 assumes an example in which the pixel sharing unit 539 includes eight pixels 541 in the pixel array section 540 including the pixels 541 in FIG. 21. Application Example 4 represents an example in the case of the pixel array section 540 in FIG. 23A. Application examples 5 and 6 assume an example in which the pixel sharing unit 539 includes eight pixels 541 in the pixel array section 540 of FIGS. 20B and 15C, respectively. Application examples 7 and 8 represent examples in the case of the pixel array section 540 in FIGS. 23B and 23C, respectively.

In the six examples of the drawing, the number of "charge holding section sharing pixel" and the "pixel circuit sharing unit" is four pixels and 2 × 4 pixels, respectively, and the number of "connecting locations" in "charge transfer section" is eight. This is because the pixel sharing unit 539 includes eight pixels 541 and one pixel circuit 210 in each example.

In Comparative Example 2 and Application Example 4, the number of "connecting locations" in "charge holding section" and "well region" is 2. This is because the through-substrate electrode 251 is disposed for each buried electrode 161, and the through-substrate electrode 252 is disposed for each buried electrode 162. In Comparative Example 2 and Application Example 4, the "Total" of the "connecting locations" is 12.

In Application Examples 5 and 6, the "charge holding section" of the "connecting location" is 2, similarly to Application Example 4. In contrast, in Application Example 5, the number of "connecting locations" in "well region" is 1. This is because the through-substrate electrode 251 is shared by the two pixel groups 538. In addition, in Application Example 6, the number of "connecting locations" in "well region" is 0. The "Total" of "connecting locations" in Application Example 5 and Application Example and 6 is 11 and 10, respectively.

In Application Examples 7 and 8, the number of "connecting locations" in "charge holding section" is 1. This is because the two buried electrodes 162 share the through-substrate electrode 252. In addition, in Application Example 7 and Application Example 8, the number of "connecting locations" in "well regions" is 1 and 0, respectively, similarly to Application Examples 5 and 6. The "Total" of "connecting locations" in Application Example 7 and Application Example and 8 is 10 and 9, respectively.

In Comparative Example 2 and Application Example 4, the "boundary wiring line" is "absent". In other cases, the "boundary wiring line" is "present". In addition, in Application Examples 6 and 8 in which the through-substrate electrode 251 is omitted, the "well contact" is "outside pixel". The "well contact" is "inside pixel" in other cases. In the item of "FD capacity", Comparative Example 1 has a higher value than Application Examples 4 to 8. This is because the distance between the gate electrode 131 and the electrodes 661 and 662 is short similarly to Comparative Example 1.

In this manner, the number of connecting locations can be further reduced in the application example in which the boundary wiring lines 163 and 164 are connected to the buried electrodes 161 and 162.

### (5. Fifth embodiment)

In the above-described fourth embodiment, the four pixels 541 share the buried electrode 162 connected to the charge holding section 103. In contrast, a fifth embodiment of the present disclosure will describe an example in which two pixels 541 share the buried electrode 162 connected to the charge holding section 103.

### [Configuration of pixel array section]

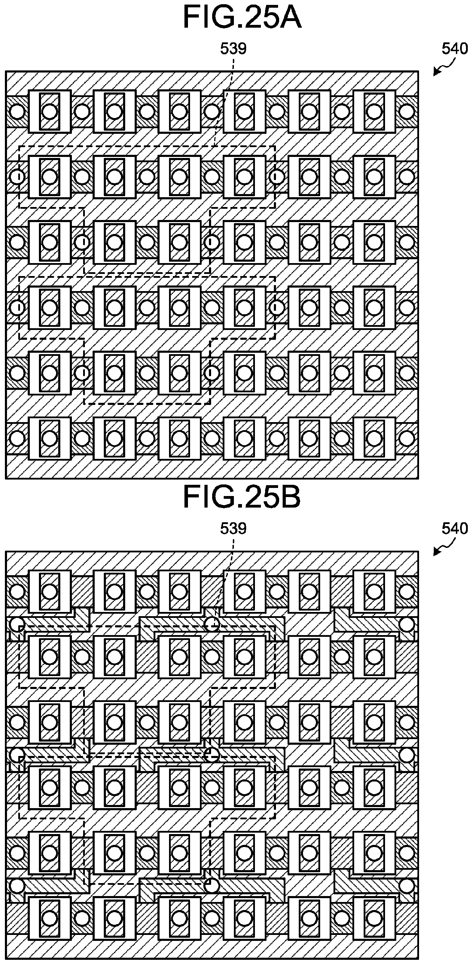

FIGS. 25A to 25E are diagrams depicting a configuration example of a pixel array section according to the fifth embodiment of the present disclosure. FIGS. 25A to 25E are diagrams depicting a configuration example of the pixel array section 540, similarly to FIGS. 23A to 23C. The pixel array section 540 of FIGS. 25A to 25E is different from the pixel array section 540 of FIGS. 23A to 23C in that the buried electrodes 161 and 162 are shared by the two pixels 541, and the pixel sharing unit 539 includes six pixels 541.

The pixel sharing unit 539 in the drawing includes three sets of two pixels 541 that share the buried electrode 162. The pixel sharing unit 539 includes a total of six pixels 541.

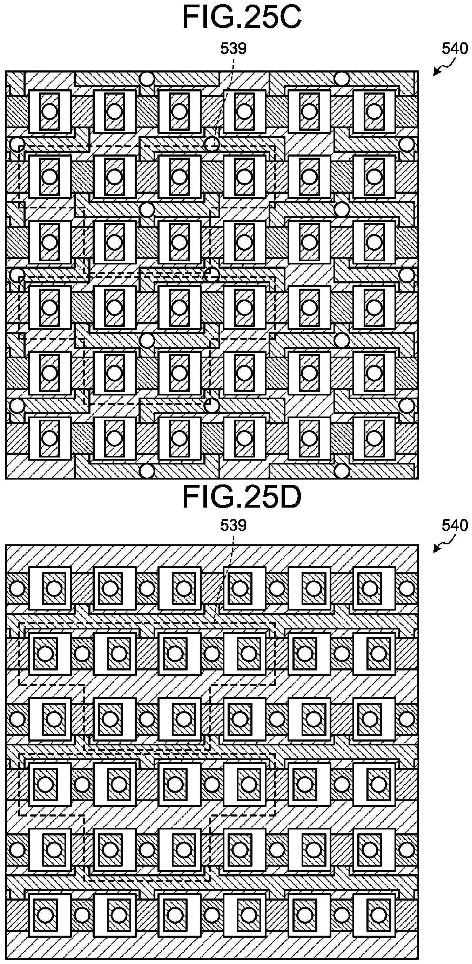

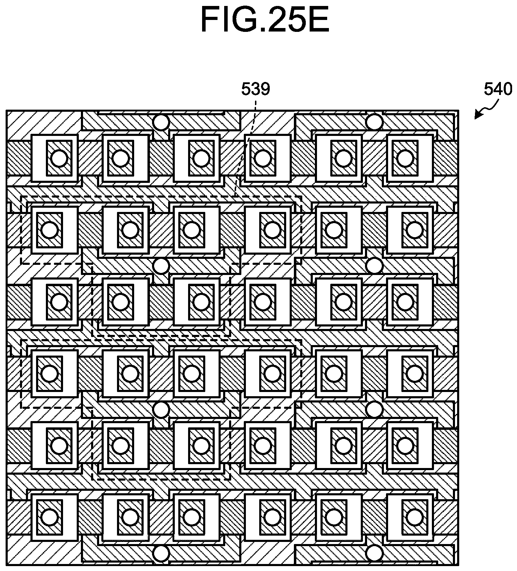

FIG. 25A is a diagram depicting an example in which the through-substrate electrodes 251 and the like are disposed on all the buried electrodes 161 and 162, similarly to FIG. 23A. The through-substrate electrodes 252 disposed on the three buried electrodes 162 of the pixel sharing unit 539 are commonly connected to the wiring line 242 of the second semiconductor substrate 220 and connected to the pixel circuit 210. FIG. 25B is a diagram depicting an example of a case where the three buried electrodes 161 are connected to each other by the boundary wiring line 163 and the like. FIG. 23B also depicts an example in which the through-substrate electrode 251 is connected to the boundary wiring line 163 and the like. FIG. 25C is a diagram depicting an example of a case in which the boundary wiring line 163 and the like that connects the three buried electrodes 162 to each other is further included, in contrast to the example of FIG. 25B. FIG. 25D is a diagram depicting an example of a case of further including the boundary wiring line 163 and the like that connect the buried electrodes 161 of the pixels 541 of the two columns in the lateral direction in the drawing to each other, in contrast to the example of FIG. 25A. FIG. 25E is a diagram depicting an example of a case of further including the boundary wiring line 163 and the like that connect the buried electrodes 161 of the pixels 541 of the two columns in the lateral direction in the drawing, in contrast to the example of FIG. 25B.

### [Comparison result]

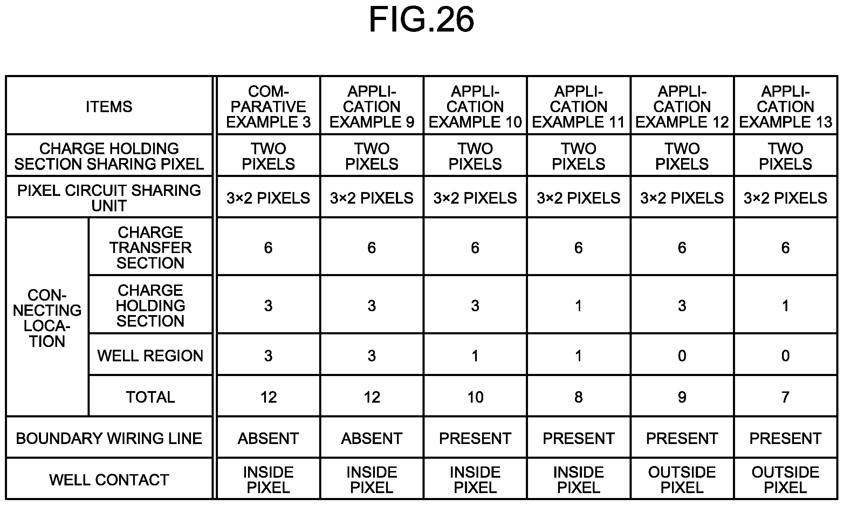

FIG. 26 is a diagram depicting a comparison result of the pixel array section according to the fifth embodiment of the present disclosure. In the drawing, Comparative Example 3 assumes an example in which the buried electrodes 161 and 162 are shared by two pixels 541 in the pixel array section 540 including the pixel 541 in FIG. 21, and the pixel sharing unit 539 includes six pixels 541. Application examples 9 to 13 depict examples in the case of the pixel array section 540 of FIGS. 25A to 20E, respectively.

In the six examples in the drawing, the number of "charge holding section sharing pixel" and the "pixel circuit sharing unit" is two pixels and 3 × 2 pixels, respectively, and the number of "connecting location" in "charge transfer section" is six. This is because the pixel sharing unit 539 includes six pixels 541 and one pixel circuit 210 in each example.

In Comparative Example 3 and Application Example 9, the number of "connecting locations" in "charge holding section" and "well region" is 3. This is because the through-substrate electrode 251 is disposed for every three buried electrodes 161, and the through-substrate electrode 252 is disposed for every three buried electrodes 162. In Comparative Example 2 and Application Example 4, the "Total" of the "connecting locations" is 12.

In Application Example 10, similarly to Application Example 9, the number of "connecting locations" in "charge holding section" is 2. In contrast, in Application Example 10, the number of "connecting locations" in "well region" is 1. This is because the through-substrate electrode 251 is shared by the three buried electrodes 161 connected to each other by the boundary wiring line 163 or the like. The "Total" of "connecting locations" in Application Example 10 is 10.

In Application Example 11, the number of "connecting locations" in "charge holding section" is 1. This is because the through-substrate electrode 252 is shared by the three buried electrodes 162 connected to each other by the boundary wiring line 163 or the like. In addition, similarly to Application Example 10, the "well region" of the "connecting location" is 1. The "Total" of "connecting locations" in Application Example 11 is 8.

In Application Example 12, similarly to Application Example 10, the "charge holding section" of the "connecting location" is 3. In addition, similarly to Application Example 5 in FIG. 24, the number of "connecting locations" in "well region" is 0. The "Total" of "connecting locations" in Application Example 12 is 9.

In Application Example 13, similarly to Application Example 11, the number of "connecting locations" in "charge holding section" is 1. In addition, similarly to Application Example 5 in FIG. 24, the number of "connecting locations" in "well region" is 0. The "Total" of "connecting locations" in Application Example 13 is 7.

In Comparative Example 3 and Application Example 9, the "boundary wiring line" is "absent". In other cases, the "boundary wiring line" is "present". In addition, in the application example 12 and the application example 13 in which the through-substrate electrode 251 is omitted, the "well contact" is "outside pixel". The "well contact" is "inside the pixel" in other cases. The item "FD capacity" is omitted.

In this manner, in the application example in which the two pixels 541 share the buried electrode 162 connected to the charge holding section 103 and the boundary wiring lines 163 and 164 are connected to the buried electrodes 161 and 162, it is possible to further reduce the number of connecting locations.

### (6. Sixth embodiment)

In the above-described fifth embodiment, a comparison is made for an example in which two pixels 541 share the buried electrode 162 connected to the charge holding section 103 and the pixel sharing unit 539 including six pixels 541 is included. In contrast, a sixth embodiment of the present disclosure will describe an example in which the number of pixels 541 of the pixel sharing unit 539 is further increased.

### [Configuration of pixel array section]

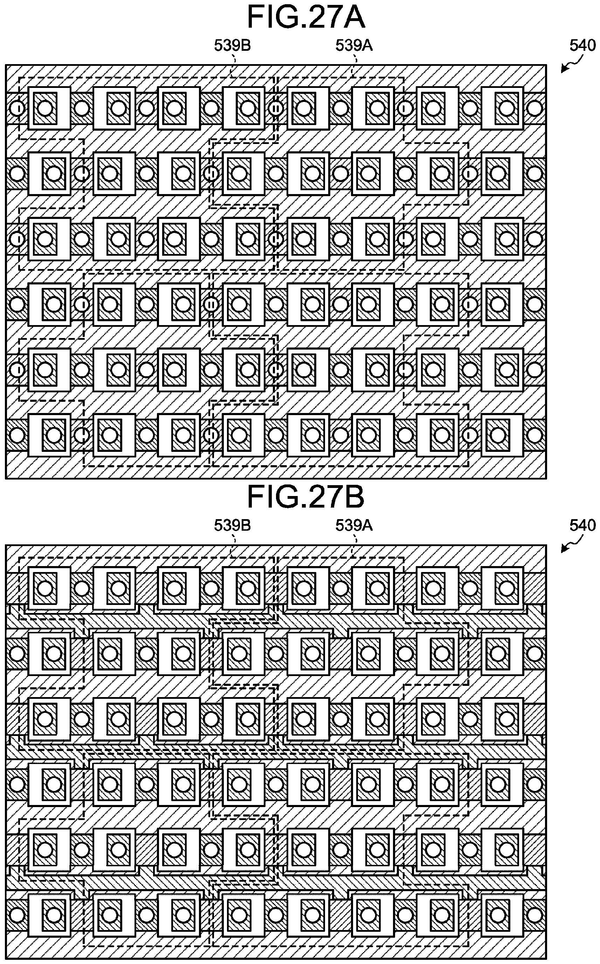

FIGS. 27A to 27F are diagrams depicting a configuration example of a pixel array section according to the sixth embodiment of the present disclosure. FIGS. 27A to 27F are diagrams depicting a configuration example of the pixel array section 540, similarly to FIGS. 25A to 25E. The pixel array section 540 of FIGS. 27A to 25F is different from the pixel array section 540 of FIGS. 25A to 25E in including pixel sharing units 539A and 539B.

The pixel sharing unit 539A includes four sets of two pixels 541 that share the buried electrode 162, and includes eight pixels 541. In addition, the pixel sharing unit 539B includes five sets of two pixels 541 that share the buried electrode 162, and includes ten pixels 541.

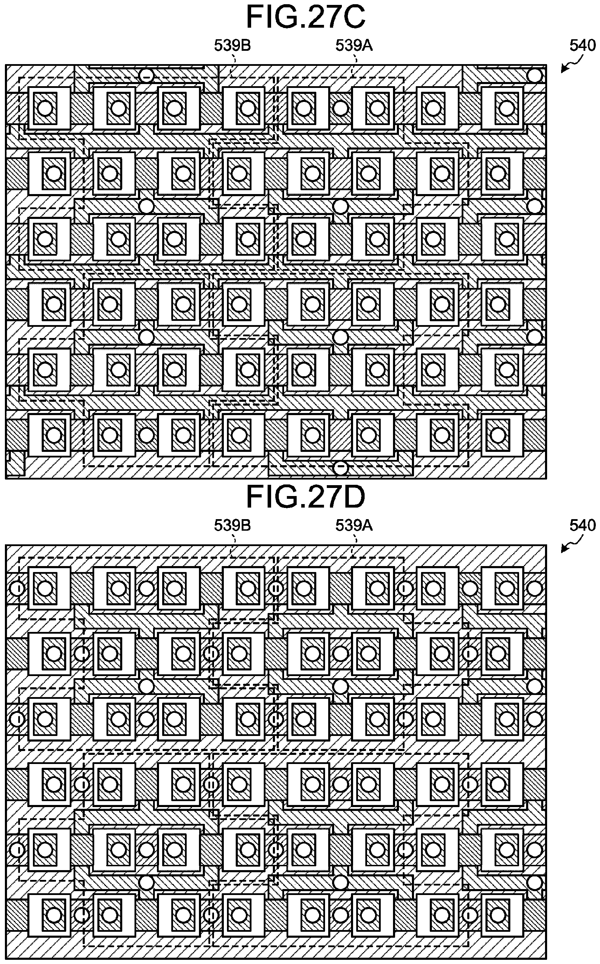

FIG. 27A is a diagram depicting an example in which the through-substrate electrodes 251 and the like are disposed on all the buried electrodes 161 and 162, similarly to FIG. 23A. The through-substrate electrodes 252 disposed in the plurality of buried electrodes 162 of the pixel sharing units 539A and 539B are commonly connected to the wiring line 242 of the second semiconductor substrate 220 and connected to the pixel circuit 210. FIG. 27B is a diagram depicting an example of a case of including a boundary wiring line 163 or the like that connects the buried electrodes 161 of the pixels 541 of two columns in the lateral direction in the drawing to each other. In this example, the through-substrate electrode 251 is omitted. FIG. 27C is a diagram depicting an example of a case in which the boundary wiring line 163 and the like that connects the three buried electrodes 162 to each other is further included, in contrast to the example of FIG. 27B. FIG. 27D is a diagram depicting an example in which the pixel sharing unit 539A includes the boundary wiring line 163 or the like that connects the four buried electrodes 162, and the pixel sharing unit 539B includes the boundary wiring line 163 or the like that connects the five buried electrodes 162.

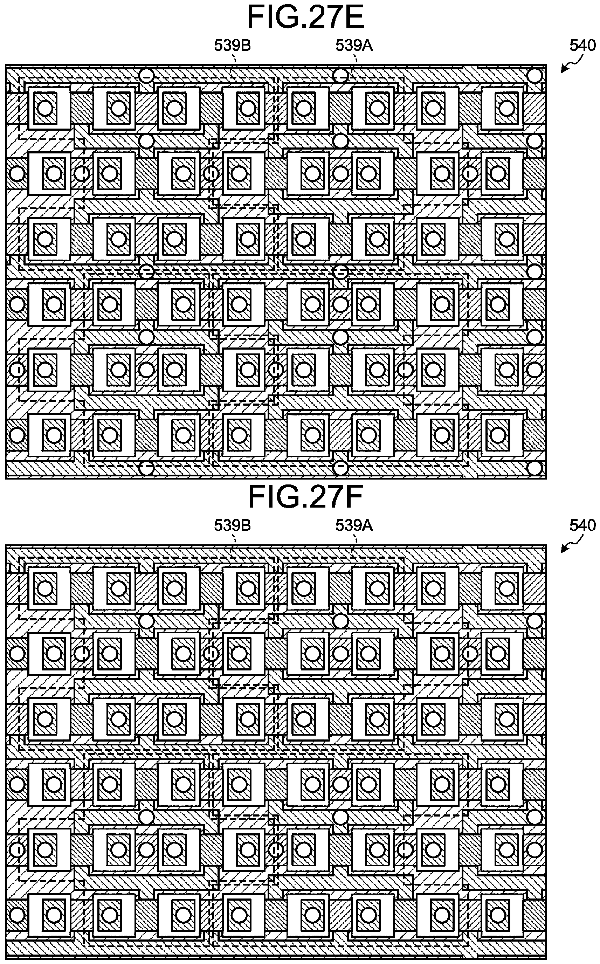

FIG. 27E is a diagram depicting an example of a case of further including the boundary wiring line 163 and the like that connect the buried electrodes 161 of the pixels 541 of the two columns in the lateral direction in FIG. 27B to each other, in contrast to the example of FIG. 27C. Note that the boundary wiring line 163 and the like that connect the buried electrodes 161 to each other are disposed at the upper end and the lower end of the pixel sharing units 539A and 539B in the drawing, and are connected to the adjacent buried electrodes 161. There is a need to connected the through-substrate electrode 251 to the buried electrode 161 in the central portion of the pixel sharing units 539A and 539B. In addition, unlike FIG. 27B, in FIG. 27E, the through-substrate electrode 251 is disposed on the boundary wiring line 163 and the like. FIG. 27F is a diagram depicting an example of a case where the through-substrate electrode 251 such as the boundary wiring line 163 is omitted from the example of FIG. 27E.

### [Comparison result]

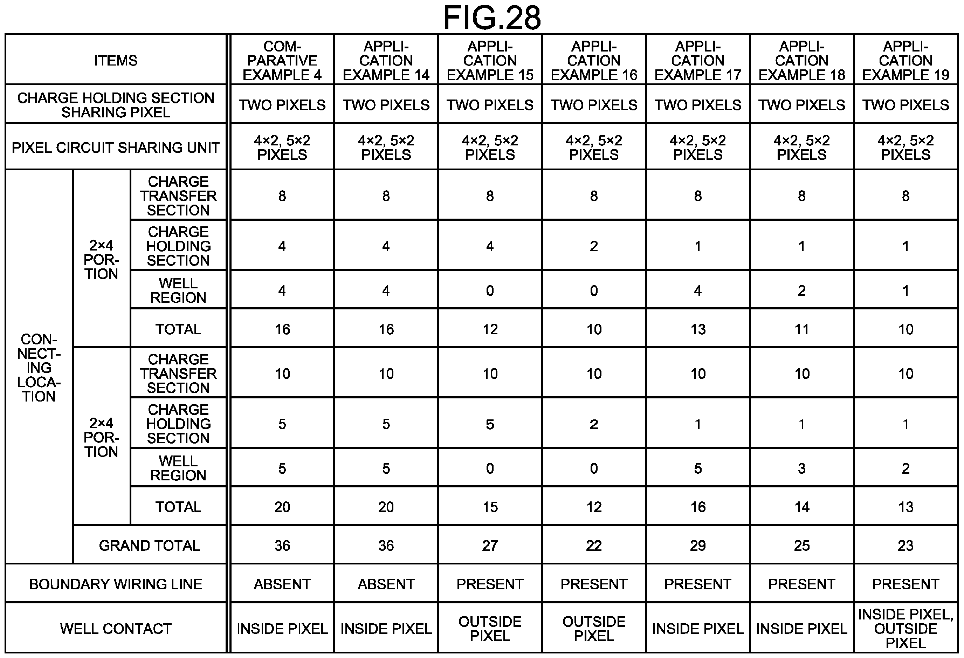

FIG. 28 is a diagram depicting a comparison result of the pixel array section according to the sixth embodiment of the present disclosure. In the drawing, Comparative Example 4 assumes a pixel array section 540 having pixel sharing units 539A and 539B including the pixel 541 of FIG. 21. Application Examples 14 to 19 depict examples in the case of the pixel array section 540 of FIGS. 27A to 27F, respectively. Note that the "4 × 2 portion" and the "5 × 2 portion" of the "connecting location" in the drawing correspond to the portions of the pixel sharing units 539A and 539B, respectively. In addition, the "Grand Total" of the "connecting location" is a sum of the number of the through-substrate electrodes 251 and the like in each of the "4 × 2 portion" and the "5 × 2 portion".

In the six examples of the drawing, the "charge holding section sharing pixels" are 2 pixels, and the "pixel circuit sharing units" are 4 × 2 pixels (pixel sharing unit 539A) and 5 × 2 pixels (pixel sharing unit 539B). In addition, in the seven examples in the drawing, the number of "connecting locations" in "charge transfer sections" for the "4 × 2 portion" and the "5 × 2 portion" is 8 and 10, respectively.

In Comparative Example 4 and Application Example 14, the number of "connecting locations" in "charge holding sections" for the "4 × 2 portion" and the "5 × 2 portion" is 8 and 10, respectively, while the number of "connecting locations" in "well regions" for the "4 × 2 portion" and the "5 × 2 portion" is 4 and 5, respectively. The total of the "4 × 2 portion" and the "5 × 2 portion" is 16 and 20, respectively. Therefore, the "Grand Total" in the "connecting location" is 36.

In Application Example 15, similarly to Application Example 14, the "4 × 2 portion" of the "connecting location" and the "charge holding section" of the "5 × 2 portion" are 4 and 5, respectively. On the other hand, in Application Example 15, similarly to Application Example 5 in FIG. 24, the "well region" of the "4 × 2 portion" and the "5 × 2 portion" of the "connecting location" is 0. "Grand Total" of "connecting location" of Application Example 5 is 27.

In Application Example 16, the "4 × 2 portion" of the "connecting location" and the "charge holding section" of the "5 × 2 portion" are 2. In addition, similarly to Application Example 15, the number of "connecting locations" in "well region" is 0. The "Grand Total" of "connecting locations" in Application Example 11 is 22.

In Application Example 17, the number of "connecting locations" in "charge holding section" is 1. This is because the plurality of through-substrate electrodes 252 of the pixel sharing units 539A and 539B are commonly connected by the boundary wiring line 163 or the like. In addition, similarly to Application Example 14, the number of "connecting locations" in "well regions" for the "4 × 2 portion" and the "5 × 2 portion" is 4 and 5, respectively. The "Grand Total" of "connecting locations" in Application Example 12 is 29.

In Application Example 18, similarly to Application Example 17, the number of "connecting locations" in "charge holding section" is 1. In addition, the number of "connecting locations" in "well regions" for the "4 × 2 portion" and the "5 × 2 portion" is 2 and 3, respectively. This is because the through-substrate electrode 251 is disposed on the buried electrode 161 unlike the application example 15 or 16. The "Grand Total" of "connecting locations" in Application Example 18 is 25.

In Application Example 19, similarly to Application Example 17, the number of "connecting locations" in "charge holding section" is 1. In addition, the number of "connecting locations" in "well regions" for the "4 × 2 portion" and the "5 × 2 portion" is 1 and 2, respectively. This is because, unlike the application example 15 or 16, the through-substrate electrode 251 is disposed on the buried electrode 161 in the central portion of the pixel sharing units 539A and 539B. The "Grand Total" of "connecting locations" in Application Example 19 is 23.

In Comparative Example 4 and Application Example 14, the "boundary wiring line" is "absent". In other cases, the "boundary wiring line" is "present". In addition, in the application example 15 and the application example 16 in which the through-substrate electrode 251 is omitted, the "well contact" is "outside pixel". Further, in Application Example 19, "well contact" is a combination of "inside the pixel" and "outside pixel". Otherwise, the "well contact" is the "inside pixel".

In this manner, in an application example in which the buried electrodes 162 of the pixel sharing units 539A and 539B are connected to each other by the boundary wiring line 163 or the like to share the through-substrate electrodes 251, it is possible to further reduce the number of connecting locations.

### (7. Seventh embodiment)

The imaging device 1 according to the first embodiment described above uses the isolating section 171 formed with an insulator. In contrast, an imaging device 1 according to a seventh embodiment of the present disclosure is different from the above-described first embodiment in using an isolating section 171 formed with another member.

### [Configuration of isolating section]

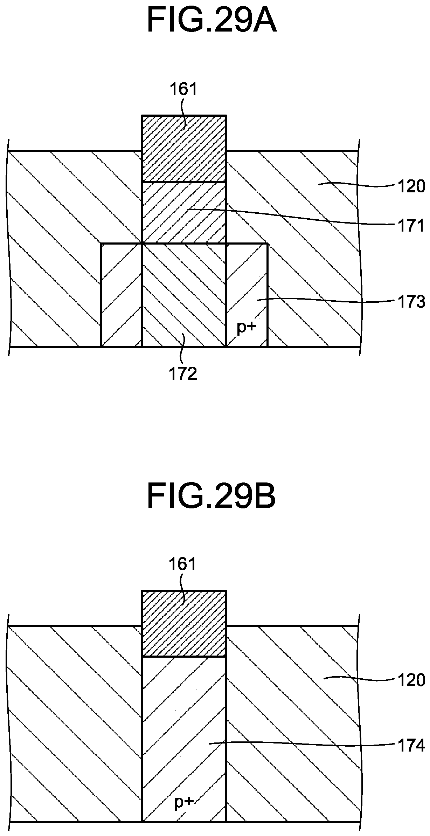

FIGS. 29A and 29B are diagrams depicting a configuration example of an isolating section according to the seventh embodiment of the present disclosure. FIGS. 29A and 29B are cross-sectional views depicting a configuration example of the isolating section.

An isolating section 171 in FIG. 29A is formed to have a relatively shallow depth from the front surface side of the first semiconductor substrate 120. There is provided a polycrystalline silicon layer 172 disposed below the isolating section 171. There is provided an isolating section 173 disposed adjacent to the polycrystalline silicon layer 172. The isolating section 173 is a semiconductor region having the same conductivity type as the well region and having a relatively high impurity concentration.

The polycrystalline silicon layer 172 is formed of polycrystalline silicon implanted with impurities. By applying heat treatment on the polycrystalline silicon layer 172 disposed in the groove 179 of the first semiconductor substrate 120, impurities of the polycrystalline silicon layer 172 are diffused into the surrounding first semiconductor substrate 120. With this configuration, the isolating section 173 including the semiconductor region having a relatively high impurity concentration can be formed adjacent to the polycrystalline silicon layer 172. Such an impurity diffusion method is referred to as a solid-phase diffusion method. The first semiconductor substrate 120 in the pixel 541 can be isolated by the isolating section 173.

An isolating section 174 in FIG. 29B is a semiconductor region having the same conductivity type as the well region and having a relatively high impurity concentration, similarly to the isolating section 173. The isolating section 174 can be formed by applying ion implantation on the first semiconductor substrate 120.

The configuration of the imaging device 1 other than this is similar to the configuration of the imaging device 1 in the first embodiment of the present disclosure, and thus the description thereof will be omitted.

In this manner, in the imaging device 1 according to the seventh embodiment of the present disclosure, the boundaries of the pixels 541 are isolated by the isolating sections 173 and 174 including the semiconductor regions.

### (8. Eighth embodiment)

In the imaging device 1 of the first embodiment described above, the buried electrodes 161 and 162 are disposed at the boundaries of the pixels 541, and the reference potential and the potential of the charge holding section are transmitted. In contrast, an imaging device 1 according to an eighth embodiment of the present disclosure is different from the above-described first embodiment in including a buried electrode having a shape surrounding a pixel 541 to transmit the reference potential alone.

### [Configuration of pixel sharing unit]

FIG. 30 is a diagram depicting a configuration example of a pixel sharing unit according to the eighth embodiment of the present disclosure. The drawing is a plan view depicting a configuration example of the pixel sharing unit 539, similarly to FIG. 8. The pixel sharing unit 539 in the drawing is different from the pixel sharing unit 539 in FIG. 8 in that a buried electrode 165 is provided instead of the buried electrodes 161 and 162, and the charge holding section 103 is disposed separated from the boundary of the pixel 541.

The buried electrode 165 is a buried electrode disposed at a boundary of the pixel 541 so as to be formed in a shape surrounding the pixel 541. The buried electrode 165 transmits a reference potential (well potential) similarly to the buried electrode 161. The semiconductor region 123 is disposed on the first semiconductor substrate 120 adjacent to the buried electrode 165. As described above, the semiconductor region 123 is a semiconductor region having a relatively high impurity concentration disposed in the well region of the first semiconductor substrate 120. By interposing the semiconductor region 123, it is possible to achieve a lower resistance in the connection between the buried electrode 165 and the well region. The semiconductor region 123 can be formed in a shape adjacent to a part of the buried electrode 165, as depicted in the drawing. The semiconductor region 123 can also be formed in an annular shape along the inside of the buried electrode 165 in plan view.

As depicted in the drawing, the through-substrate electrode 251 that supplies the reference potential (well potential) is connected to the portion of the buried electrode 165 extended to the outside of the pixel array section 540. With this configuration, a common well potential is supplied to the well region of each pixel 541, enabling omission of the through-substrate electrode 251 for each pixel 541.

In addition, as depicted in the drawing, by forming the buried electrode 165 in a mesh shape, it is possible to achieve a lower resistance in a region of the buried electrode 165 serving as a transmission path of the reference potential. This makes it possible to reduce the potential difference of the well potential between the different pixels 541.

As depicted in the drawing, the semiconductor region 122 constituting the charge holding section 103 is disposed at a position separated from the boundary of the pixel 541. This is to separate the region from the buried electrode 165 at the boundary of the pixel 541. In the pixel 541 in the drawing, an electrode 143 is connected to the semiconductor region 122 constituting the charge holding section 103. The electrodes 143 are disposed in the charge holding sections 103 of all the pixels 541 of the pixel sharing unit 539. The plurality of electrodes 143 of the pixel sharing unit 539 are connected to a charge holding section wiring line 142 in the drawing. The charge holding section wiring line 142 is a wiring disposed between the first semiconductor substrate 120 and the second semiconductor substrate 220. A through-substrate electrode 254 is further connected to the charge holding section wiring line 142. The through-substrate electrode 254 is an electrode having a shape penetrating the second semiconductor substrate 220. The through-substrate electrode 254 is connected to the pixel circuit 210.

### [Configuration of pixel]

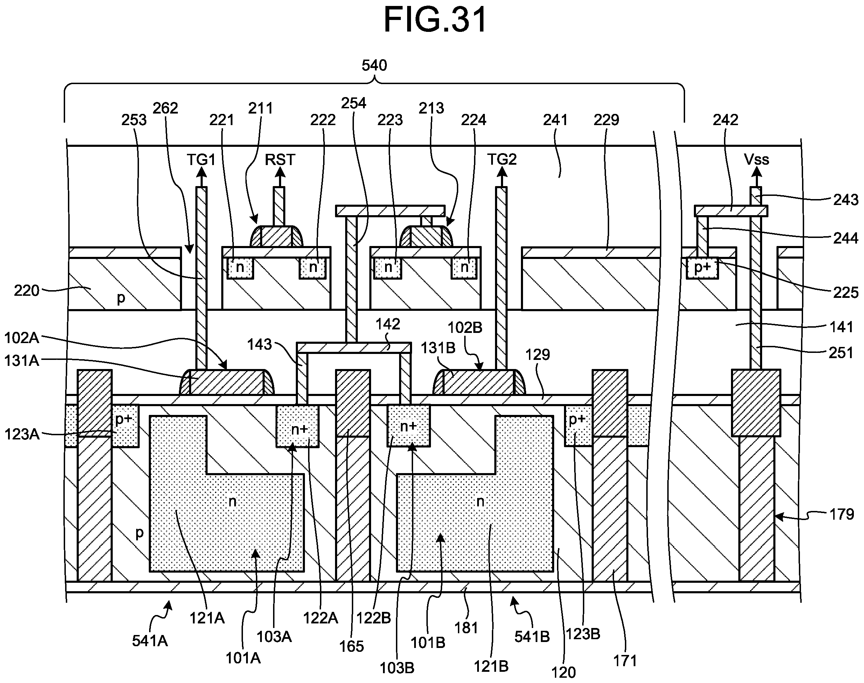

FIG. 31 is a diagram depicting a configuration example of a pixel according to the eighth embodiment of the present disclosure. The drawing is a schematic cross-sectional view depicting a configuration example of the pixel 541, similarly to FIG. 9. The pixel 541 in the drawing is different from the pixel 541 in FIG. 9 in that the pixel 541 includes a buried electrode 165 instead of the buried electrodes 161 and 162, and the charge holding section 103 is disposed separated from the boundary of the pixel.

The buried electrode 165 is disposed by being buried in the front surface side of the first semiconductor substrate 120 at the boundary of the pixel 541 overlapping the isolating section 171. The semiconductor region 123 is disposed adjacent to the buried electrode 165. The semiconductor region 122 constituting the charge holding section 103 is disposed to be separated from the boundary of the pixel 541, so as to be connected to the electrode 143. Similarly to the through-substrate electrode 251, the electrode 143 is an electrode formed of columnar metal or the like. Further, the electrode 143 is connected to the charge holding section wiring line 142. In addition, the through-substrate electrode 254, the wiring line 242, and the via plug 243 are sequentially connected to the charge holding section wiring line 142, and are connected to the element (the amplification transistor 213 in the drawing) of the second semiconductor substrate 220. Note that the electrode 143 is an example of a second connecting location described in the claims.

A part of the buried electrode 165 is extended to a region outside the pixel array section 540, so as to be connected to the through-substrate electrode 251. Similarly to FIG. 9, the through-substrate electrode 251 is connected to the ground line Vss of the third semiconductor substrate 320 via the wiring line 242 and the contact plug 244, and the ground potential is supplied as the reference potential (well potential). The through-substrate electrode 251 is also connected to a semiconductor region 225 of the second semiconductor substrate 220.

The configuration of the imaging device 1 other than this is similar to the configuration of the imaging device 1 in the first embodiment of the present disclosure, and thus the description thereof will be omitted.

In this manner, in the imaging device 1 according to the eighth embodiment of the present disclosure, the buried electrode 165 having a shape surrounding the pixel 541 is disposed to supply the reference potential. The region related to the supply of the reference potential can be disposed outside the pixel 541, making it possible to downsize the pixel 541.

### (9. Ninth embodiment)

The imaging device 1 of the eighth embodiment described above includes the charge transfer section 102 formed with a planar (horizontal) MOS transistor. In contrast, an imaging device 1 according to a ninth embodiment of the present disclosure is different from the above-described eighth embodiment in that the imaging device 1 includes a charge transfer section 102 formed with a vertical MOS transistor in which carriers move in a vertical direction.

### [Configuration of pixel sharing unit]

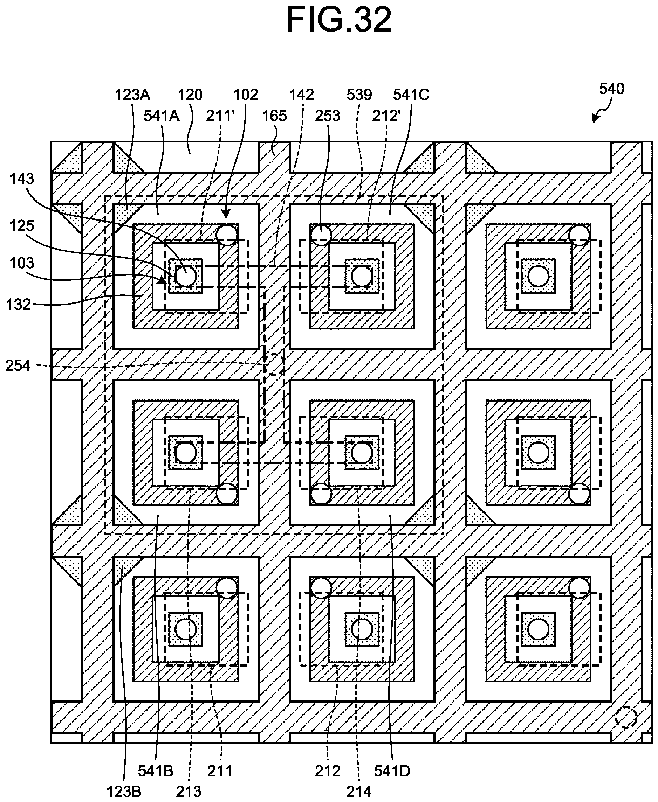

FIG. 32 is a diagram depicting a configuration example of a pixel sharing unit according to the ninth embodiment of the present disclosure. The drawing is a plan view depicting a configuration example of the pixel sharing unit 539, similarly to FIG. 30. The pixel sharing unit 539 in the drawing is different from the pixel sharing unit 539 in FIG. 30 in including a charge transfer section 102 formed with a vertical MOS transistor.

In the pixel 541 in the drawing, the charge holding section 103 and the charge transfer section 102 are disposed in the central portion. The charge transfer section 102 is disposed below a semiconductor region 125 constituting the charge holding section 103. The charge transfer section 102 is formed with a vertical MOS transistor as described above. A channel region of the charge transfer section 102 is disposed in a protrusion formed on the front surface side of the first semiconductor substrate 120 and includes a gate electrode 132. The gate electrode 132 is formed in a shape surrounding the periphery of the channel region. The charge transfer section 102 in this example of the drawing is formed to have a rectangular shape similar to that of the pixel 541 in plan view. The through-substrate electrode 253 is connected to the gate electrode 132. Further, an electrode 143 is connected to the charge holding section 103.

### [Configuration of pixel]

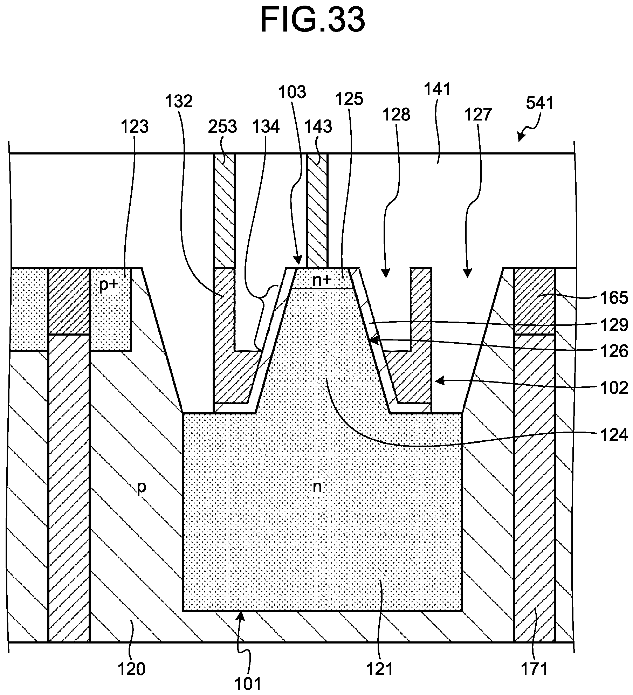

FIG. 33 is a diagram depicting a configuration example of a pixel according to the ninth embodiment of the present disclosure. The drawing is a schematic cross-sectional view depicting a configuration example of the pixel 541. The pixel 541 in the drawing is different from the pixel 541 in FIG. 31 in that the charge holding section 103 is formed with a vertical MOS transistor.

There is provided a protrusion 126 formed on the front surface side of the first semiconductor substrate 120. A channel region 124 of the charge holding section 103 is disposed in the protrusion 126. There is provided an annular groove 127 on the front surface side of the first semiconductor substrate 120. The protrusion 126 in the drawing is formed by grinding the front surface side of the first semiconductor substrate 120 into the shape of the annular groove 127. The photoelectric conversion section 101 is disposed below the charge transfer section 102, while the charge holding section 103 is disposed at an upper end of the charge transfer section 102. The channel region 124 of the charge transfer section 102 includes an n-type semiconductor. The n-type semiconductor region 121 of the photoelectric conversion section 101 and the n-type semiconductor region 125 of the charge holding section 103 correspond to the source region and the drain region of the charge transfer section 102, respectively. In the channel region 124, carriers (electrons in the drawing) move in the thickness direction (vertical direction) of the first semiconductor substrate 120 from the source region to the drain region.

By applying such a vertical MOS transistor to the charge transfer section 102, it is possible to reduce the area of the charge transfer section 102 on the front surface side of the first semiconductor substrate 120. This also makes it possible to facilitate transfer of charges from the photoelectric conversion section 101 constituted as a back-illuminated type and disposed in the deep portion of the first semiconductor substrate 120.

On the front surface of the channel region 124, an insulating film 129 corresponding to a gate insulating film is disposed. The gate electrode 132 having a shape adjacent to the channel region 124 is disposed via the insulating film 129. In this manner, the charge transfer section 102 is configured as a depletion type MOS transistor. The charge transfer section 102 is a transistor referred to as a normally-on type MOS transistor. In a case where the charge transfer section 102 is brought into a non-conductive state, a negative control signal is applied to the gate electrode 132.

The gate electrode 132 as an example in the drawing is formed in a shape surrounding the channel region 124. In this manner, by disposing the gate electrode 132 around the channel region 124, it is possible to increase the effective channel width, achieving reduction of the channel resistance. In addition, a depletion layer can be formed by applying a gate voltage to all side surfaces of the channel region, making it possible to achieve complete depletion of the channel region. This also makes it possible to reduce the leakage current at the time of OFF.

In addition, the gate electrode 132 in the drawing is disposed to be separated from the charge holding section 103 in the thickness direction of the first semiconductor substrate 120. There is provided a separating section 134 is disposed between the gate electrode 132 and the semiconductor region 125 of the charge holding section 103 in the drawing. An insulator similar to the insulating layer 141 is disposed in the separating section 134. The separating section 134 can be formed by disposing an annular groove 128 between the gate electrode 132 and the protrusion 126. In this manner, by separating the gate electrode 132 and the charge holding section 103 from each other, it is possible to reduce the electric field between the gate electrode 132 and the semiconductor region 125 constituting the charge holding section 103. When a high electric field is applied between the gate electrode 132 and the semiconductor region 125, charges are generated from the valence band, and the generated charges are retained at the interface between the insulating film 129 and the first semiconductor substrate 120 in the vicinity of the gate electrode 132. This leads to deterioration of the performance of the charge transfer section 102. By setting the distance between the gate electrode 132 and the charge holding section 103 to 100 nm or more, it is possible to lower the electric field between the gate electrode 132 and the semiconductor region 125 constituting the charge holding section 103.

On the other hand, when the distance between the gate electrode 132 and the charge holding section 103 is too large, the diffusion region of the drain of the charge transfer section 102 becomes long. This increases the region of the equivalent charge holding section 103, leading to an increase in the capacitance (FD capacitance) of the charge holding section 103.

Further, as described above, the charge transfer section 102 in the drawing is formed in a rectangular shape similar to that of the pixel 541 in plan view. By forming the charge transfer section 102 in a planar shape similar to that of the pixel 541, it is possible to increase the region of the charge transfer section 102 for the pixel 541.

Note that the configuration of the pixel 541 is not limited to this example. For example, the buried electrode 165 can be omitted. In this case, the through-substrate electrode 251 is disposed for each pixel 541 and connected to the semiconductor region 123 to allow the reference potential to be supplied.

### [Method of manufacturing imaging element]

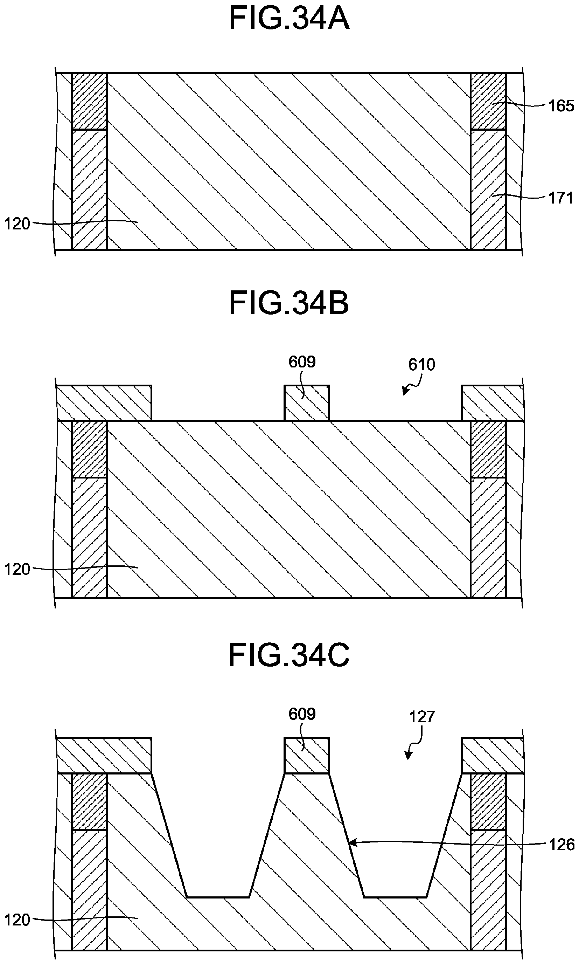

FIGS. 34A to 34M are diagrams depicting an example of the method of manufacturing the imaging element according to the ninth embodiment of the present disclosure. FIGS. 34A to 34M are diagrams depicting an example of a manufacturing step of the imaging device 1, being a diagram mainly depicting an example of a manufacturing step related to a region of the charge transfer section 102.

First, the isolating section 171 and the buried electrode 165 are disposed on the first semiconductor substrate 120 (FIG. 34A).

Next, a resist 609 is disposed on the front surface side of the first semiconductor substrate 120. The resist 609 is formed to have an opening 610 located in a portion where the annular groove 127 is formed (FIG. 34B). Next, the front surface side of the first semiconductor substrate 120 is etched using the resist 609 as a mask to form the annular groove 127. This process can be performed by dry etching, for example. Through this process, the protrusion 126 can be formed on the front surface side of the first semiconductor substrate 120 (FIG. 34C).

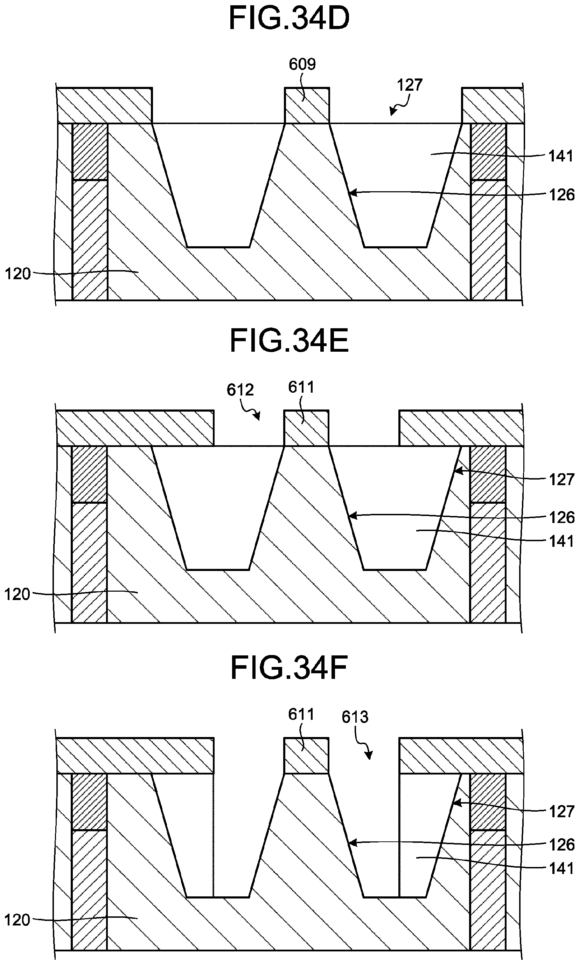

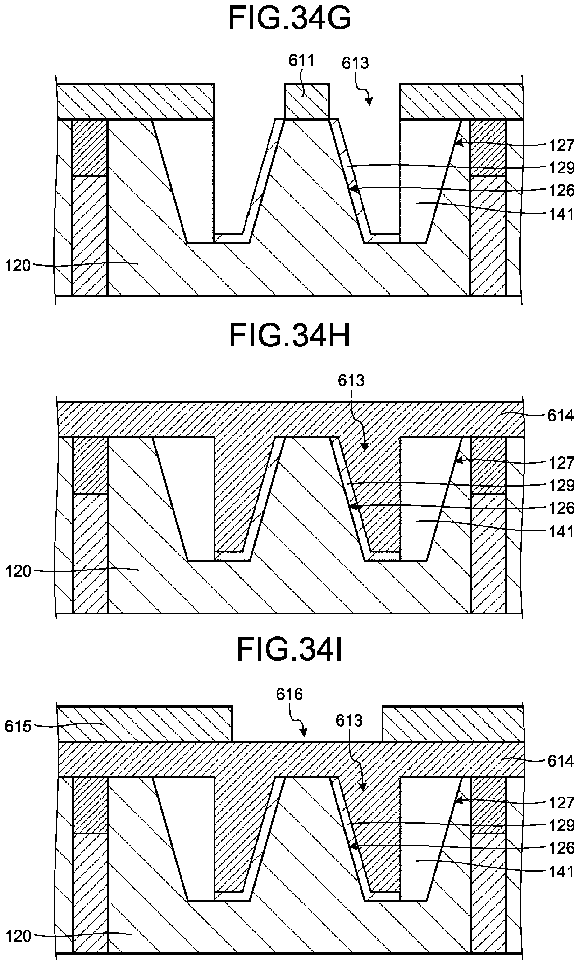

Next, the insulating layer 141 is disposed in the annular groove 127 (FIG. 34D). This process can be performed by forming a material film to be the insulating layer 141 by CVD and grinding an unnecessary portion, for example. Next, a resist 611 is disposed on the front surface side of the first semiconductor substrate 120. The resist 611 is formed to have an opening 612 located in a region where the gate electrode 132 is disposed (FIG. 34E). Next, the insulating layer 141 disposed in the annular groove 127 is etched using the resist 611 as a mask to form a groove 613 (FIG. 34F). This process can be performed by anisotropic dry etching, for example. Next, an insulating film 129 corresponding to a gate insulating film is formed on the side surface of the protrusion 126 and the bottom of the annular groove 127 (FIG. 34G). This process can be performed by thermal oxidation, for example.

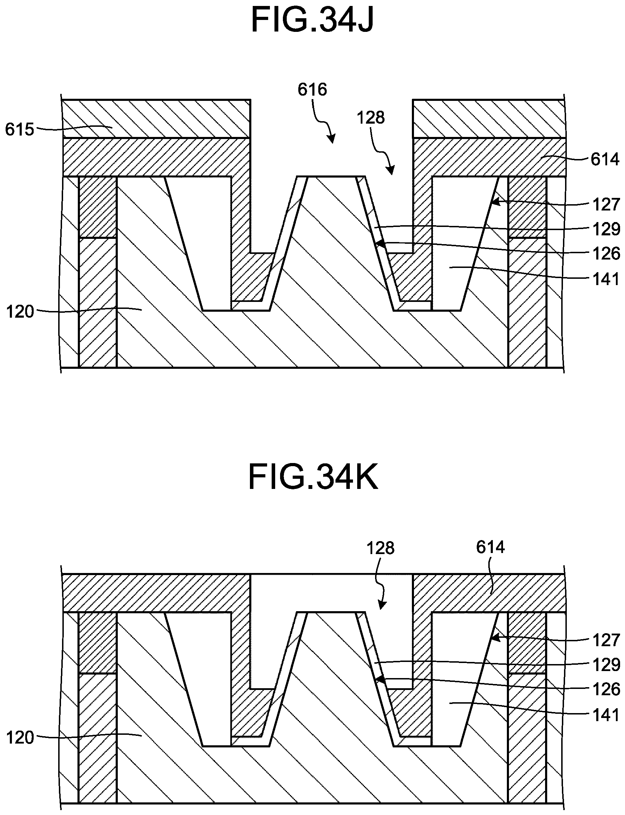

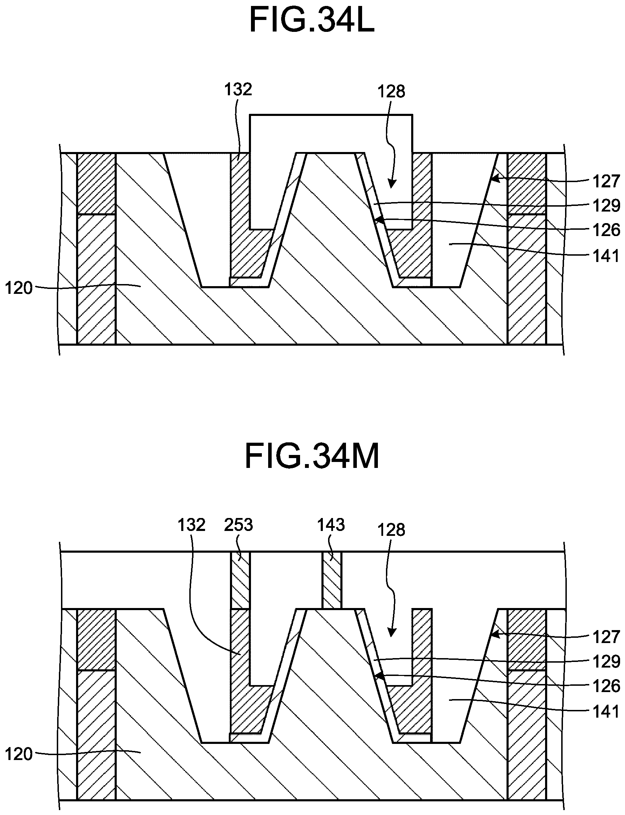

Next, a material film 614 of the gate electrode 132 is disposed on the front surface side of the first semiconductor substrate 120 including the groove 613 (FIG. 34H). This process can be performed by forming a polycrystalline silicon film by CVD, for example. Next, a resist 615 is disposed on the front surface side of the first semiconductor substrate 120. The resist 615 is formed to have an opening 616 located in a portion where the annular groove 128 is formed (FIG. 34I). Next, the material film 614 is etched using the resist 615 as a mask. At this time, the etching is stopped at a position where the portion of the gate electrode 132 adjacent to the channel region 124 has a desired width (FIG. 34J). This etching can be performed by dry etching, for example. This leads to formation of the annular groove 128. Next, the insulating layer 141 is disposed in the annular groove 128, and the resist 615 is removed (FIG. 34K). Next, the material film 614 on the front surface side of the first semiconductor substrate 120 is removed. Through this step, the gate electrode 132 can be formed (FIG. 34L). Next, the insulating layer 141 is disposed on the front surface side of the first semiconductor substrate 120, and the through-substrate electrode 253 and the electrode 143 are disposed (FIG. 34M). The charge transfer section 102 can be formed through the above steps.

### [Modifications]

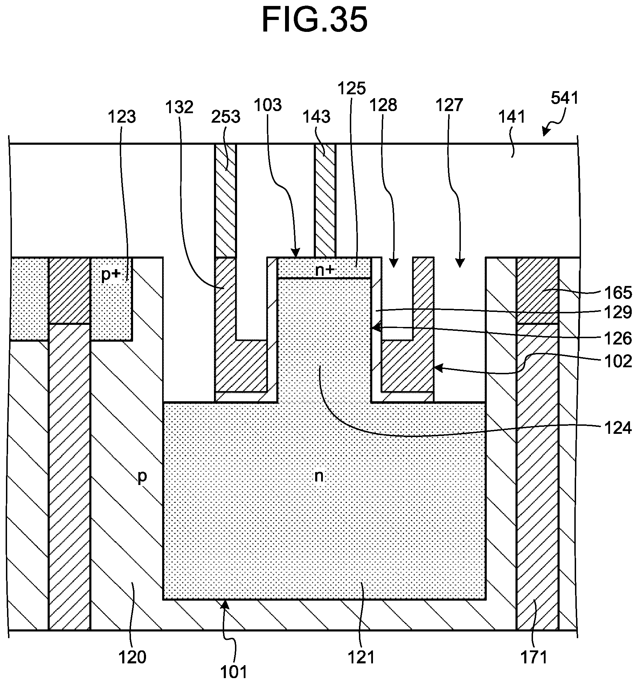

FIG. 35 is a diagram depicting a first modification of the configuration of the charge transfer section according to the ninth embodiment of the present disclosure. The drawing is a schematic cross-sectional view depicting a modification of the configuration of the charge transfer section 102. The charge transfer section 102 in the drawing is different from the charge transfer section 102 in FIG. 33 in that the annular groove 127 is formed to have a substantially vertical cross section.

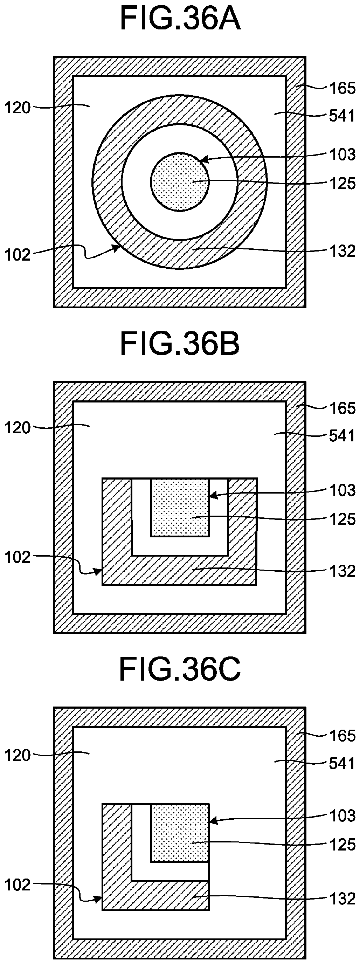

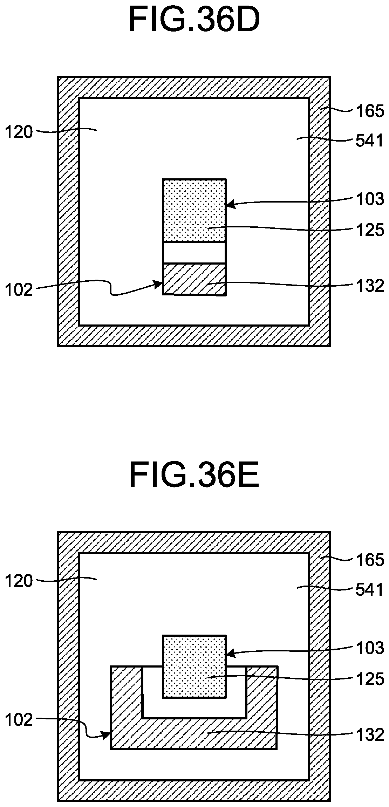

FIGS. 36A to 36E are diagrams depicting a second modification of the configuration of the charge transfer section according to the ninth embodiment of the present disclosure. FIGS. 36A to 36E are plan views depicting a modification of the configuration of the charge transfer section 102.

FIG. 36A is a diagram depicting an example of the charge transfer section 102 formed in a circular shape in plan view. Further, in the drawing, the charge holding section 103 can also be formed in a circular shape in plan view. Since the gate electrode 132 and the like are formed in a circular shape without a corner, concentration of an electric field can be alleviated.

FIGS. 36B to 36E are diagrams depicting an example in which the gate electrode 132 adjacent to the channel region 124 of the charge transfer section 102 is reduced. The gate electrode 132 can be formed in any shape that does not surround the channel region 124. By reducing the size of the gate electrode 132, the charge transfer section 102 can be downsized. In addition, by reducing the size of the gate electrode 132, it is possible to downsize the capacitance between the gate electrode 132 and the channel region 124. The input capacitance of the charge transfer section 102 is reduced, leading to high speed operation of the charge transfer section 102.

The configuration of the imaging device 1 other than this is similar to the configuration of the imaging device 1 in the eighth embodiment of the present disclosure, and thus the description thereof will be omitted.

In this manner, the imaging device 1 according to the ninth embodiment of the present disclosure includes the charge transfer section 102 formed with the vertical MOS transistor, making it possible to downsize the charge transfer section 102.

### (10. Tenth embodiment)

In the imaging device 1 of the ninth embodiment described above, the wiring line that transmits the control signal of the charge transfer section 102 is disposed for each pixel sharing unit 539. In contrast, an imaging device 1 according to a tenth embodiment of the present disclosure is different from that of the above-described ninth embodiment in that a wiring line for transmitting a control signal of a charge transfer section 102 is shared in an adjacent pixel sharing unit 539.

### [Configuration of pixel sharing unit]

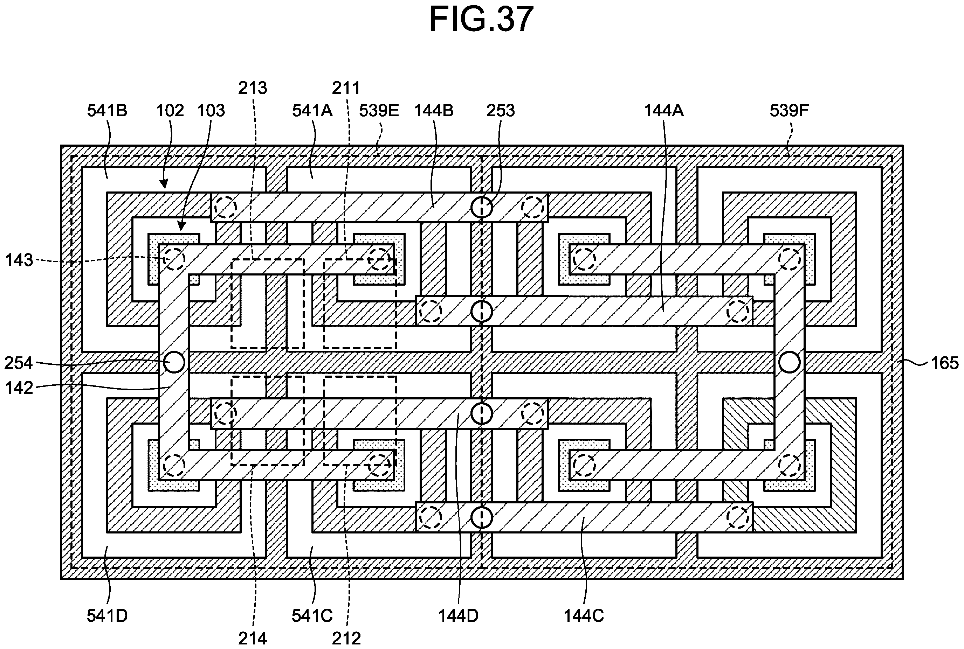

FIG. 37 is a diagram depicting a configuration example of a pixel sharing unit according to the tenth embodiment of the present disclosure. The drawing is a plan view depicting a configuration example of the pixel sharing unit 539, similarly to FIG. 32. The pixel sharing unit 539 in the drawing is different from the pixel sharing unit 539 in FIG. 32 in including a charge transfer section wiring line 144.

The charge transfer section wiring line 144 is a signal line that is disposed in common in the adjacent pixel sharing units 539 and transmits a control signal of the charge transfer section 102. The charge transfer section wiring line 144 will be described using pixel sharing units 539E and 539F depicted in the drawing. The gate electrodes 132 of the four charge transfer sections 102 of the pixel sharing unit 539E is connected with the gate electrodes 132 of the corresponding charge transfer sections 102 of the pixel sharing unit 539F individually by charge transfer section wiring lines 144A to 144D. Specifically, the gate electrode 131A of the charge transfer section 102A in the pixel 541A of the pixel sharing unit 539E is connected with the gate electrode 131 of the charge transfer section 102A in the pixel 541A of the pixel sharing unit 539F by the charge transfer section wiring line 144A. Similarly, the gate electrodes 132 of the charge transfer sections 102 of the pixels 541B to 541D are each connected by the charge transfer section wiring lines 144B to 144D, respectively. A through-substrate electrode 253 is disposed on each of the charge transfer section wiring lines 144A to 144D.

In this manner, by sharing the signal line for transmitting the control signal between the adjacent pixel sharing units 539, it is possible to reduce the number of through-substrate electrodes 253 for transmitting the control signal.

Note that the charge holding section wiring line 142 having a U-shape is disposed in the pixel sharing units 539E and 539F in the drawing.

In a case where the through-substrate electrode is disposed for each of the charge holding section 103 and the charge transfer section 102 without using the charge holding section wiring line 142 or the charge transfer section wiring line 144, there is a need to use eight through-substrate electrodes 253 and the like for each pixel sharing unit 539. In contrast, by using the charge holding section wiring line 142 and the charge transfer section wiring line 144, the number of the through-substrate electrodes 253 and 254 per pixel sharing unit 539 can be reduced to three. This also makes it possible to reduce the opening area of the through hole 262 of the second semiconductor substrate 220 for disposing the through-substrate electrode 253 and the like.

The configuration of the imaging device 1 other than this is similar to the configuration of the imaging device 1 in the ninth embodiment of the present disclosure, and thus the description thereof will be omitted.

In this manner, in the imaging device 1 according to the tenth embodiment of the present disclosure, by disposing the charge transfer section wiring line 144 and sharing the control signal between the adjacent pixel sharing units 539, it is possible to reduce the number of through-substrate electrodes 253.

### (11. Application example)

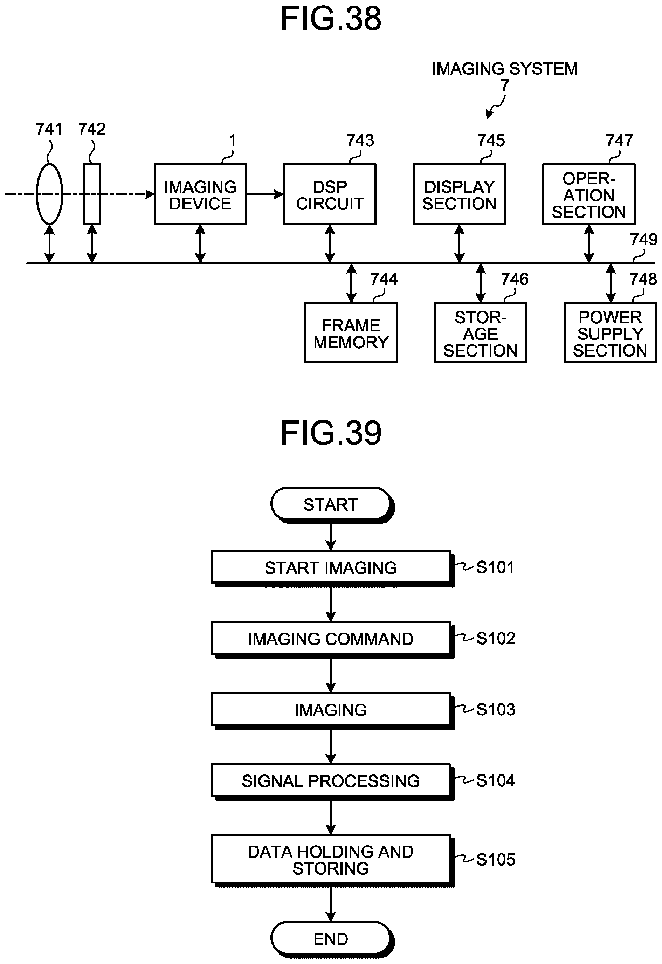

FIG. 38 depicts an example of a schematic configuration of an imaging system including the imaging device according to the embodiments and their modifications.

An imaging system 7 is, for example, an electronic device exemplified by an imaging device such as a digital still camera or a video camera, or a portable terminal device such as a smartphone or a tablet terminal. The imaging system 7 includes, for example, the imaging device 1 according to the above-described embodiments and their modifications, a DSP circuit 743, frame memory 744, a display section 745, a storage section 746, an operation section 747, and a power supply section 748. In the imaging system 7, the imaging device 1 according to the above-described embodiments and their modifications, the DSP circuit 743, the frame buffer memory 744, the display section 745, the storage section 746, the operation section 747, and the power supply section 748 are connected to each other via a bus line 749.

The imaging device 1 according to the above-described embodiments and their modifications outputs image data according to incident light. The DSP circuit 743 is a signal processing circuit that processes a signal (image data) output from the imaging device 1 according to the above-described embodiments and their modifications. The frame buffer memory 744 temporarily holds the image data processed by the DSP circuit 743 in units of frames. The display section 745 includes, for example, a panel-type display device such as a liquid crystal panel or an organic electro luminescence (EL) panel, and displays a moving image or a still image captured by the imaging device 1 according to the above-described embodiments and their modifications. The storage section 746 records image data of a moving image or a still image captured by the imaging device 1 according to the above-described embodiments and their modifications in a recording medium such as semiconductor memory or a hard disk. The operation section 747 issues operation commands for various functions of the imaging system 7 in accordance with an operation by the user. The power supply section 748 appropriately supplies various types of power as operation power of the imaging device 1 according to the above-described embodiments and their modifications, the DSP circuit 743, the frame buffer memory 744, the display section 745, the storage section 746, and the operation section 747 to these supply targets.

Next, an imaging procedure in the imaging system 7 will be described.

FIG. 39 depicts an example of a flowchart of an imaging operation in the imaging system. A user instructs start of imaging by operating the operation section 747 (step S101). Subsequently, the operation section 747 transmits an imaging command to the imaging device 1 (step S102). Having received the imaging command, the imaging device 1 (specifically, a system control circuit 36) executes imaging by a predetermined imaging method (step S103).

The imaging device 1 outputs image data obtained by imaging to the DSP circuit 743. Here, the image data represents data for all the pixels of the pixel signal generated on the basis of the charge temporarily held in the floating diffusion FD. The DSP circuit 743 performs predetermined signal processing (for example, noise reduction processing) on the basis of the image data input from the imaging device 1 (step S104). The DSP circuit 743 causes the frame buffer memory 744 to hold the image data subjected to predetermined signal processing, and then, the frame buffer memory 744 causes the storage section 746 to store the image data (step S105). In this manner, imaging in the imaging system 7 is performed.

In the present application example, the imaging device 1 according to the above-described embodiments and their modifications is applied to the imaging system 7. With this application, the imaging device 1 can be downsized or have high definition, making it possible to provide the small or high definition imaging system 7.

### (12. Example of application to mobile body)

The technology according to the present disclosure (the present technology) is applicable to various products. For example, the technology according to the present disclosure may be applied to devices mounted on any of mobile body such as automobiles, electric vehicles, hybrid electric vehicles, motorcycles, bicycles, personal mobility, airplanes, drones, ships, and robots.

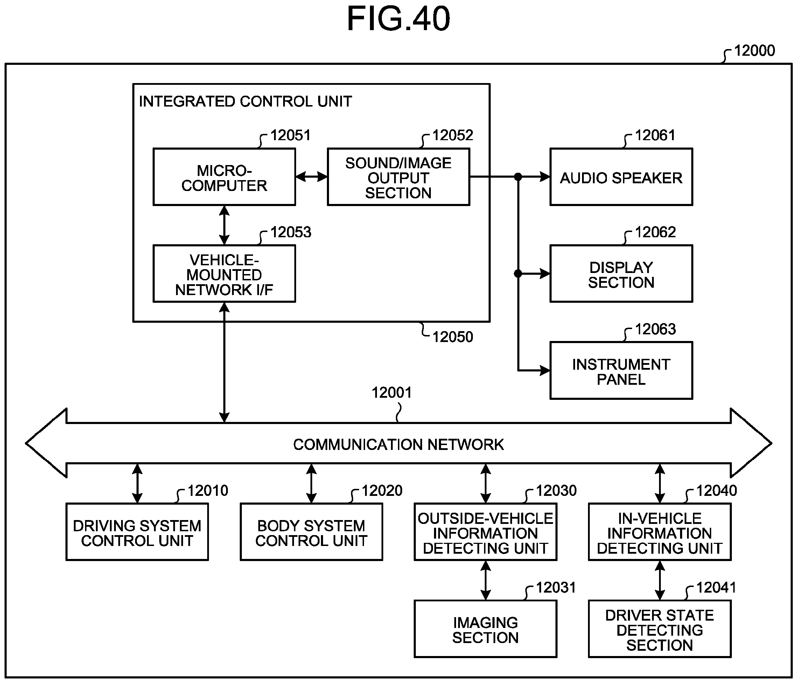

FIG. 40 is a block diagram depicting an example of schematic configuration of a vehicle control system as an example of a mobile body control system to which the technology according to an embodiment of the present disclosure can be applied.

A vehicle control system 12000 includes a plurality of electronic control units connected to each other via a communication network 12001. In the example depicted in FIG. 40, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 40, an audio speaker 12061, a display section 12062, and an instrument panel 12063 are illustrated as the output device. The display section 12062 may, for example, include at least one of an on-board display and a head-up display.

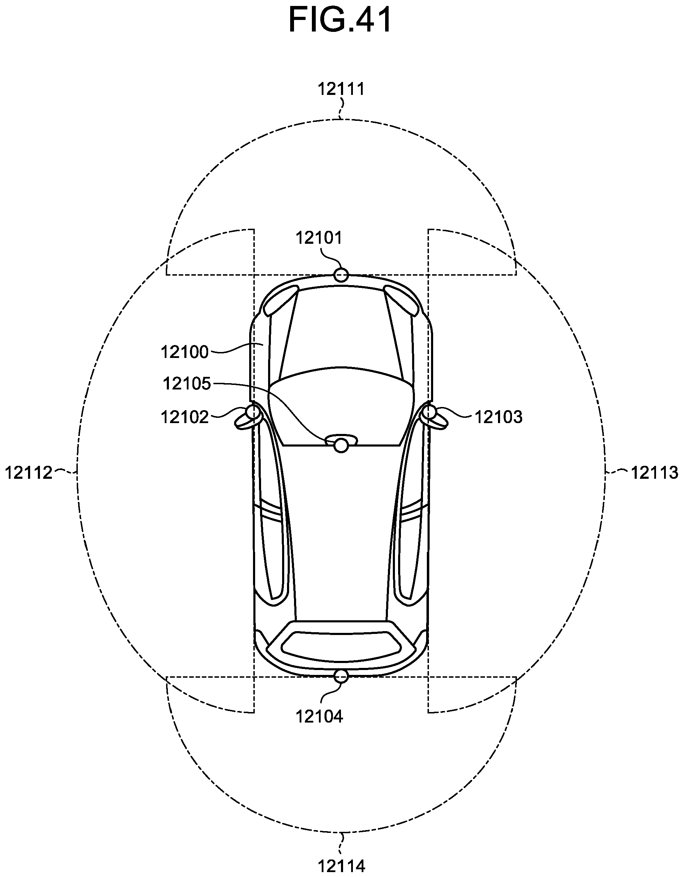

FIG. 41 is a diagram depicting an example of the installation position of the imaging section 12031.

In FIG. 41, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of a vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 41 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Hereinabove, an example of the vehicle control system to which the technology according to the present disclosure is applicable has been described. The technology according to the present disclosure can be suitably applied to the imaging section 12031 among the configurations described above. Specifically, the imaging device 1 in FIG. 1 can be applied to the imaging section 12031. By applying the technology according to the present disclosure to the imaging section 12031, it is possible to downsize the imaging section 12031.

### (13. Example of application to endoscopic surgery system)

The technology according to the present disclosure (the present technology) is applicable to various products. For example, the techniques according to the present disclosure may be applied to endoscopic surgery systems.

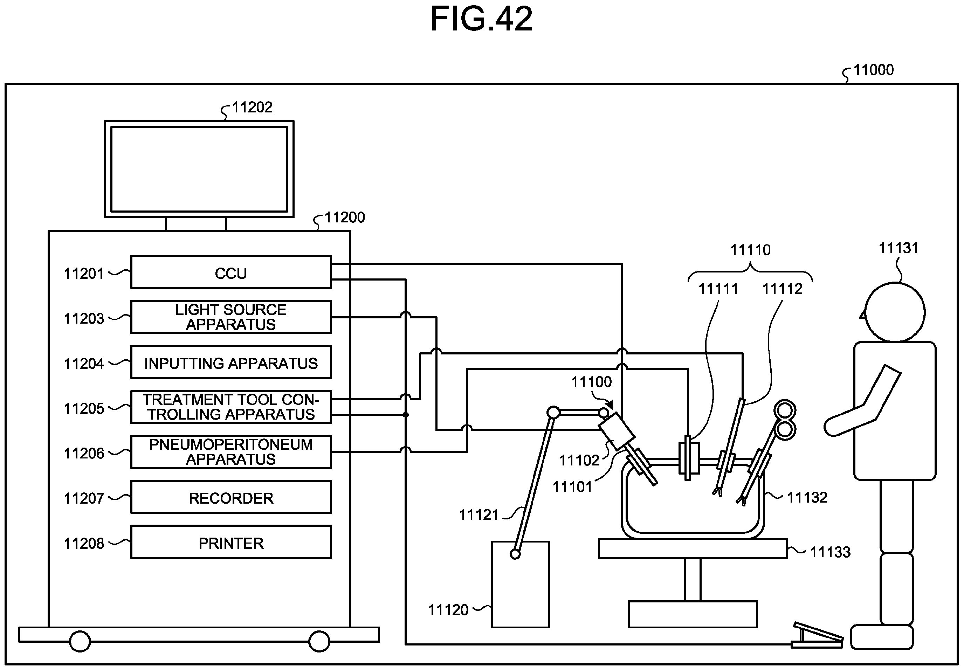

FIG. 42 is a view depicting an example of a schematic configuration of an endoscopic surgery system to which the technology according to an embodiment of the present disclosure (present technology) can be applied.

In FIG. 42, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

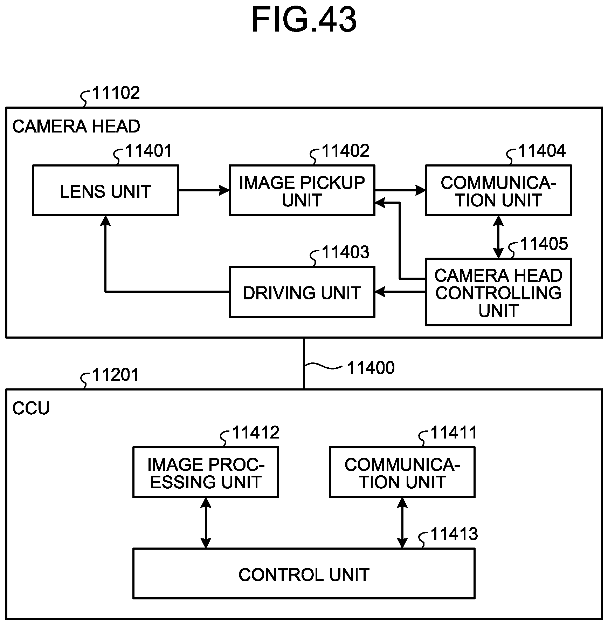

FIG. 43 is a block diagram depicting an example of a functional configuration of the camera head 11102 and the CCU 11201 depicted in FIG. 42.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technique according to the present disclosure can be applied to, for example, the endoscope 11100 and the image pickup unit 11402 of the camera head 11102 among the configurations described above. Specifically, the imaging device 1 in FIG. 1 can be applied to the image pickup unit 11402. By applying the technology according to the present disclosure to the image pickup unit 11402, it is possible to downsize the image pickup unit 11402.

Although the endoscopic surgery system has been described here as an example, the technique according to the present disclosure may be applied to, for example, a microscopic surgery system or the like.

Note that the configuration of the seventh embodiment of the present disclosure can be applied to other embodiments. Specifically, the isolating section 173 in FIG. 29A and the isolating section 174 in FIG. 29B can be applied to the second to sixth and eighth to tenth embodiments of the present disclosure.

### (Effects)

The imaging device 1 includes the pixel 541, the pixel circuit 210, the isolating section 171, the buried electrodes (buried electrodes 161 and 162), and the connecting locations (through-substrate electrodes 251 and 252). The pixel 541 includes: the photoelectric conversion section 101 that is disposed on the first semiconductor substrate 120 and performs photoelectric conversion of incident light; the charge holding section 103 that holds a charge generated by the photoelectric conversion; and the charge transfer section 102 that transfers the charge from the photoelectric conversion section 101 to the charge holding section 103. The pixel circuit 210 disposes on the second semiconductor substrate 220 stacked on the front surface side of the first semiconductor substrate 120 and generates an image signal on the basis of charges held. The isolating section 171 is disposed at a boundary of the pixel 541. The buried electrodes (buried electrodes 161 and 162) are disposed by being buried in the front surface side of the first semiconductor substrate 120 at the boundary of the pixel 541 overlapping the isolating section 171, so as to be connected to the first semiconductor substrate 120. The connecting locations (through-substrate electrodes 251 and 252) are connected to the buried electrodes (buried electrodes 161 and 162). This brings about an effect that a buried electrode that transmits a signal or the like is disposed at a boundary of pixels. This makes it possible to reduce the pixel size.

Further, boundary wiring lines (boundary wiring lines 163 and 164) disposed at the boundary of the pixel 541 and connected to the buried electrodes (buried electrodes 161 and 162) may be further provided. This makes it possible to connect the buried electrodes to each other at the boundary of the pixel 541.

The boundary wiring line (boundary wiring line 163) may be disposed by being buried in the first semiconductor substrate 120.

The boundary wiring line (boundary wiring line 164) may be disposed adjacent to the front surface side of the first semiconductor substrate 120.

In addition, the connecting locations (through-substrate electrodes 251 and 252) may be connected to the buried electrodes (buried electrodes 161 and 162) via the boundary wiring lines (boundary wiring lines 163 and 164). This makes it possible to expand the arrangement place of the connecting location.

In addition, the buried electrode (buried electrode 161) may be connected to the well region of the first semiconductor substrate 120, and the connecting location (through-substrate electrode 251) may supply a reference potential. This makes it possible to supply the reference potential via the buried electrode (buried electrode 161).

The buried electrode (buried electrode 161) may be formed in a shape surrounding the pixel 541. With this configuration, the resistance of the buried electrode (buried electrode 161) can be reduced in the plane direction of the semiconductor substrate.

Further, the pixels 541 may be disposed in plurality on the first semiconductor substrate 120.

In addition, the buried electrode (buried electrode 161) may be commonly connected to the well region of each pixel 541 of the pixel group 538 including two or more pixels 541 among the plurality of pixels 541. With this configuration, the buried electrode (buried electrode 161) can be shared by the pixels 541 disposed in the pixel group 538.

Further, the connecting location (through-substrate electrode 251) may be disposed for each of the pixel groups 538. This makes it possible to reduce the number of connecting locations.

Further, the connecting location (through-substrate electrode 251) may be disposed on the first semiconductor substrate 120 outside the plurality of pixels 541. This makes it possible to reduce the number of connecting locations.

Further, the pixel circuit 210 may be disposed for each pixel sharing unit 539 including two or more pixels 541 among the plurality of pixels 541. With this configuration, the pixel circuit 210 can be shared by a plurality of pixels disposed in a pixel sharing unit 639.

Further, it is allowable to further provide the electrode 143 connected to the charge holding section 103 and the charge holding section wiring line 142 disposed between the first semiconductor substrate 120 and the second semiconductor substrate 220 and commonly connected to the electrode 143 of each of the plurality of pixels 541 included in the pixel sharing unit 539, and the charge holding section wiring line 142 may be connected to the pixel circuit 210. This makes it possible to reduce the number of connecting locations penetrating the second semiconductor substrate 220.

Further, it is allowable to further provide: the charge transfer section wiring line 144 that is disposed between the first semiconductor substrate 120 and the second semiconductor substrate 220, transmits a control signal to the charge transfer section 102, and is commonly connected to the charge transfer sections 102 of another one of the pixel sharing units 539; and the electrode 143 that is connected to the charge transfer section wiring line and supplies the control signal. This makes it possible to reduce the number of connecting locations penetrating the second semiconductor substrate 220.

In addition, the connecting location (through-substrate electrode 251) may be connected to the well region in which the element of the pixel circuit 210 is disposed in the second semiconductor substrate 220. With this configuration, the well potential can be used in common between the first semiconductor substrate 120 and the second semiconductor substrate 220.

Further, the buried electrode (buried electrode 162) may be connected to the charge holding section 103, while the connecting location (through-substrate electrode 252) may be connected to the pixel circuit 210. With this configuration, the potential of the charge holding section 103 can be transmitted via the electrode (buried electrode 162).

Further, the plurality of pixels 541 may be disposed on the first semiconductor substrate 120, and the pixel circuit 210 may be disposed for each pixel sharing unit 539 including two or more pixels 541 among the plurality of pixels 541. With this configuration, the pixel circuit 210 can be shared by the plurality of pixels 541 disposed in the pixel sharing unit 539.

In addition, the buried electrode (buried electrode 162) may be commonly connected to the charge holding section 103 of each pixel 541 in the pixel sharing unit 539. Thereby, the buried electrode (buried electrode 162) can be shared by the plurality of pixels 541 disposed in the pixel sharing unit 539.

In addition, the buried electrode (buried electrode 162) may be formed in a shape protruding from the first semiconductor substrate 120, and the charge transfer section 102 may be formed with a MOS transistor including the gate electrode 131 having a height equal to or less than a protruding height of the buried electrode (buried electrode 162) from the first semiconductor substrate 120. This configuration makes it possible to reduce the parasitic capacitance of the charge holding section 103 connected to the buried electrode (buried electrode 162).

In addition, the connecting location (through-substrate electrode 251) may be connected to the well region via the semiconductor region 123 which is a semiconductor region having a high impurity concentration formed in the first semiconductor substrate 120. This makes it possible to reduce the connection resistance between the connecting location (through-substrate electrode 251) and the first semiconductor substrate 120.

In addition, the buried electrodes (the buried electrodes 161 and 162) may include silicon. This allows a high temperature process to be employed in the manufacturing step after the formation of the buried electrodes (buried electrodes 161 and 162).

In addition, the isolating section 171 may be formed in a shape penetrating the first semiconductor substrate 120. Accordingly, the isolating capacity can be improved.

The isolating section 171 may be formed of an insulator.

In addition, the isolating section 171 may include a semiconductor region having a high impurity concentration.

Further, it is also allowable to further provide a third semiconductor substrate 320 that is stacked on a side of the second semiconductor substrate 220 different from the side on which the first semiconductor substrate 120 is disposed and that includes a circuit connected to the pixel circuit 210.

Further, the charge transfer section 102 may be formed with a MOS transistor that includes: a channel region disposed in the protrusion 126 formed on the front surface side of the first semiconductor substrate 120; and a gate electrode 132 adjacent to the side surface of the protrusion 126 via an insulating film and transfers the charge in the thickness direction of the first semiconductor substrate 120. This makes it possible to reduce the area of the charge transfer section 102.

Further, the protrusion 126 may be formed by grinding the front surface side of the first semiconductor substrate 120 into an annular groove shape. This brings about an effect of burying the protrusion 126 in the first semiconductor substrate 120. This makes it possible to flatten the front surface side of the first semiconductor substrate 120.

The gate electrode 132 may be formed in a shape surrounding the side surface of the protrusion 126. This makes it possible to expand the effective channel width.

Further, the charge holding section 103 may be disposed at an end of the protrusion 126. With this configuration, the wiring line between the charge transfer section 102 and the charge holding section 103 can be omitted.

Further, the gate electrode 132 may be disposed to be separated from the charge holding section 103 in the thickness direction of the first semiconductor substrate 120. This makes it possible to reduce the electric field between the gate electrode 132 and the charge holding section 103.

In addition, the channel region may be formed to have a conductivity type different from that of the well region of the first semiconductor substrate 120. This makes it possible to form a depletion type MOS transistor.

The imaging device 1 includes the pixel 541, the pixel circuit 210, the isolating section 171, the buried electrodes (buried electrodes 161 and 162), the connecting locations (through-substrate electrodes 251 and 252), and the column signal processing section 550. The pixel 541 includes: the photoelectric conversion section 101 that is disposed on the first semiconductor substrate 120 and performs photoelectric conversion of incident light; the charge holding section 103 that holds a charge generated by the photoelectric conversion; and the charge transfer section 102 that transfers the charge from the photoelectric conversion section 101 to the charge holding section 103. The pixel circuit 210 disposes on the second semiconductor substrate 220 stacked on the front surface side of the first semiconductor substrate 120 and generates an image signal on the basis of charges held. The isolating section 171 is disposed at a boundary of the pixel 541. The buried electrodes (buried electrodes 161 and 162) are disposed by being buried in the front surface side of the first semiconductor substrate 120 at the boundary of the pixel 541 overlapping the isolating section 171, so as to be connected to the first semiconductor substrate 120. The connecting locations (through-substrate electrodes 251 and 252) are connected to the buried electrodes (buried electrodes 161 and 162). The column signal processing section 550 processes the generated image signal. This brings about an effect that a buried electrode that transmits a signal or the like is disposed at a boundary of pixels. This makes it possible to reduce the pixel size.

The effects described in the present specification are merely examples, and thus, there may be other effects, not limited to the exemplified effects.

Note that the present technique can also have the following configurations.
(1) An imaging element comprising:
   pixels each disposed on a first semiconductor substrate and including a photoelectric conversion section that performs photoelectric conversion of incident light, a charge holding section that holds a charge generated by the photoelectric conversion, and a charge transfer section that transfers the charge from the photoelectric conversion section to the charge holding section;
   a pixel circuit that is disposed on a second semiconductor substrate stacked on a front surface side of the first semiconductor substrate and generates an image signal on a basis of the held charge;
   an isolating section disposed at a boundary of the pixels;
   a buried electrode that is disposed by being buried in the front surface side of the first semiconductor substrate at a boundary of the pixel overlapping with the isolating section and is connected to the first semiconductor substrate; and
   a connecting location connected to the buried electrode.
(2) The imaging element according to the above (1), further comprising a boundary wiring line disposed at the boundary of the pixels and connected to the buried electrode.
(3) The imaging element according to the above (2), wherein the boundary wiring line is disposed by being buried in the first semiconductor substrate.
(4) The imaging element according to the above (2), wherein the boundary wiring line is disposed adjacent to the front surface side of the first semiconductor substrate.
(5) The imaging element according to the above (2), wherein the connecting location is connected to the buried electrode via the boundary wiring line.
(6) The imaging element according to any one of the above (1) to (5), wherein the buried electrode is connected to a well region of the first semiconductor substrate, and
   the connecting location supplies a reference potential.
(7) The imaging element according to the above (6), wherein the buried electrode is formed in a shape surrounding the pixel.
(8) The imaging element according to the above (6), wherein a plurality of the pixels are disposed on the first semiconductor substrate.
(9) The imaging element according to the above (8), wherein the buried electrode is commonly connected to the well region of each pixel of a pixel group including two or more pixels among the plurality of pixels.
(10) The imaging element according to the above (9), wherein the connecting location is disposed for each of the pixel groups.
(11) The imaging element according to the above (8), wherein the connecting location is disposed on the first semiconductor substrate outside the plurality of pixels.
(12) The imaging element according to the above (8), wherein the pixel circuit is disposed for each of pixel sharing units, each pixel sharing unit including two or more pixels among the plurality of pixels.
(13) The imaging element according to the above (12), further comprising:
   a second connecting location connected to the charge holding section; and
   a charge holding section wiring line disposed between the first semiconductor substrate and the second semiconductor substrate and connected in common to the second connecting location of each of the plurality of pixels included in the pixel sharing unit,
   wherein the charge holding section wiring line is connected to the pixel circuit.
(14) The imaging element according to the above (12), further comprising:
   a charge transfer section wiring line that is disposed between the first semiconductor substrate and the second semiconductor substrate, transmits a control signal to the charge transfer section, and is commonly connected to the charge transfer sections of another piece of the pixel sharing units; and
   a second connecting location that is connected to the charge transfer section wiring line and supplies the control signal.
(15) The imaging element according to any one of the above (6) to (14), wherein the connecting location is connected to a well region in which an element of the pixel circuit is disposed, on the second semiconductor substrate.
(16) The imaging element according to any one of the above (6) to (14), wherein the buried electrode is formed in a band shape in plan view.
(17) The imaging element according to the above (1),
   wherein the buried electrode is connected to the charge holding section, and
   the connecting location is connected to the pixel circuit.
(18) The imaging element according to the above (17),
   wherein a plurality of the pixels is disposed on the first semiconductor substrate, and
   the pixel circuit is disposed for each of pixel sharing units, each pixel sharing unit including two or more pixels among the plurality of pixels.
(19) The imaging element according to the above (18), wherein the buried electrode is commonly connected to the charge holding section of each pixel in the pixel sharing unit.
(20) The imaging element according to any one of the above (17) to (19),
   wherein the buried electrode is formed in a shape protruding from the first semiconductor substrate, and
   the charge transfer section includes a MOS transistor including a gate electrode having a height equal to or less than a protruding height of the buried electrode from the first semiconductor substrate.
(21) The imaging element according to any one of the above (6) to (20), wherein the connecting location is connected to the well region via a high-concentration impurity region which is a semiconductor region having a high impurity concentration formed on the first semiconductor substrate.
(22) The imaging element according to any one of the above (1) to (21), wherein the buried electrode includes silicon.
(23) The imaging element according to any one of the above (1) to (22), wherein the isolating section has a shape penetrating the first semiconductor substrate.
(24) The imaging element according to any one of the above (1) to (23), wherein the isolating section is formed with an insulator.
(25) The imaging element according to any one of the above (1) to (23), wherein the isolating section is formed with a semiconductor region having a high impurity concentration.
(26) The imaging element according to any one of the above (1) to (25), further comprising a third semiconductor substrate that is stacked on a side of the second semiconductor substrate different from the side on which the first semiconductor substrate is disposed and that includes a circuit connected to the pixel circuit.
(27) The imaging element according to any one of the above (1) to (26), wherein the charge transfer section is formed with a MOS transistor that includes: a channel region disposed in a protrusion formed on a front surface side of the first semiconductor substrate; and a gate electrode adjacent to a side surface of the protrusion via an insulating film, and that transfers the charge in a thickness direction of the first semiconductor substrate.
(28) The imaging element according to the above (27), wherein the protrusion is formed by grinding the front surface side of the first semiconductor substrate into an annular groove shape.
(29) The imaging element according to the above (27), wherein the gate electrode is formed in a shape surrounding a side surface of the protrusion.
(30) The imaging element according to any one of the above (27) to (29), wherein the charge holding section is disposed at an end of the protrusion.
(31) The imaging element according to the above (30), wherein the gate electrode is disposed to be separated from the charge holding section in a thickness direction of the first semiconductor substrate.
(32) The imaging element according to any one of the above (27) of (31), wherein the channel region is formed to have a conductivity type different from a conductivity type of a well region of the first semiconductor substrate.
(33) An imaging device comprising:
   pixels each disposed on a first semiconductor substrate and including a photoelectric conversion section that performs photoelectric conversion of incident light, a charge holding section that holds a charge generated by the photoelectric conversion, and a charge transfer section that transfers the charge from the photoelectric conversion section to the charge holding section;
   a pixel circuit that is disposed on a second semiconductor substrate stacked on a front surface side of the first semiconductor substrate and generates an image signal on a basis of the held charge;
   an isolating section disposed at a boundary of the pixels;
   a buried electrode that is disposed by being buried in the front surface side of the first semiconductor substrate at a boundary of the pixel overlapping with the isolating section and is connected to the first semiconductor substrate;
   a connecting location connected to the buried electrode; and
   a processing circuit that processes the generated image signal.

### Reference Signs List

1 IMAGING DEVICE
100S, 200S, 300S SEMICONDUCTOR LAYER
100T, 200T, 300T WIRING LAYER
101, 101A, 101B PHOTOELECTRIC CONVERSION SECTION
102, 102A, 102B CHARGE TRANSFER SECTION
103, 103A, 103B CHARGE HOLDING SECTION
120 FIRST SEMICONDUCTOR SUBSTRATE
123, 123A, 123B SEMICONDUCTOR REGION
124 CHANNEL REGION
126 PROTRUSION
128 ANNULAR GROOVE
129 INSULATING FILM
132 GATE ELECTRODE
134 SEPARATING SECTION
142 CHARGE HOLDING SECTION WIRING LINE
143 ELECTRODE
144, 144A, 144B, 144C, 144D CHARGE TRANSFER SECTION WIRING LINE
161, 162, 165, 166 BURIED ELECTRODE
163, 164 BOUNDARY WIRING LINE
171, 173, 174 ISOLATING SECTION
179 GROOVE
210 PIXEL CIRCUIT
220 SECOND SEMICONDUCTOR SUBSTRATE
251 to 254 THROUGH-SUBSTRATE ELECTRODE
320 THIRD SEMICONDUCTOR SUBSTRATE
538 PIXEL GROUP
539, 539A, 539B, 539E, 539F PIXEL SHARING UNIT
540 PIXEL ARRAY SECTION
541, 541A, 541B, 541C, 541D PIXEL
550 COLUMN SIGNAL PROCESSING SECTION
11402, 12031, 12101 to 12105 IMAGING SECTION

## Claims

1. An imaging element comprising:
pixels each disposed on a first semiconductor substrate and including a photoelectric conversion section that performs photoelectric conversion of incident light, a charge holding section that holds a charge generated by the photoelectric conversion, and a charge transfer section that transfers the charge from the photoelectric conversion section to the charge holding section;
a pixel circuit that is disposed on a second semiconductor substrate stacked on a front surface side of the first semiconductor substrate and generates an image signal on a basis of the held charge;
an isolating section disposed at a boundary of the pixels;
a buried electrode that is disposed by being buried in the front surface side of the first semiconductor substrate at a boundary of the pixel overlapping with the isolating section and is connected to the first semiconductor substrate; and
a connecting location connected to the buried electrode.

2. The imaging element according to claim 1, further comprising a boundary wiring line disposed at the boundary of the pixels and connected to the buried electrode.

3. The imaging element according to claim 2, wherein the boundary wiring line is disposed by being buried in the first semiconductor substrate.

4. The imaging element according to claim 2, wherein the boundary wiring line is disposed adjacent to the front surface side of the first semiconductor substrate.

5. The imaging element according to claim 2, wherein the connecting location is connected to the buried electrode via the boundary wiring line.

6. The imaging element according to claim 1,
wherein the buried electrode is connected to a well region of the first semiconductor substrate, and
the connecting location supplies a reference potential.

7. The imaging element according to claim 6, wherein the buried electrode is formed in a shape surrounding the pixel.

8. The imaging element according to claim 6, wherein a plurality of the pixels are disposed on the first semiconductor substrate.

9. The imaging element according to claim 8, wherein the buried electrode is commonly connected to the well region of each pixel of a pixel group including two or more pixels among the plurality of pixels.

10. The imaging element according to claim 9, wherein the connecting location is disposed for each of the pixel groups.

11. The imaging element according to claim 8, wherein the connecting location is disposed on the first semiconductor substrate outside the plurality of pixels.

12. The imaging element according to claim 8, wherein the pixel circuit is disposed for each of pixel sharing units, each pixel sharing unit including two or more pixels among the plurality of pixels.

13. The imaging element according to claim 12, further comprising:
a second connecting location connected to the charge holding section; and
a charge holding section wiring line disposed between the first semiconductor substrate and the second semiconductor substrate and connected in common to the second connecting location of each of the plurality of pixels included in the pixel sharing unit,
wherein the charge holding section wiring line is connected to the pixel circuit.

14. The imaging element according to claim 12, further comprising:
a charge transfer section wiring line that is disposed between the first semiconductor substrate and the second semiconductor substrate, transmits a control signal to the charge transfer section, and is commonly connected to the charge transfer sections of another piece of the pixel sharing units; and
a second connecting location that is connected to the charge transfer section wiring line and supplies the control signal.

15. The imaging element according to claim 6, wherein the connecting location is connected to a well region in which an element of the pixel circuit is disposed, on the second semiconductor substrate.

16. The imaging element according to claim 6, wherein the buried electrode is formed in a band shape in plan view.

17. The imaging element according to claim 1,
wherein the buried electrode is connected to the charge holding section, and
the connecting location is connected to the pixel circuit.

18. The imaging element according to claim 17,
wherein a plurality of the pixels is disposed on the first semiconductor substrate, and
the pixel circuit is disposed for each of pixel sharing units, each pixel sharing unit including two or more pixels among the plurality of pixels.

19. The imaging element according to claim 18, wherein the buried electrode is commonly connected to the charge holding section of each pixel in the pixel sharing unit.

20. The imaging element according to claim 17,
wherein the buried electrode is formed in a shape protruding from the first semiconductor substrate, and
the charge transfer section includes a MOS transistor including a gate electrode having a height equal to or less than a protruding height of the buried electrode from the first semiconductor substrate.

21. The imaging element according to claim 6, wherein the connecting location is connected to the well region via a high-concentration impurity region which is a semiconductor region having a high impurity concentration formed on the first semiconductor substrate.

22. The imaging element according to claim 1, wherein the buried electrode includes silicon.

23. The imaging element according to claim 1, wherein the isolating section has a shape penetrating the first semiconductor substrate.

24. The imaging element according to claim 1, wherein the isolating section is formed with an insulator.

25. The imaging element according to claim 1, wherein the isolating section is formed with a semiconductor region having a high impurity concentration.

26. The imaging element according to claim 1, further comprising a third semiconductor substrate that is stacked on a side of the second semiconductor substrate different from the side on which the first semiconductor substrate is disposed and that includes a circuit connected to the pixel circuit.

27. The imaging element according to claim 1, wherein the charge transfer section is formed with a MOS transistor that includes: a channel region disposed in a protrusion formed on a front surface side of the first semiconductor substrate; and a gate electrode adjacent to a side surface of the protrusion via an insulating film, and that transfers the charge in a thickness direction of the first semiconductor substrate.

28. The imaging element according to claim 27, wherein the protrusion is formed by grinding the front surface side of the first semiconductor substrate into an annular groove shape.

29. The imaging element according to claim 27, wherein the gate electrode is formed in a shape surrounding a side surface of the protrusion.

30. The imaging element according to claim 27, wherein the charge holding section is disposed at an end of the protrusion.

31. The imaging element according to claim 30, wherein the gate electrode is disposed to be separated from the charge holding section in a thickness direction of the first semiconductor substrate.

32. The imaging element according to claim 27, wherein the channel region is formed to have a conductivity type different from a conductivity type of a well region of the first semiconductor substrate.

33. An imaging device comprising:
pixels each disposed on a first semiconductor substrate and including a photoelectric conversion section that performs photoelectric conversion of incident light, a charge holding section that holds a charge generated by the photoelectric conversion, and a charge transfer section that transfers the charge from the photoelectric conversion section to the charge holding section;
a pixel circuit that is disposed on a second semiconductor substrate stacked on a front surface side of the first semiconductor substrate and generates an image signal on a basis of the held charge;
an isolating section disposed at a boundary of the pixels;
a buried electrode that is disposed by being buried in the front surface side of the first semiconductor substrate at a boundary of the pixel overlapping with the isolating section and is connected to the first semiconductor substrate;
a connecting location connected to the buried electrode; and
a processing circuit that processes the generated image signal.
